# EUROPÄISCHE PATENTSCHRIFT

(11) **EP 2 340 579 B1**
(45) Veröffentlichungstag und Bekanntmachung des Hinweises auf die Patenterteilung: **12.09.2018**
(21) Anmeldenummer: 09783815.5
(22) Anmeldetag: 07.10.2009
(51) Int. Cl.: H01L 51/50, H01L 51/54

(54) **MIT KONDENSIERTEN RINGSYSTEMEN SUBSTITUIERTE SILOLE UND DEREN VERWENDUNG IN DER ORGANISCHEN ELEKTRONIK**
SILOLES SUBSTITUTED WITH CONDENSED RING SYSTEMS AND USE THEREOF IN ORGANIC ELECTRONICS
SILOLES SUBSTITUÉS PAR DES SYSTÈMES CYCLIQUES CONDENSÉS ET LEUR UTILISATION EN ÉLECTRONIQUE ORGANIQUE

(30) Priorität: 07.10.2008 EP 08166046; 07.10.2008 EP 08166034
(43) Veröffentlichungstag der Anmeldung: 06.07.2011
(73) Patentinhaber: OSRAM OLED GMBH, 93049 Regensburg (DE); UDC Ireland Limited, Ballycoolin, Dublin 15 (IE); OLEDWorks GmbH, 52068 Aachen (DE)
(72) Erfinder: HEUSER, Karsten, 91056 Erlangen (DE); HUNZE, Arvid, 91056 Erlangen (DE); SCHMID, Günter, 91334 Hemhofen (DE); KRAUSE, Ralf, 91058 Erlangen (DE); LANGER, Nicolle, 64646 Heppenheim (DE); MOLT, Oliver, 69469 Weinheim (DE); DORMANN, Korinna, 67098 Bad Dürkheim (DE); FUCHS, Evelyn, 68199 Mannheim (DE); RUDOLPH, Jens, 67547 Worms (DE); LENNARTZ, Christian, 67105 Schifferstadt (DE); WATANABE, Soichi, 68161 Mannheim (DE); SCHILDKNECHT, Christian, 68307 Mannheim (DE); WAGENBLAST, Gerhard, 67157 Wachenheim (DE); VAN ELSBERGEN, Volker, 52080 Aachen (DE); BOERNER, Herbert, Friedrich, 52076 Aachen (DE)
(74) Vertreter: Epping - Hermann - Fischer
(86) Internationale Anmeldenummer: PCT/EP2009/063036
(87) Internationale Veröffentlichungsnummer: WO 2010/040777

(56) Entgegenhaltungen:
- WO-A1-2004/020373
- JP-A- 2001 172 284
- JP-A- 2003 243 178
- JP-A- 2005 104 986

## Beschreibung

Die vorliegende Erfindung betrifft die Verwendung von mit kondensierten Ringsystemen substituierten Silolen in organisch-elektronischen Anwendungen, bevorzugt als Matrixmaterial und/oder Loch-/Excitonenblockermaterial, eine organische Leuchtdiode, enthaltend eine Anode An und eine Kathode Ka und eine zwischen der Anode An und der Kathode Ka angeordnete Licht-emittierende Schicht E sowie gegebenenfalls als weitere Schicht mindestens eine Blockschicht für Löcher/Excitonen, wobei die organische Leuchtdiode mindestens eine Silolverbindung der Formel (I) enthält, die in der Licht-emittierenden Schicht und/oder in der mindestens in der Blockschicht für Löcher/Excitonen - soweit vorhanden - vorliegt, eine Vorrichtung ausgewählt aus der Gruppe bestehend aus stationären Bildschirmen, mobilen Bildschirmen und Beleuchtungseinheiten enthaltend mindestens eine erfindungsgemäße organische Leuchtdiode, sowie spezielle mit kondensierten Ringsystemen substituierte Silole.

Die organische Elektronik ist ein Teilgebiet der Elektronik, das elektronische Schaltungen verwendet, die Polymere oder kleinere organische Verbindungen aufweisen. Anwendungsbereiche der organischen Elektronik sind der Einsatz von Polymeren oder kleineren organischen Verbindungen in organischen Leuchtdioden (OLEDs), die Anwendung in organischen Solarzellen (organische Photovoltaik), sowie in schaltenden Elementen wie organischen Transistoren, z. B. organischen FET und organischen TFT.

Durch den Einsatz geeigneter neuartiger organischer Materialien können somit verschiedene neuartige Bauelemente, die auf organischer Elektronik basieren, wie Displays, Sensoren, Transistoren, Datenspeicher oder Photovoltaikzellen bereitgestellt werden. Dadurch ist die Entwicklung neuer Anwendungen, die dünn, leicht, flexibel und zu niedrigen Kosten herstellbar sind, möglich.

Ein bevorzugter Anwendungsbereich gemäß der vorliegenden Anmeldung ist der Einsatz von kleineren organischen Verbindungen in organischen Leuchtdioden.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, z. B. für Anwendungen in Handys, Laptops, usw. sowie zur Beleuchtung.

Die Grundprinzipien der Funktionsweise von OLEDs sowie geeignete Aufbauten (Schichten) von OLEDs sind z. B. in WO 2005/113704 und deren zitierten Literatur genannt.

Als Licht-emittierende Materialien (Emitter) können neben fluoreszierenden Materialien (Fluoreszenz-Emitter) phosphoreszierende Materialien (Phosphoreszenz-Emitter) eingesetzt werden. Bei den Phosphoreszenz-Emittern handelt es sich üblicherweise um metallorganische Komplexe, die im Gegensatz zu den Fluoreszenz-Emittern, die eine Singulett-Emission zeigen, eine Triplett-Emission zeigen (M. A. Baldo et al., Appl. Phys. Lett. 1999, 75, 4 - 6). Aus quantenmechanischen Gründen ist bei Verwendung der Phosphoreszenz-Emitter eine bis zu vierfache Quanten-, Energie- und Leistungseffizienz möglich.

Von besonderem Interesse sind organische Leuchtdioden mit langer operativer Lebensdauer, guter Effizienz, hoher Stabilität gegenüber Temperaturbelastung und einer niedrigen Einsatz- und Betriebsspannung, die insbesondere Licht im blauen Bereich des elektromagnetischen Spektrums emittieren.

Um die vorstehend erwähnten Eigenschaften in die Praxis umzusetzen, ist es nicht nur erforderlich, geeignete Emittermaterialien bereitzustellen, sondern auch die anderen Komponenten der OLED (Komplementärmaterialien) müssen in geeigneten Device-Kompositionen aufeinander abgestimmt sein. Solche Device-Kompositionen können zum Beispiel spezielle Matrixmaterialien enthalten, in denen der eigentliche Lichtemitter in verteilter Form vorliegt. Des Weiteren können die Kompositionen Blockermaterialien enthalten, wobei Loch-, Excitonen- und/oder Elektronenblocker in den Device-Kompositionen vorliegen können. Daneben oder alternativ können die Device-Kompositionen des Weiteren Loch-Injektionsmaterialien und/oder Elektronen-Injektionsmaterialien und/oder Ladungstransportmaterialien wie Lochleitermaterialien und/oder Elektronenleitermaterialien aufweisen. Dabei hat die Auswahl der vorstehend genannten Materialien, die in Kombination mit dem eigentlichen Lichtemitter eingesetzt werden, einen wesentlichen Einfluss unter anderem auf die Effizienz sowie die Lebensdauer der OLEDs.

Im Stand der Technik werden zahlreiche verschiedene Materialien für den Einsatz in den verschiedenen Schichten von OLEDs sowie für den Einsatz in weiteren Anwendungen in der organischen Elektronik vorgeschlagen.

In JP 2001-172285 A sind organische Leuchtdioden offenbart, worin Silole als Elektronentransportmaterial eingesetzt werden. Die Silole weisen die folgende allgemeine Formel auf 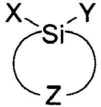 , wobei unter anderem Silole offenbart sind, worin der aus Si und Z gebildete Ring die folgende Formel aufweist.

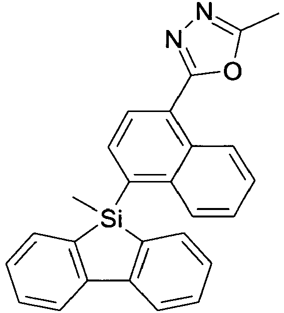

Der Einsatz von Silolen als Lochblockermaterial oder als Matrixmaterial ist in JP 2001-172285 A nicht erwähnt.

In JP 2001-172284 wird der Einsatz von Silolen als Lochtransportverbindungen in organischen Leuchtdioden offenbart. Diese Silole weisen die folgende allgemeine Formel auf

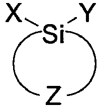

Unter anderem sind in JP 2001-172284 A Silole, die die folgende Struktur aufweisen, offenbart

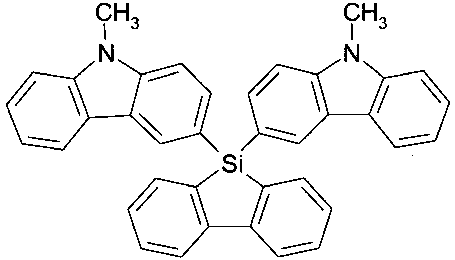

Der Einsatz der in JP 2001-172284 genannten Silole als Lochblockermaterialien oder Matrixmaterialien ist in JP 2001-172284 A nicht offenbart. Gemäß den Beispielen in JP 2001-172284 A werden die Silole als Ersatz für TPD und PVK, die üblicherweise als Lochtransportmaterialien in OLEDs eingesetzt werden, eingesetzt.

In X. Zhan et al., J. Am. Chem. Soc. 2005, 127, 9021 - 9029, ist die experimentelle und theoretische Charakterisierung der elektronischen Struktur von 1,1-Diaryl-2,3,4,5-tetraphenylsilolen offenbart. Gemäß X. Zhan et al. stellen diese Verbindungen Elektronentransportmaterialien für den Einsatz in der organischen Elektronik dar. Eine Eignung der in X. Zhan et al. offenbarten Silole als Lochblockermaterialien oder Matrixmaterialien ist nicht erwähnt.

In JP 2003-243178 A sind organische Leuchtdioden offenbart, die gute Lumineszenzen und lange Lumineszenzlebensdauern aufweisen und als Matrix in der Licht-emittierenden Schicht oder in der Elektronentransportschicht Silole der folgenden allgemeinen Formel aufweisen

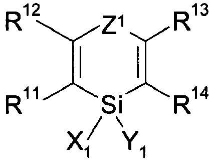

Bevorzugte Silole weisen zum Beispiel die folgenden allgemeinen Formeln auf.

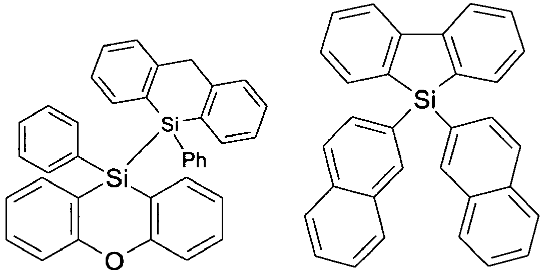

Gemäß den Beispielen in JP 2003-243178 A werden Silole der folgenden Formel eingesetzt:

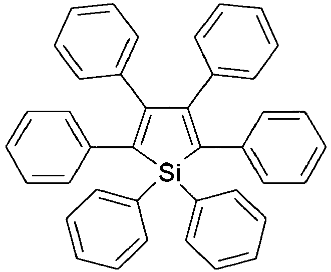

Unter den zahlreichen verschiedenen Silolen, die gemäß JP 2003-243178 A als Matrixmaterialien offenbart sind, sind keine Silole offenbart, die am Si mit einem kondensierten Tricyclus, der mindestens ein Heteroatom ausgewählt aus O, S, N und P enthält, substituiert sind.

EP 1 740 019 A1 betrifft organische Leuchtdioden, die eine Licht-emittierende Schicht enthalten, die mindestens ein Silicacyclopentadien-Derivat als Matrix und mindestens ein Amin als Dotiermaterial aufweist. Das Silicacyclopentadien-Derivat weist die folgende Formel auf

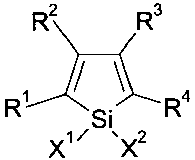

Unter anderem können X¹ und X² ein Heteroring mit 3 bis 50 Kohlenstoffatomen sein, wobei jedoch in EP 1 740 019 A1 keine Heteroringe mit 3 kondensierten Ringen für X¹ bzw. X² erwähnt sind. In allen Beispielverbindungen in EP 1 740 019 A1 bedeuten X¹ und X² Phenyl oder Alkyl, insbesondere Methyl.

In EP 0 754 691 A2 bzw. EP 1 143 538 A1 sind Silacyclopentadienderivate und deren Einsatz in organischen Leuchtdioden offenbart. Die Silacyclopentadienderivate gemäß EP 0 754 691 A2 weisen die folgende allgemeine Formel auf

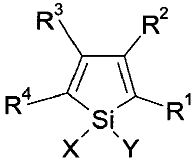

X und Y können unter anderem Heterocyclen sein, wobei keine kondensierten tricyclischen Heterocyclen erwähnt sind.

In den Beispielen in EP 0 754 691 A2 werden im Wesentlichen 3,4-Diphenylsilacyclopentadiene bzw. 9,9'-Silaspirobifluorene eingesetzt. Gemäß EP 0 754 691 A2 können die genannten Silacyclopentadiene in der Elektronentransportschicht der Licht-emittierenden Schicht oder einer Blockschicht für Löcher eingesetzt werden.

In WO 2004/020373 werden Spiroverbidungen für organische lumineszente Bauelemente offenbart.

Die JP 2003/243178 offenbart ein organisches elektrolumineszierendes Element mit hoher Helligkeit und langer Haltbarkeit.

Aus dem Stand der Technik ergibt sich somit, dass Silolverbindungen in unterschiedlichen Schichten organischer Leuchtdioden eingesetzt werden können. Dabei wird der Einsatz von Silolverbindungen in verschiedenen Schichten in OLEDs erwähnt.

Aufgabe der vorliegenden Erfindung gegenüber dem vorstehend genannten Stand der Technik ist die Bereitstellung von weiteren für den Einsatz in OLEDs und weiteren Anwendungen in der organischen Elektronik geeigneten Materialien. Insbesondere sollen Lochblockermaterialien sowie Matrixmaterialien für den Einsatz in OLEDs bereitgestellt werden. Die Materialien sollen insbesondere für OLEDs geeignet sein, die mindestens einen Phosphoreszenzemitter, insbesondere mindestens einen Grün- oder mindestens einen Blauemitter, enthalten. Somit sollen insbesondere Matrix- und/oder Lochblockermaterialien für OLEDs bereitgestellt werden, die eine hohe Triplett-Energie aufweisen. Des Weiteren sollen die Materialien zur Bereitstellung von OLEDs geeignet sein, die gute Effizienzen, gute operative Lebensdauern sowie eine hohe Stabilität gegenüber Temperaturbelastung und eine niedrige Einsatz- und Betriebsspannung der OLEDs gewährleisten.

Es werden Verbindungen der Formel Verbindungen der Formel (Ib) angegeben 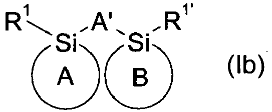 worin bedeuten:
- A': ein kondensiertes Ringsystem aufgebaut aus mindestens 3, bevorzugt 3 oder 4, besonders bevorzugt 3, kondensierten Ringen, die unabhängig voneinander 4 bis 10, bevorzugt 5 bis 7, besonders bevorzugt 5 oder 6 Ringglieder aufweisen und gesättigt oder ein- oder mehrfach ungesättigt sowie unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, bevorzugt Alkyl, Heteroaryl und Gruppen mit Donor- oder Akzeptorwirkung substituiert sein können, wobei das kondensierte Ringsystem mindestens eine Heteroatom haltige Gruppe, bevorzugt ausgewählt aus O, S, N, P, SO, SO₂ und Si, besonders bevorzugt O, S und N, ganz besonders bevorzugt O und S, in dem kondensierten Ringsystem selbst oder in mindestens einem Substituenten, bevorzugt in dem kondensierten Ringsystem selbst, aufweist; 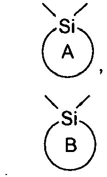
unabhängig voneinander jeweils ein Si enthaltender Ring, der 4 bis 10, bevorzugt 5 bis 7, besonders bevorzugt 5 oder 6, ganz besonders bevorzugt 5 Ringglieder aufweist, wobei der Ring gesättigt oder einoder mehrfach ungesättigt sein kann und neben dem Si-Atom ein oder mehrere weitere Heteroatom haltige Gruppen, bevorzugt ausgewählt aus O, S, SO, SO₂ und N, besonders bevorzugt O und N aufweisen kann, und unsubstituiert oder mit einem oder mehreren Substituenten ausgewählt aus Alkyl, Cycloalkyl, Heterocycloalkyl, Aryl, Hetereoaryl und Gruppen mit Donor- oder Akzeptorwirkung substituiert sein kann, wobei der Si-enthaltende Ring des Weiteren Teil eines kondensierten Ringsystems aufgebaut aus mindestens 2, bevorzugt 2 oder 3, besonders bevorzugt 3 kondensierten Ringen sein kann, wobei die weiteren Ringe - neben dem Si enthaltenden Ring - in dem kondensierten Ringsystem unabhängig voneinander gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung substituiert sein können und eine oder mehrere Heteroatom haltige Gruppen, bevorzugt ausgewählt aus O, S, SO, SO₂ und N, besonders bevorzugt S und N, aufweisen können;
- R¹, R^{1'}: unabhängig voneinander -ein kondensiertes Ringsystem aufgebaut aus mindestens 3 kondensierten Ringen, die unabhängig voneinander 4 bis 10 Ringglieder aufweisen und gesättigt oder ein- oder mehrfach ungesättigt sowie substituiert oder mit einem oder mehreren Substituenten ausgewählt aus Alkyl, Cycloalkyl, Heterocycloalkyl, Aryl, Heteroaryl, SiR²R³R⁴ und Gruppen mit Donor- oder Akzeptorwirkung substituiert sein können, wobei das kondensierte Ringsystem mindestens ein Heteroatom in dem kondensierten Ringsystem selbst oder in mindestens einem Substituenten aufweist, - Alkyl, Cycloalkyl, Heterocycloalkyl, Aryl oder Heteroaryl, bevorzugt Alkyl, Aryl oder Heteroaryl, besonders bevorzugt Alkyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl oder Dibenzofuryl, Dibenzothienyl, Carbazolyl oder Azacarbazolyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl, und Gruppen mit Donor- oder Akzeptorwirkung substituiert sein können.

Auch offenbart wird die Verwendung von Verbindungen der allgemeinen Formel (I) 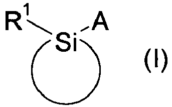 worin bedeuten:
- A: ein kondensiertes Ringsystem aufgebaut aus mindestens 3, bevorzugt 3 oder 4, besonders bevorzugt 3 kondensierten Ringen, die unabhängig voneinander 4 bis 10, bevorzugt 5 bis 7, besonders bevorzugt 5 oder 6 Ringglieder aufweisen und gesättigt oder ein- oder mehrfach ungesättigt sowie unsubstituiert oder mit einem oder mehreren Substituenten ausgewählt aus Alkyl, Cycloalkyl, Heterocycloalkyl, Aryl, Heteroaryl, SiR²R³R⁴ und Gruppen mit Donor- oder Akzeptorwirkung , bevorzugt Alkyl, Heteroaryl, SiR²R³R⁴ und Gruppen mit Donor- oder Akzeptorwirkung wie Alkoxy, Amino, Halogen oder Pseudohalogen, substituiert sein können, wobei das kondensierte Ringsystem mindestens ein Heteroatom, bevorzugt ausgewählt aus O, S, N und P, besonders bevorzugt O, S und N, ganz besonders bevorzugt S und O, in dem kondensierten Ringsystem selbst oder in mindestens einem Substituenten, bevorzugt in dem kondensierten Ringsystem selbst, aufweist; 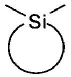 ein Si-enthaltender Ring, der 4 bis 10, bevorzugt 5 bis 7, besonders bevorzugt 5 oder 6, ganz besonders bevorzugt 5 Ringglieder aufweist, wobei der Ring gesättigt oder ein- oder mehrfach ungesättigt sein kann und neben dem Si-Atom ein oder mehrere weitere Heteroatome bevorzugt ausgewählt aus O, S und N, besonders bevorzugt O und N aufweisen kann, und unsubstituiert oder mit einem oder mehreren Substituenten ausgewählt aus Alkyl, Cycloalkyl, Heterocycloalkyl, Aryl, Heteroaryl und Substituenten mit Donor- oder Akzeptorwirkung substituiert sein kann, wobei der Si-enthaltende Ring des Weiteren Teil eines kondensierten Ringsystems aufgebaut aus mindestens zwei, bevorzugt zwei oder drei, besonders bevorzugt drei Ringen sein kann, wobei die weiteren Ringe in dem kondensierten Ringsystem unabhängig voneinander gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl, und Substituenten mit Donor- oder Akzeptorwirkung substituiert sein können und ein oder mehrere Heteroatome, bevorzugt ausgewählt aus O, S und N, besonders bevorzugt S und N aufweisen können;
- R¹: A, Alkyl, Cycloalkyl, Heterocycloalkyl, Aryl oder Heteroaryl, bevorzugt Alkyl, Aryl oder Heteroaryl, besonders bevorzugt Methyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl, Dibenzofuryl, Dibenzothienyl, Carbazolyl oder Azacarbazolyl;
- R², R³, R⁴: unabhängig voneinander Alkyl, Cycloalkyl, Heterocycloalkyl, Aryl, Heteroaryl bedeuten, wobei die Reste R², R³ und R⁴ oder zwei der Reste R², R³ und R⁴ des Weiteren gemeinsam ein kondensiertes Ringsystem aus 2 bis 6 Ringen, bevorzugt 2 bis 3 Ringen, die jeweils gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bilden können;
in organisch elektronischen Anwendungen, bevorzugt ausgewählt aus schaltenden Elementen wie organischen Transistoren, z. B. organischen FET und organischen TFT, organischen Solarzellen und organischen Leuchtdioden, wobei die Verbindungen der Formel (I) in organischen Leuchtdioden bevorzugt als Matrixmaterial und/oder Loch-/Excitonenblockermaterial eingesetzt werden.

Es wurde gefunden, dass die vorstehend genannten Verbindungen der Formel (I), worin die Siloleinheit mit einem kondensierten Ringsystem aufgebaut ist aus mindestens drei kondensierten Ringen, wobei das kondensierte Ringsystem mindestens eine Heteroatom haltige Gruppe ausgewählt aus O, S, N, SO, SO₂ und P aufweist, besonders gut für den Einsatz in Anwendungen geeignet sind, bei denen eine Ladungsträgerleitfähigkeit erforderlich ist, insbesondere für den Einsatz in organisch elektronischen Anwendungen ausgewählt aus schaltenden Elementen wie organischen Transistoren, z. B. organischen FET und organischen TFT, organischen Solarzellen und organischen Leuchtdioden (OLED), wobei die Verbindungen der Formel (I) in OLEDs für den Einsatz als Matrixmaterial und/oder als Loch- und/oder Excitonenblockermaterial besonders geeignet sind, insbesondere in Kombination mit einem Phosphoreszenzemitter. Bei Verwendung der Verbindungen der Formel (I) werden organische Leuchtdioden (OLEDs) erhalten, die gute Effizienzen und eine lange Lebensdauer aufweisen. Die hervorragende Eignung der Verbindungen der allgemeinen Formel (I) als Matrixmaterial und/oder als Loch- und/oder Excitonenblockermaterial in OLEDs ist insbesondere im Hinblick auf JP 2001-172284 A überraschend, worin der Einsatz von mit den Verbindungen der Formel (I) eng verwandten Silolderivaten als Lochtransportmaterialien offenbart ist.

Die in den vorstehend genannten organisch elektronischen Anwendungen eingesetzten mit einem kondensierten Ringsystem substituierten Silole der Formel (I) zeichnen sich durch eine hervorragende Eignung für den Einsatz in organisch elektronischen Anwendungen, insbesondere als Matrix und/oder Loch-/Excitonenblocker in OLEDs aus. Insbesondere weisen die verwendeten Silolverbindungen der Formel (I) eine hohe Amorphizität in dünnen Schichten auf und sind leicht zugänglich. Dadurch wird eine optimale Performance der organisch elektronischen Anwendungen, insbesondere von OLEDs, erreicht. Die bereitgestellten Silolverbindungen der Formel (I) sind insbesondere zur Bereitstellung von OLEDs mit guten Effizienzen und einer langen Lebensdauer geeignet. Des Weiteren weisen die eeingesetzten Silolverbindungen der Formel (I) bevorzugt einen Energieunterschied zwischen dem elektronisch angeregten TriplettZustand T₁ und dem Grundzustand So auf, der ausreichend groß ist, damit sie für den Einsatz als Matrix oder Loch-/Exctionenblockermaterialien, z. B. für Blauemitter und Grünemitter in Frage kommen. Weiterhin können die Silolverbindungen der Formel (I) als Leiter/Komplementärmaterialien in organisch elektronischen Anwendungen ausgewählt aus schaltenden Elementen und organischen Solarzellen eingesetzt werden.

Im Sinne der vorliegenden Anmeldung haben die Begriffe unsubstituierter oder substituierter Arylrest oder -gruppe, unsubstituierter oder substituierter Heteroarylrest oder - gruppe, unsubstituierter oder substituierter Alkylrest oder -gruppe, unsubstituierter oder substituierter Cycloalkylrest oder -gruppe, unsubstituierter oder substituierter Heterocycloalkylrest oder -gruppe, unsubstituierter oder substituierter Alkenylrest oder - gruppe, unsubstituierter oder substituierter Alkinylrest oder -gruppe, unsubstituierter oder substituierter Aralkylrest oder -gruppe, und Gruppen mit Donor- und/oder Akzeptorwirkung die folgenden Bedeutungen:

Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl, Indenyl oder Fluorenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Deuterium, Alkoxyreste, Aryloxyreste, Alkylaminogruppen, Arylaminogruppen, Carbazoylgruppen, Silylgruppen, SiR²R³R⁴, wobei geeignete Silylgruppen SiR²R³R⁴ nachstehend genannt sind, Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste und Carbazolylreste, Alkenylreste, bevorzugt Alkenylreste, die eine Doppelbindung tragen, besonders bevorzugt Alkenylreste mit einer Doppelbindung und 1 bis 8 Kohlenstoffatomen, Alkinylreste, bevorzugt Alkinylreste mit einer Dreifachbindung, besonders bevorzugt Alkinylreste mit einer Dreifachbindung und 1 bis 8 Kohlenstoffatomen oder Gruppen mit Donor- oder Akzeptorwirkung. Geeignete Gruppen, mit Donor- oder Akzeptorwirkung sind nachstehend genannt. Ganz besonders bevorzugt tragen die substituierten Arylreste Substituenten ausgewählt aus der Gruppe bestehend aus Methyl, Ethyl, Isopropyl, Alkoxy, Heteroaryl, Halogen, Pseudohalogen und Amino, bevorzugt Arylamino. Bevorzugt ist der Arylrest oder die Arylgruppe ein C₆-C₁₈-Arylrest, besonders bevorzugt ein C₆-Arylrest, der gegebenenfalls mit mindestens einem oder mehreren der vorstehend genannten Substituenten substituiert ist. Besonders bevorzugt weist der C₆-C₁₈-Arylrest, bevorzugt C₆-Arylrest, keinen, einen, zwei, drei oder vier, ganz besonders bevorzugt keinen, einen oder zwei der vorstehend genannten Substituenten auf.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist, sowie dadurch, dass das Grundgerüst der Heteroarylreste bevorzugt 5 bis 18 Ringatome aufweist. Bevorzugte Heteroatome sind N, O und S. Besonders bevorzugt geeignete Heteroarylreste sind stickstoffhaltige Heteroarylreste. Ganz besonders bevorzugt sind ein oder zwei Kohlenstoffatome des Grundgerüsts durch Heteroatome, bevorzugt Stickstoff, ersetzt. Insbesondere bevorzugt ist das Grundgerüst ausgewählt aus Systemen wie Pyridin, Pyrimidin und fünfgliedrigen Heteroaromaten wie Pyrrol, Furan, Pyrazol, Imidazol, Thiophen, Oxazol, Thiazol, Triazol. Des Weiteren kann es sich bei den Heteroarylresten um kondensierte Ringsysteme handeln, z. B. um Benzofuryl,- Benzothienyl-, Benzopyrrolyl-, Dibenzofuryl-, Dibenzothienyl-, Phenanthrolinyl-, Carbazolylreste oder Azacarbazoylreste. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8, ganz besonders bevorzugt 1 bis 4 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere (Hetero-)-Arylgruppen trägt. Im Sinne der vorliegenden Anmeldung stellen z. B. Benzylreste somit substituierte Alkylreste dar. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl und Ethyl.

Unter einem Cycloalkylrest oder einer Cycloalkylgruppe ist ein Rest mit 3 bis 20 Kohlenstoffatomen, bevorzugt 3 bis 10 Kohlenstoffatomen, besonders bevorzugt 3 bis 8 Kohlenstoffatomen zu verstehen. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind die bereits vorstehend bezüglich der Arylreste genannten Gruppen. Es ist ebenfalls möglich, dass der Cycloalkylrest eine oder mehrere (Hetero-)Arylgruppen trägt. Beispiele für geeignete Cycloalkylreste sind Cyclopropyl, Cyclopentyl und Cyclohexyl.

Unter einem Heterocycloalkylrest oder einer Heterocycloalkylgruppe sind Reste zu verstehen, die sich von den vorstehend genannten Cycloalkylresten dadurch unterscheiden, dass in dem Grundgerüst der Cycloalkylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Cycloalkylreste durch Heteroatome ersetzt. Beispiele für geeignete Heterocycloalkylreste sind Reste abgeleitet von Pyrrolidin, Piperidin, Piperazin, Tetrahydrofuran, Dioxan.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einer Gruppe SiR²R³R⁴ ist ein Silylrest zu verstehen, worin
- R², R³ und R⁴: unabhängig voneinander Alkyl, Cycloalkyl, Heterocycloalkyl, Aryl, Heteroaryl bedeuten, wobei die Reste R², R³ und R⁴ oder zwei der Reste R², R³ und R⁴ des Weiteren gemeinsam ein kondensiertes Ringsystem aus 2 bis 6 Ringen, bevorzugt 2 bis 3 Ringen, die jeweils gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bilden können; bevorzugt bilden - in dem Fall, wenn ein kondensiertes Ringsystem vorliegt - zwei der drei Reste R², R³ und R⁴ das kondensierte Ringsystem, während der dritte Rest eine der vorstehend genannten Bedeutungen aufweist.

Ein besonders bevorzugter Rest SiR²R³R⁴ weist die folgende Formel auf 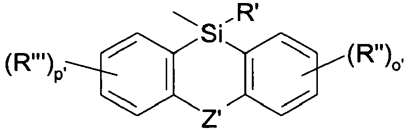 worin bedeuten:
- R': unabhängig voneinander Alkyl, Cycloalkyl, Heterocycloalkyl, Aryl, Heteroaryl, bevorzugt Alkyl oder Aryl;
- R", R"': unabhängig voneinander Alkyl, Cycloalkyl, Heterocycloalkyl, Aryl, Heteroaryl oder eine Gruppe mit Donor- oder Akzeptorwirkung, bevorzugt Alkyl, Heteroaryl oder eine Gruppe mit Donor- oder Akzeptorwirkung;
- Z': eine Bindung oder NR"", CR""'₂, O, SO, SO₂, Si oder S, bevorzugt eine Bindung;
- R"": unabhängig voneinander Alkyl, Cycloalkyl, Heterocycloalkyl, Aryl oder Heteroaryl, bevorzugt Alkyl oder Aryl;
- R""': unabhängig voneinander Wasserstoff, Alkyl, Cycloalkyl, Heterocycloalkyl, Aryl oder Heteroaryl, bevorzugt Alkyl oder Aryl;
- o, p: unabhängig voneinander 0, 1, 2, 3 oder 4, bevorzugt 0, 1 oder 2, besonders bevorzugt 0.

Unter einer Gruppe oder einem Substituenten mit Donor- oder Akzeptorwirkung sind im Sinne der vorliegenden Anmeldung die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Bevorzugte geeignete Gruppen sind ausgewählt aus C₁-C₂₀-Alkoxy, C₆-C₃₀-Aryloxy, C₁-C₂₀-Alkylthio, C₆-C₃₀-Arylthio, SiR²⁰R²¹R²², Halogenresten, halogenierten C₁-C₂₀-Alkylresten, Carbonyl (-CO(R²⁰)), Carbonylthio (- C = O (SR²⁰)), Carbonyloxy (- C = O(OR²⁰)), Oxycarbonyl (- OC = O(R²⁰)), Thiocarbonyl (- SC = O(R²⁰)), Amino (-NR²⁰R²¹), Pseudohalogenresten, Amido (- C = O (NR²⁰)), -NR²⁰C = O (R²¹), Phosphonat (- P(O) (OR²⁰)₂, Phosphat (-OP(O) (OR²⁰)₂), Phosphin (-PR²⁰R²¹), Phosphinoxid (-P(O)R²⁰₂), Sulfat (-OS(O)₂OR²⁰), Sulfoxid (-S(O)R²⁰), Sulfonat (-S(O)₂OR²⁰), , Sulfonyl (-S(O)₂R²⁰, Sulfonamid (-S(O)₂NR²⁰R²¹), NO₂, Boronsäureestern (-OB(OR²⁰)₂), Imino (-C = NR²⁰R²¹)), Boranresten, Stannanresten, Hydrazinresten, Hydrazonresten, Oximresten, Nitroso-Gruppen, Diazo-Gruppen, Vinylgruppen, Sulfoximinen, Alanen, Germanen, Boroximen und Borazinen.

Die in den vorstehend genannten Gruppen mit Donor- oder Akzeptorwirkung erwähnten Reste R²⁰, R²¹ und R²² bedeuten unabhängig voneinander:
Substituiertes oder unsubstituiertes C₁-C₂₀-Alkyl oder substituiertes oder unsubstituiertes C₆-C₃₀-Aryl, wobei geeignete und bevorzugte Alkyl- und Arylreste vorstehend genannt sind. Besonders bevorzugt bedeuten die Reste R²⁰, R²¹ und R²² C₁-C₆-Alkyl, z. B. Methyl, Ethyl oder i-Propyl oder Phenyl. In einer bevorzugten Ausführungsform - im Falle von SiR²⁰R²¹R²² - bedeuten R²⁰, R²¹ und R²² bevorzugt unabhängig voneinander substituiertes oder unsubstituiertes C₁-C₂₀-Alkyl oder substituiertes oder unsubstituiertes Aryl, bevorzugt Phenyl.

Bevorzugte Substituenten mit Donor- oder Akzeptorwirkung sind ausgewählt aus der Gruppe bestehend aus:
C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR²⁰R²¹R²², wobei R²⁰, R²¹ und R²² bevorzugt unabhängig voneinander substituiertes oder unsubstituiertes Alkyl oder substituiertes oder unsubstituiertes Aryl. bevorzugt Phenyl, bedeuten; besonders bevorzugt ist mindenstens einer der Reste R²⁰, R²¹ oder R²² substituiertes oder unsubstituiertes Phenyl, ganz besonders bevorzugt ist mindenstens einer der Reste R²⁰, R²¹ und R²² substituiertes Phenyl, wobei geeignete Substituenten vorstehend genannt sind; Halogenresten, bevorzugt F, Cl, besonders bevorzugt F, halogenierten C₁-C₂₀-Alkylresten, bevorzugt halogenierten C₁-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diarylamino, besonders bevorzugt Diarylamino; Pseudohalogenresten, bevorzugt CN, -C(O)OC₁-C₄-Alkyl, bevorzugt -C(O)OMe, P(O)R₂, bevorzugt P(O)Ph₂.

Ganz besonders bevorzugte Substituenten mit Donor- oder Akzeptorwirkung sind ausgewählt aus der Gruppe bestehend aus Methoxy, Phenyloxy, halogeniertem C₁-C₄-Alkyl, bevorzugt CF₃, CH₂F, CHF₂, C₂F₅, Halogen, bevorzugt F, CN, SiR²⁰R²¹R²², wobei geeignete Reste R²⁰, R²¹ und R²² bereits genannt sind, Diarylamino (NR²⁰R²¹, wobei R²⁰, R²¹ jeweils C₆-C₃₀-Aryl bedeuten), -C(O)OC₁-C₄-Alkyl, bevorzugt -C(O)OMe, P(O)Ph₂.

Unter Halogengruppen sind bevorzugt F, Cl und Br, besonders bevorzugt F und Cl, ganz besonders bevorzugt F, zu verstehen.

Unter Pseudohalogengruppen sind bevorzugt CN, SCN und OCN, besonders bevorzugt CN, zu verstehen.

Die vorstehend genannten Gruppen mit Donor- oder Akzeptorwirkung schließen nicht aus, dass weitere der in der vorliegenden Anmeldung genannte Reste und Substituenten, die nicht in der vorstehenden Liste der Gruppen mit Donor- oder Akzeptorwirkung aufgeführt sind, eine Donor- oder Akzeptorwirkung aufweisen.

Die Arylreste oder -gruppen, Heteroarylreste oder -gruppen, Alkylreste oder -gruppen, Cycloalkylreste oder -gruppen, Heterocycloalkylreste oder -gruppen, Alkenylreste oder -gruppen und Gruppen mit Donor- und/oder Akzeptorwirkung können - wie vorstehend erwähnt - substituiert oder unsubstituiert sein. Unter einer unsubstituierten Gruppe ist im Sinne der vorliegenden Anmeldung eine Gruppe zu verstehen, worin die substituierbaren Atome der Gruppe Wasserstoffatome tragen. Unter einer substituierten Gruppe ist im Sinne der vorliegenden Anmeldung eine Gruppe zu verstehen, worin ein oder mehrere substituierbare Atom(e) mindestens an einer Position anstelle eines Wasserstoffatoms einen Substituenten tragen. Geeignete Substituenten sind die vorstehend bezüglich der Arylreste oder -gruppen genannten Substituenten.

Kommen Reste mit denselben Nummerierungen mehrfach in den Verbindungen gemäß der vorliegenden Anmeldung vor, so können diese Reste jeweils unabhängig voneinander die genannten Bedeutungen aufweisen.

Die Gruppe A in den Silolverbindungen der allgemeinen Formel (I) ist ein kondensiertes Ringsystem aufgebaut aus mindestens 3, bevorzugt 3 oder 4, besonders bevorzugt 3 kondensierten Ringen, die unabhängig voneinander 4 bis 10, bevorzugt 5 bis 7, besonders bevorzugt 5 oder 6 Ringglieder aufweisen und gesättigt oder ein- oder mehrfach ungesättigt sowie unsubstituiert oder mit einem oder mehreren Substituenten ausgewählt aus Alkyl, Cycloalkyl, Heterocycloalkyl, Aryl, Heteroaryl, SiR²R³R⁴, und Gruppen mit Donor- oder Akzeptorwirkung, bevorzugt Alkyl, Heteroaryl, Halogen, Pseudohalogen, Alkoxy, Amino und SiR²R³R⁴, substituiert sein können, wobei das kondensierte Ringsystem mindestens eine Heteroatom haltige Gruppe, bevorzugt ausgewählt aus O, S, N, P, SO, SO₂ und Si, besonders bevorzugt O, S und N, ganz besonders bevorzugt O und S in dem kondensierten Ringsystem selbst oder in mindestens einem Substituenten, bevorzugt in dem kondensierten Ringsystem selbst, aufweist.

Bevorzugt ist das kondensierte Ringsystem aus drei kondensierten Ringen aufgebaut, die unabhängig voneinander fünf oder sechs Ringglieder aufweisen, wobei mindestens einer der drei kondensierten Ringe mindestens zweifach ungesättigt ist, wobei das kondensierte Ringsystem mindestens eine Heteroatom haltige Gruppe ausgewählt aus der Gruppe bestehend aus S, O, N, SO, SO₂ und P, bevorzugt S, O und N, besonders bevorzugt S und O, aufweist. Das kondensierte Ringsystem kann die vorstehend erwähnten Substituenten ausgewählt aus Alkyl, Cycloalkyl, Heterocycloalkyl, Aryl, Heteroaryl, SiR²R³R⁴ und Gruppen mit Donor- oder Akzeptorwirkung, bevorzugt Alkyl, Heteroaryl, Halogen, Pseudohalogen, Alkoxy, Amino und SiR²R³R⁴, aufweisen.

Besonders bevorzugt weist das kondensierte Ringsystem A die folgende allgemeine Formel Aa auf 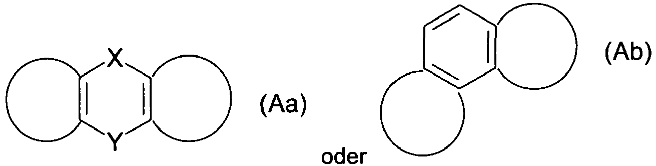 worin bedeuten:
- X: S, O, NR⁵, SO, SO₂ oder PR⁶, bevorzugt S, O oder NR⁵, besonders bevorzugt S oder O;
- Y: eine Bindung oder NR⁵, CR⁷R⁸, O, SO, SO₂ oder S, bevorzugt NR⁵, S oder eine Bindung, besonders bevorzugt eine Bindung;
- R⁵, R⁶: unabhängig voneinander Alkyl, Cycloalkyl, Heterocycloalkyl, Aryl oder Heteroaryl, bevorzugt Aryl oder Alkyl, besonders bevorzugt Phenyl;
- R⁷, R⁸: unabhängig voneinander Wasserstoff, Alkyl, Cycloalkyl, Heterocycloalkyl, Aryl oder Heteroaryl, bevorzugt Aryl oder Alkyl; und 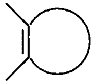 jeweils unabhängig voneinander ein kondensierter Ring mit 5 bis 6 Ringgliedern, der neben der bereits vorhandenen Doppelbindung eine oder mehrere Doppelbindungen aufweisen kann und unsubstituiert oder mit einem oder mehreren Substituenten, bevorzugt einem oder zwei Substituenen, ausgewählt aus Alkyl, Cycloalkyl, Heterocycloalkyl, Aryl, Heteroaryl, SiR²R³R⁴ und Gruppen mit Donor- oder Akzeptorwirkung, bevorzugt Alkyl, Heteroaryl, Halogen, Pseudohalogen, Alkoxy, Amino und SiR²R³R⁴, substituiert sein kann, wobei der kondensierte Ring mit 5 oder 6 Ringatomen des Weiteren mit einem oder mehreren weiteren kondensierten Ringen mit 5 oder 6 Ringatomen anelliert sein kann;
- R², R³, R⁴: unabhängig voneinander Alkyl, Cycloalkyl, Heterocycloalkyl, Aryl, Heteroaryl bedeuten, wobei die Reste R², R³ und R⁴ oder zwei der Reste R², R³ und R⁴ des Weiteren gemeinsam ein kondensiertes Ringsystem aus 2 bis 6 Ringen, bevorzugt 2 bis 3 Ringen, die jeweils gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bilden können.

Ganz besonders bevorzugt weist die Gruppe A in Formel (I) die folgende Formel Aaa auf: 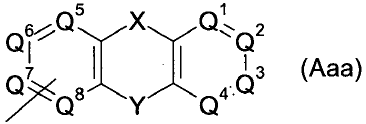 worin bedeuten:
- X: S, O, NR⁵, SO, SO₂ oder PR⁶, bevorzugt S, O oder NR⁵, besonders bevorzugt S oder O;
- Y: eine Bindung oder NR⁵, CR⁷R⁸, O, SO, SO₂ oder S, bevorzugt eine Bindung oder NR⁵, besonders bevorzugt eine Bindung;
- Q¹ bis Q⁸: unabhängig voneinander CR⁹, N, bevorzugt unabhängig voneinander CR⁹, wobei über eine der Gruppen Q¹, Q², Q³, Q⁴, Q⁵, Q⁶, Q⁷ oder Q⁸ eine Verknüpfung zu dem Si-Atom der Gruppe 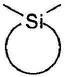 erfolgt und diese Gruppe Q¹, Q², Q³, Q⁴, Q⁵, Q⁶, Q⁷ oder Q⁸ C bedeutet;
- R⁵, R⁶: unabhängig voneinander Alkyl, Cycloalkyl, Heterocycloalkyl, Aryl oder Heteroaryl, bevorzugt Aryl oder Alkyl, besonders bevorzugt Phenyl;
- R⁷, R⁸: unabhängig voneinander Wasserstoff, Alkyl, Cycloalkyl, Heterocycloalkyl, Aryl oder Heteroaryl, bevorzugt Aryl oder Alkyl;
- R⁹: Wasserstoff, Alkyl, Cycloalkyl, Heterocycloalkyl, Aryl, Heteroaryl, SiR²R³R⁴, Gruppen mit Donor- oder Akzeptorwirkung, bevorzugt Wasserstoff, Alkyl, Heteroaryl, Halogen, Pseudohalogen, Alkoxy, Amino oder SiR²R³R⁴;
- R², R³, R⁴: unabhängig voneinander Alkyl, Cycloalkyl, Heterocycloalkyl, Aryl, Heteroaryl bedeuten, wobei die Reste R², R³ und R⁴ oder zwei der Reste R², R³ und R⁴ des Weiteren gemeinsam ein kondensiertes Ringsystem aus 2 bis 6 Ringen, bevorzugt 2 bis 3 Ringen, die jeweils gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bilden können.

In einer bevorzugten Ausführungsform bedeutet R⁹ in der Gruppe der Formel Aaa in den Gruppen Q¹, Q², Q⁴, Q⁵, Q⁶ und Q⁸ Wasserstoff und R⁹ in der Gruppe Q³ bedeutet Wasserstoff oder SiR²R³R⁴ und Q⁷ bedeutet C und ist mit dem Si-Atom der Gruppe 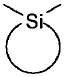 verknüpft.

Bevorzugte Ausführungsformen für die Gruppen Alkyl, Cycloalkyl, Heterocycloalkyl, Aryl, Heteroaryl, SiR²R³R⁴, und Gruppen mit Donor- oder Akzeptorwirkung, die in bevorzugten Ausführungsformen in der Gruppen der Formeln (Aa) und (Aaa) vorliegen, sind vorstehend genannt.

Ganz besonders bevorzugt weist die Gruppe der Formel Aaa die folgenden Bedeutungen auf: 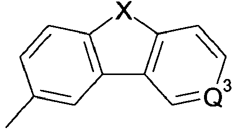 worin bedeuten:
- X: O, S oder NR⁵, bevorzugt O oder S;
- R⁵: Aryl oder Heteroaryl, bevorzugt Phenyl;
- Q³: C-H oder 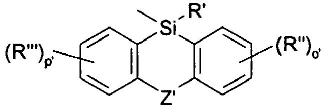
worin bedeuten:
- R': unabhängig voneinander Alkyl oder Aryl;
- R", R'": unabhängig voneinander Alkyl oder Heteroaryl oder eine Gruppe mit Donor- oder Akzeptorwirkung;
- Z': eine Bindung oder NR"", CR""'₂, O, Si oder S, bevorzugt eine Bindung,
- R"": unabhängig voneinander Alkyl oder Aryl
- R""': unabhängig voneinander Wasserstoff, Alkyl oder Aryl;
- o', p': unabhängig voneinander 0, 1 oder 2, bevorzugt 0.

Die Gruppe 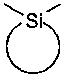 in den Silolverbindungen der Formel (I) ist ein Si enthaltender Ring, der 4 bis 10, bevorzugt 5 bis 7, besonders bevorzugt 5 oder 6, ganz besonders bevorzugt 5 Ringglieder aufweist, wobei der Ring gesättigt oder ein- oder mehrfach ungesättigt sein kann und neben dem Si-Atom ein oder mehrere weitere Heteroatome, bevorzugt ausgewählt aus O, S und N, besonders bevorzugt O und N aufweisen kann, und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein kann, wobei der Si-enthaltende Ring des Weiteren Teil eines kondensierten Ringsystems aufgebaut aus mindestens 2, bevorzugt 2 oder 3, besonders bevorzugt 3 Ringen sein kann, wobei die weiteren Ringe - neben dem Si enthaltenden Ring - in dem kondensierten Ringsystem unabhängig voneinander gesättigt oder ein -oder mehrfach ungesättigt und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein können und ein oder mehrere Heteroatome, bevorzugt ausgewählt aus O, S und N, besonders bevorzugt S und N, aufweisen können.

In einer bevorzugten Ausführungsform handelt es sich bei der Gruppe 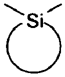 in der allgemeinen Formel (I) um einen Si enthaltenden Ring, der 5 oder 6 Ringglieder aufweist, wobei der Ring mindestens zweifach ungesättigt ist und neben dem Si-Atom keine oder eine weitere Heteroatom haltige Gruppe ausgewählt aus S, O, SO, SO₂ und N, bevorzugt O und N, aufweist und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein kann, wobei der Si enthaltende Ring Teil eines kondensierten Ringsystems aufgebaut aus 2 oder 3, bevorzugt 3, Ringen sein kann, wobei die weiteren Ringe - neben dem Si enthaltenden Ring - in dem kondensierten Ringsystem unabhängig voneinander gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein können und ein oder zwei Heteroatome ausgewählt aus O, S, SO, SO₂ und N, bevorzugt S und N aufweisen können.

Besonders bevorzugt weist die Gruppe 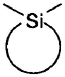 in Formel (I) die folgende Formel (Sia) auf: 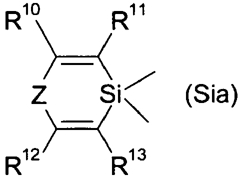 worin bedeuten:
- Z: eine Bindung oder NR¹⁴, CR¹⁵R¹⁶, O, SO, SO₂, Si oder S, bevorzugt eine Bindung,
- R¹⁰ bis R¹³: unabhängig voneinander Wasserstoff, Alkyl, Cycloalkyl, Heterocycloalkyl, Aryl, Heteroaryl und Gruppen mit Donor- oder Akzeptorwirkung, oder R¹⁰ und R¹¹ und/oder R¹² und R¹³ und/oder R¹⁰ und R¹² bilden jeweils unabhängig voneinander gemeinsam mit den beiden jeweiligen Kohlenstoffatomen des Si enthaltenden Rings in der Formel (Sia), mit denen sie verknüpft sind, einen cyclischen Rest mit 5 oder 6 Ringatomen, der eine, zwei oder drei Doppelbindungen aufweisen kann und ein oder zwei Heteroatome ausgewählt aus N, SO, SO₂ oder S, bevorzugt N, aufweisen kann und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein kann, wobei der cyclische Rest mit 5 oder 6 Ringatomen des Weiteren mit einem oder mehreren weiteren cyclischen Resten mit 5 oder 6 Ringatomen anelliert sein kann;

- R¹⁴: Alkyl, Cycloalkyl, Heterocycloalkyl, Aryl oder Heteroaryl, bevorzugt Aryl oder Alkyl, besonders bevorzugt Phenyl; und
- R¹⁵, R¹⁶: unabhängig voneinander Wasserstoff, Alkyl, Cycloalkyl, Heterocycloalkyl, Aryl oder Heteroaryl, bevorzugt Phenyl oder Alkyl.

Ganz besonders bevorzugt weist die Gruppe 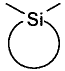 in Formel (I) die folgende Formel (Siaa) auf: 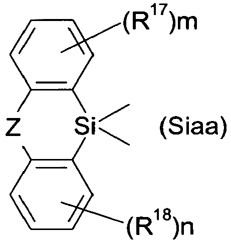 worin bedeuten:
- Z: eine Bindung oder NR¹⁴, CR¹⁵R¹⁶, O, SO, SO₂, Si oder S, bevorzugt eine Bindung,
- R¹⁴: Alkyl, Cycloalkyl, Heterocycloalkyl, Aryl oder Heteroaryl, bevorzugt Aryl oder Alkyl, besonders bevorzugt Phenyl; und
- R¹⁵, R¹⁶: unabhängig voneinander Wasserstoff, Alkyl, Cycloalkyl, Heterocycloalkyl, Aryl oder Heteroaryl, bevorzugt Aryl oder Alkyl;
- R¹⁷, R¹⁸: unabhängig voneinander Alkyl, Cycloalkyl, Heterocycloalkyl, Aryl, Heteroaryl, oder Gruppen mit Donor- oder Akzeptorwirkung bevorzugt Alkyl, Heteroaryl oder Gruppen mit Donor- oder Akzeptorwirkung, oder zwei benachbarte Reste R¹⁷ und/oder zwei benachbarte Reste R¹⁸ bilden jeweils unabhängig voneinander gemeinsam mit den beiden jeweiligen Kohlenstoffatomen, mit denen sie verknüpft sind, einen cyclischen Rest mit 5 oder 6 Ringatomen, der eine, zwei oder drei Doppelbindungen aufweisen kann und eine oder zwei Heteroatom haltige Gruppen ausgewählt aus N, O, SO, SO₂ oder S, bevorzugt N, aufweisen kann und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein kann;

- n, m: unabhängig voneinander 0, 1, 2, 3 oder 4, bevorzugt 0, 1 oder 2, besonders bevorzugt 0 oder 1, ganz besonders bevorzugt 0.

Die vorstehend erwähnten Gruppen Alkyl, Cycloalkyl, Heterocycloalkyl, Aryl, Heteroaryl, und Gruppen mit Donor- oder Akzeptorwirkung weisen in den allgemeinen Formeln (Sia) und (Siaa) die vorstehend erwähnten Bedeutungen auf.

Eine besonders bevorzugte Gruppe 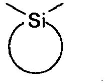 in Formel (I) ist nachstehend genannt 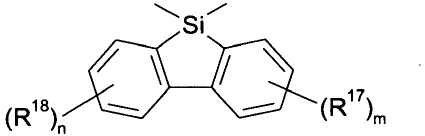 worin bedeuten:
- R¹⁷, R¹⁸: unabhängig voneinander Alkyl oder Gruppen mit Donor- oder Akzeptorwirkung,
- n, m: unabhängig voneinander 0 oder 1, bevorzugt 0.
R¹ in Formel (I) bedeutet A, Alkyl, Cycloalkyl, Heterocycloalkyl, Aryl oder Heteroaryl, bevorzugt Alkyl, Aryl oder Heteroaryl, besonders bevorzugt Alkyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl, Dibenzofuryl, Dibenzothienyl, Carbazolyl oder Azacarbazolyl. Die vorstehend genannten Gruppen können unsubstituiert oder mit Substituenten ausgewählt aus der Gruppe bestehend aus Alkyl, Cycloalkyl, Heterocycloalkyl, Aryl, Heteroaryl und Gruppen mit Donor- oder Akzeptorwirkung ein- oder mehrfach substituiert sein.

Bevorzugte Ausführungsformen bezüglich der vorstehend erwähnten Reste und Gruppen A, Alkyl, Cycloalkyl, Heterocycloalkyl, Aryl, Heteroaryl, Halogen und Pseudohalogen sind vorstehend erwähnt.

Auch offenbart wird die Verwendung von Verbindungen der Formel (Ia): 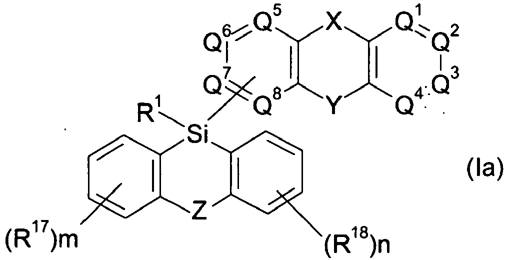 worin bedeuten:
- X: S, O, NR⁵, SO, SO₂ oder PR⁶, bevorzugt S, O oder NR⁵, besonders bevorzugt S oder O;
- Y: eine Bindung, NR⁵, CR⁷R⁸, O, SO, SO₂ oder S, bevorzugt eine Bindung oder NR⁵, besonders bevorzugt eine Bindung;
- Q¹ bis Q⁸: unabhängig voneinander CR⁹ oder N, bevorzugt unabhängig voneinander CR⁹ wobei über eine der Gruppen Q¹ bis Q⁸ eine Bindung zu dem Si-Atom der Gruppe 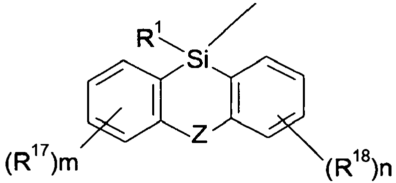 erfolgt, und diese Gruppe C bedeutet;
- R⁵, R⁶: unabhängig voneinander Alkyl, Cycloalkyl, Heterocycloalkyl, Aryl oder Heteroaryl, bevorzugt Aryl oder Alkyl, besonders bevorzugt Phenyl;
- R⁷, R⁸: unabhängig voneinander Wasserstoff, Alkyl, Cycloalkyl, Heterocycloalkyl, Aryl oder Heteroaryl, bevorzugt Alkyl oder Aryl;
- R⁹: unabhängig voneinander Wasserstoff, Alkyl, Cycloalkyl, Heterocycloalkyl, Aryl, Heteroaryl, SiR²R³R⁴ oder eine Gruppe mit Donor- oder Akzeptorwirkung, bevorzugt Wasserstoff, Alkyl, Heteroaryl, eine Gruppe mit Donoroder Akzeptorwirkung oder SiR²R³R⁴;
- R², R³, R⁴: unabhängig voneinander Alkyl, Cycloalkyl, Heterocycloalkyl, Aryl, Heteroaryl bedeuten, wobei die Reste R², R³ und R⁴ oder zwei der Reste R², R³ und R⁴ des Weiteren gemeinsam ein kondensiertes Ringsystem aus 2 bis 6 Ringen, bevorzugt 2 bis 3 Ringen, die jeweils gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bilden können;
- Z: eine Bindung oder NR¹⁴, CR¹⁵R¹⁶, O, SO, SO₂, Si oder S, bevorzugt eine Bindung;
- R¹⁴: Alkyl, Cycloalkyl, Heterocycloalkyl, Aryl oder Heteroaryl, bevorzugt Alkyl oder Aryl; besonders bevorzugt Phenyl;
- R¹⁵, R¹⁶: unabhängig voneinander Wasserstoff, Alkyl, Cycloalkyl, Heterocycloalkyl, Aryl oder Heteroaryl, bevorzugt Alkyl oder Aryl
- R¹⁷, R¹⁸: unabhängig voneinander Alkyl, Cycloalkyl, Heterocycloalkyl, Aryl, Heteroaryl oder eine Gruppe mit Donor- oder Akzeptorwirkung, bevorzugt Alkyl, Heteroaryl oder eine Gruppe mit Donor- oder Akzeptorwirkung, oder zwei benachbarte Reste R¹⁷ und/oder zwei benachbarte Reste R¹⁸ bilden jeweils unabhängig voneinander gemeinsam mit den beiden jeweiligen Kohlenstoffatomen, mit denen sie verknüpft sind, einen cyclischen Rest mit 5 oder 6 Ringatomen, der eine, zwei oder drei Doppelbindungen aufweisen kann und eine oder zwei Heteroatom haltige Gruppen ausgewählt aus N, O, SO, SO₂ oder S, bevorzugt N, aufweisen kann und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, substituiert sein kann;
- n, m: unabhängig voneinander 0, 1, 2, 3 oder 4, bevorzugt 0, 1 oder 2, besonders bevorzugt 0 oder 1, ganz besonders bevorzugt 0;
- R¹: 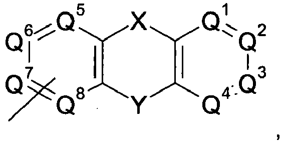 Alkyl, Cycloalkyl, Heterocycloalkyl, Aryl oder Heteroaryl, bevorzugt Alkyl, Aryl oder Heteroaryl, besonders bevorzugt Alkyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl oder Dibenzofuryl, Dibenzothienyl, Carbazolyl oder Azacarbazolyl.

Bevorzugte Ausführungsformen der in der Formel (la) genannten Reste und Gruppen sind die bezüglich der entsprechenden Reste und Gruppen vorstehend genannten Ausführungsformen.

Ganz besonders bevorzugte Verbindungen der Formel (I) weisen die folgenden allgemeine Formel auf: 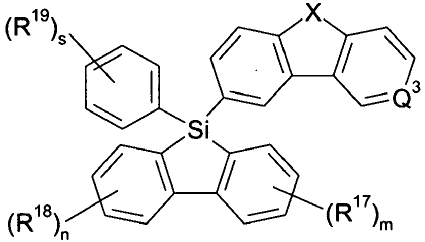 worin bedeuten:
- X: O, S, SO, SO₂ oder NR⁵, bevorzugt O oder S;
- R⁵: Aryl oder Alkyl, bevorzugt Phenyl;
- Q³: C-H oder 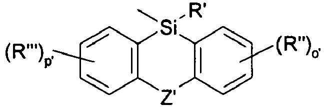
worin bedeuten
- R': Alkyl oder Aryl;
- R", R"': unabhängig voneinander Alkyl, Heteroaryl oder eine Gruppe mit Donor- oder Akzeptorwirkung;
- Z': eine Bindung oder NR"", CR""', O, SO, SO₂, Si oder S, bevorzugt eine Bindung;
- R"": unabhängig voneinander Alkyl oder Aryl;
- R""': unabhängig voneinander Wasserstoff, Alkyl oder Aryl;
- o', p': unabhängig voneinander 0, 1 oder 2, bevorzugt 0,
- R¹⁷, R¹⁸: unabhängig voneinander Alkyl oder eine Gruppe mit Donor- oder Akzeptorwirkung,
- R¹⁹: unabhängig voneinander Alkyl oder eine Gruppe mit Donor- oder Akzeptorwirkung, oder zwei benachbarte Gruppen R¹⁹ bilden gemeinsam einen Ring, der bevorzugt 5 oder 6, besonders bevorzugt 5, Ringglieder aufweist, wobei alle Ringglieder Kohlenstoffatome sein können oder ein oder zwei, bevorzugt ein, Ringglieder Heteroatome ausgewählt aus O, S oder N sind und die übrigen Ringglieder Kohlenstoffatome sind, wobei der Ring unsubstituiert oder mit einem oder mehreren vorstehend bezüglich der Arylreste genannten Substituenten substituiert sein kann und/oder mit einem oder mehreren, bevorzugt einem, weiteren Ringen anelliert sein kann, wobei der Ring bevorzugt benzanelliert ist; besonders bevorzugt handelt es sich bei dem Ring um einen benzanellierten 5-gliedrigen Ring, der in dem 5gliedrigen Ring ein Heteroatom ausgewählt aus O, S und N aufweist;
- n, m: unabhängig voneinander 0, 1 oder 2, bevorzugt 0 oder 1, besonders bevorzugt 0;
- s: 0, 1 oder 2, bevorzugt 0 oder, in dem Fall, wenn zwei benachbarte Gruppen R¹⁹ einen Ring bilden, 2.

Beispiele für geeignete Verbindungen der Formel (I) sind:

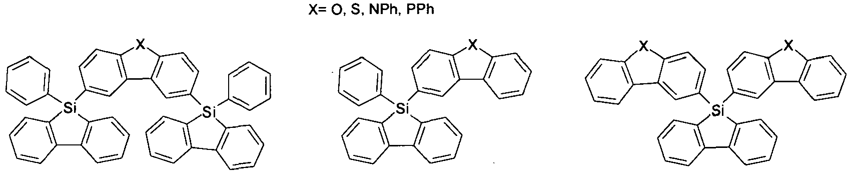

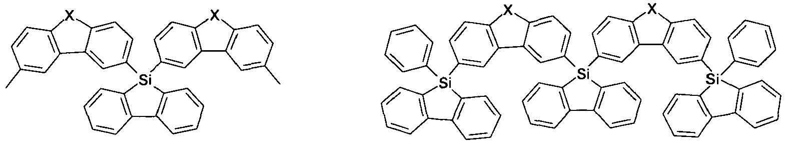

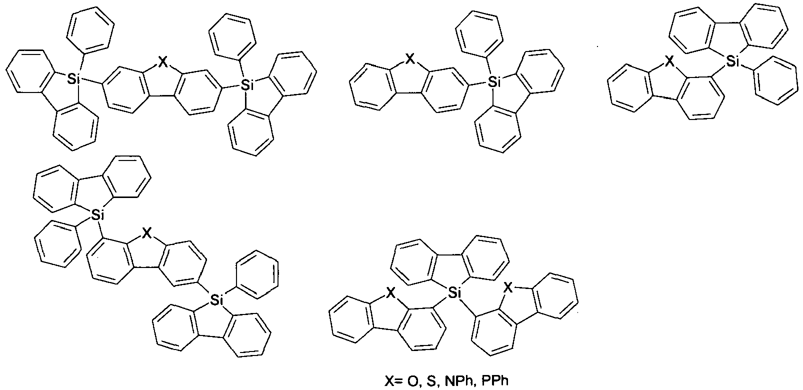

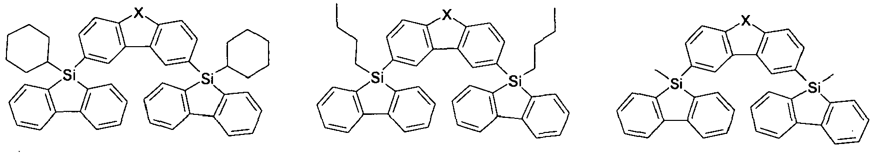

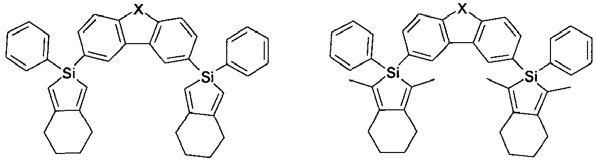

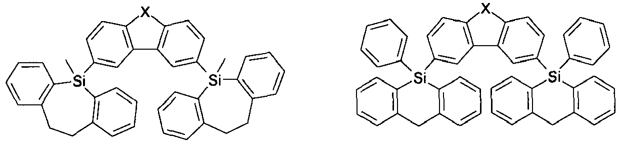

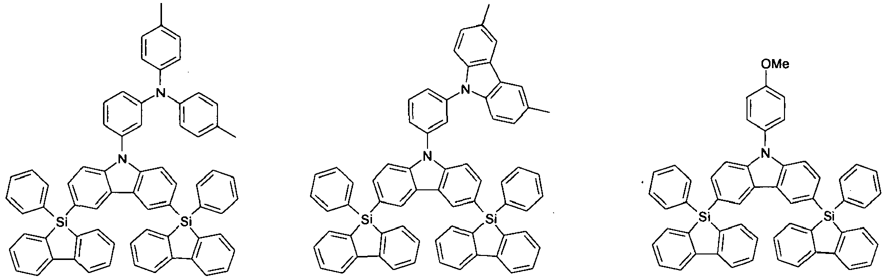

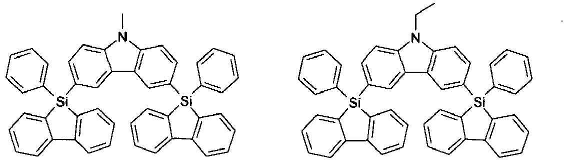

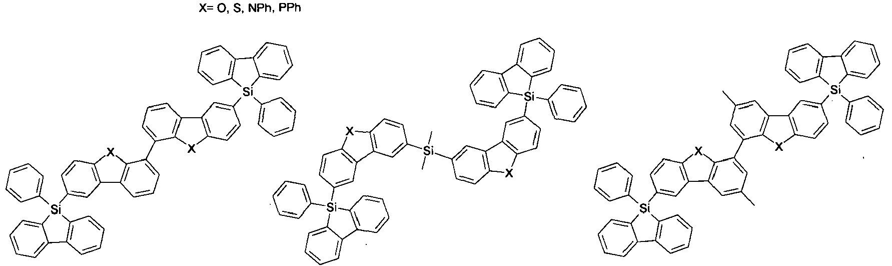

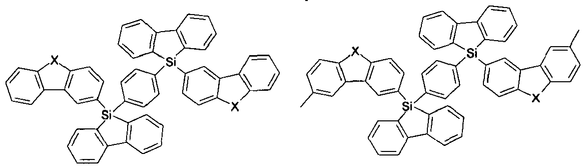

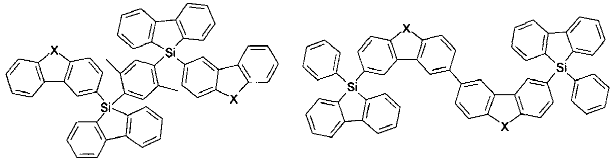

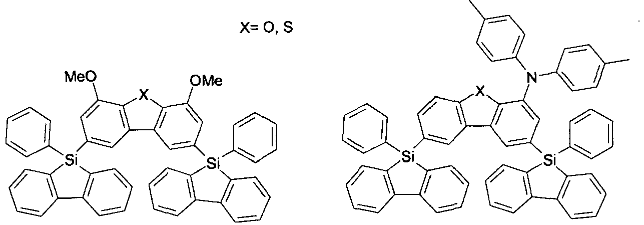

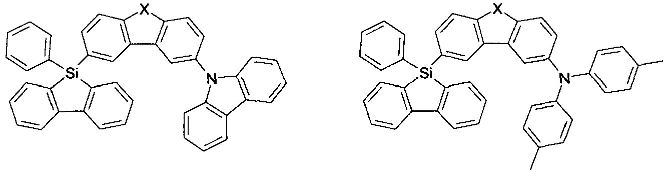

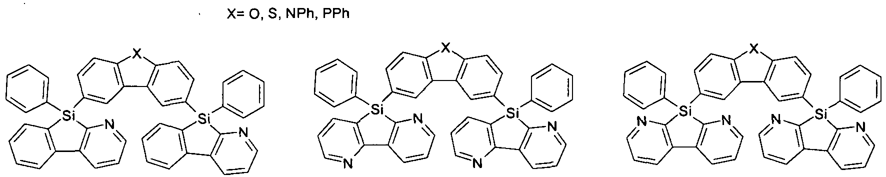

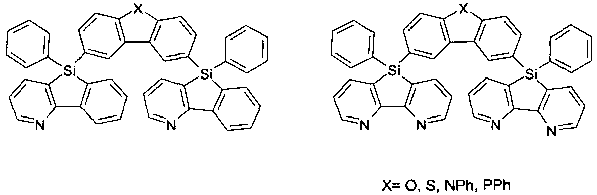

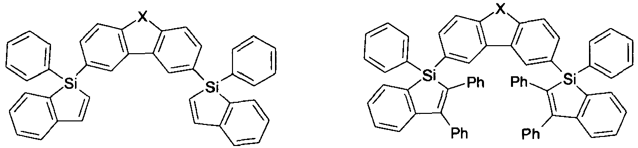

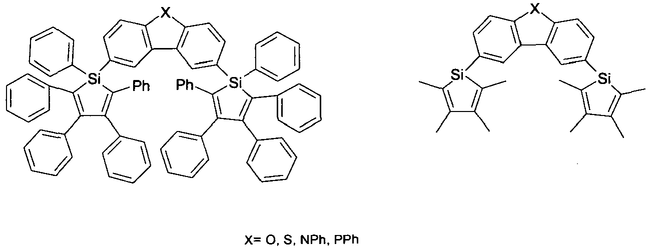

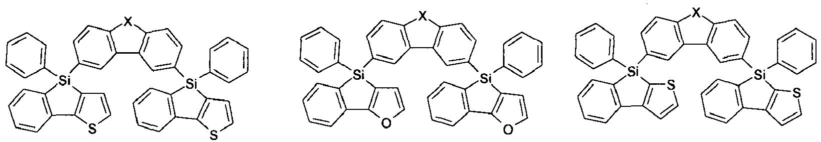

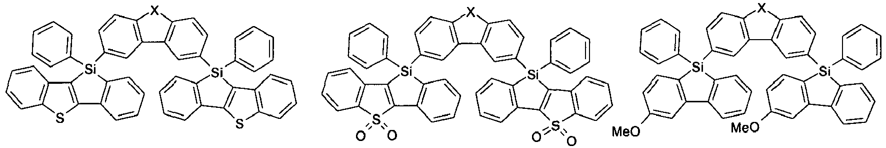

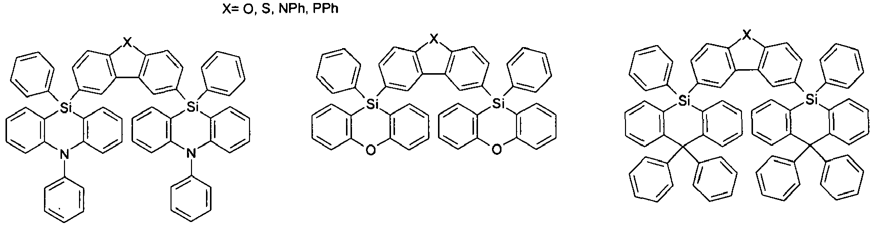

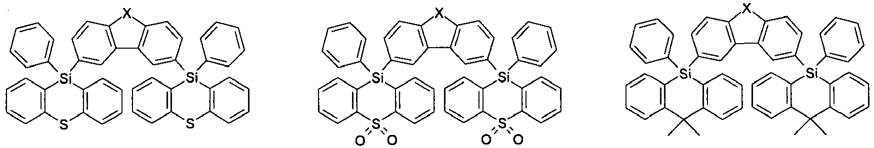

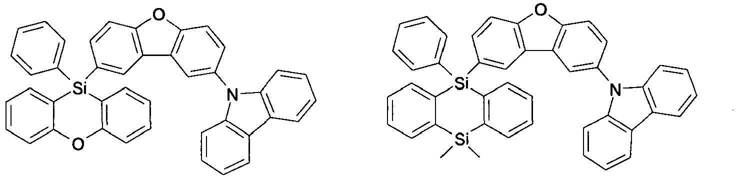

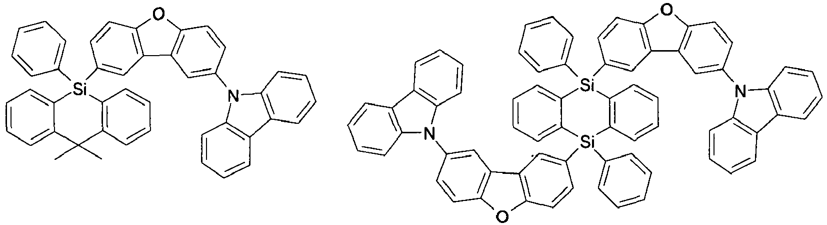

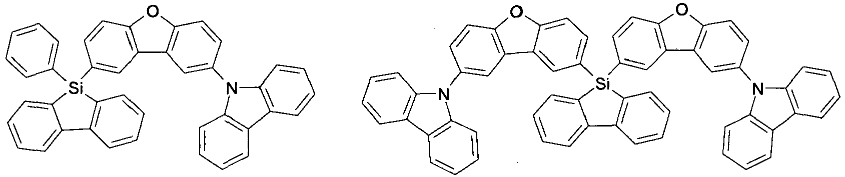

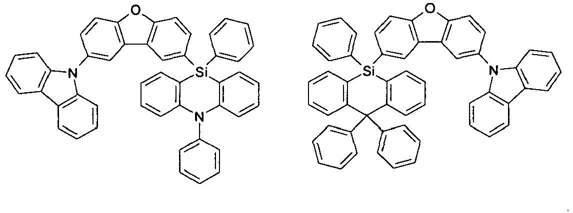

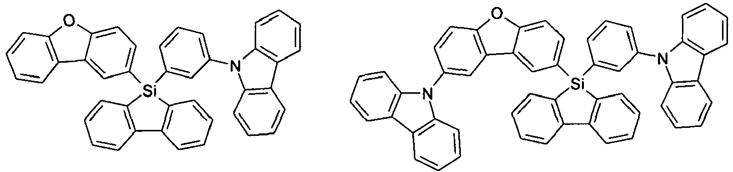

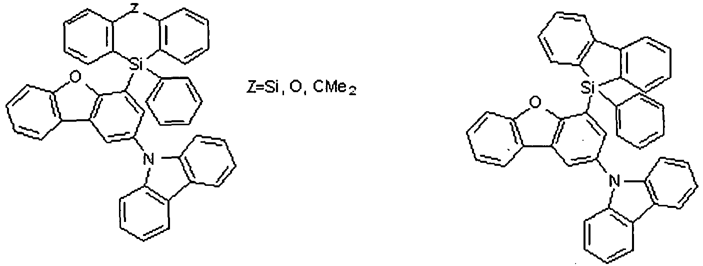

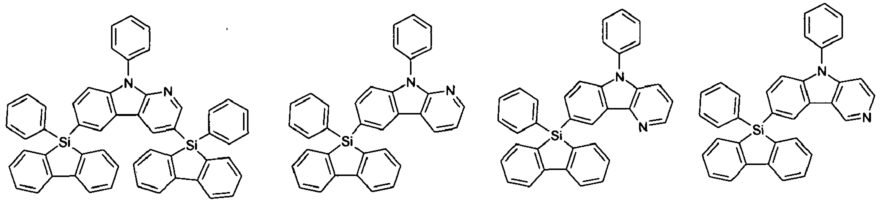

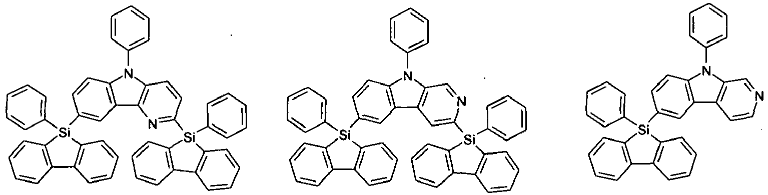

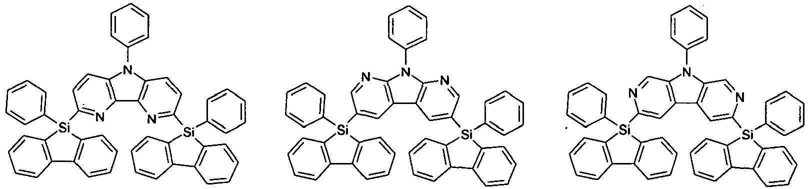

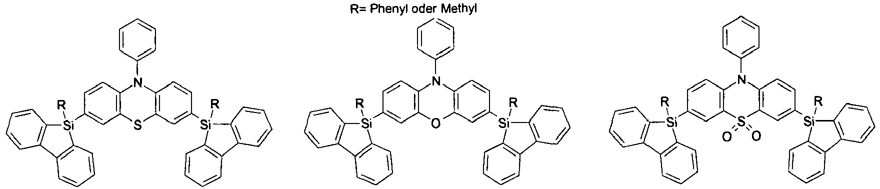

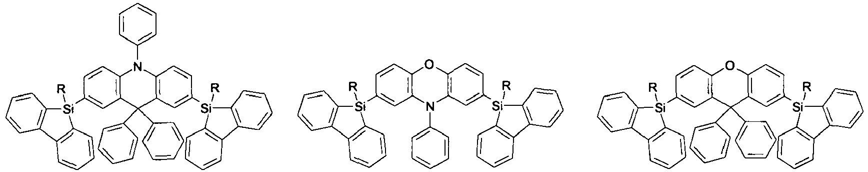

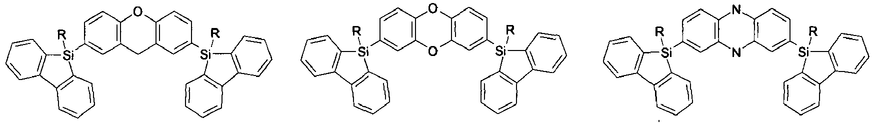

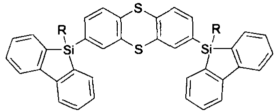

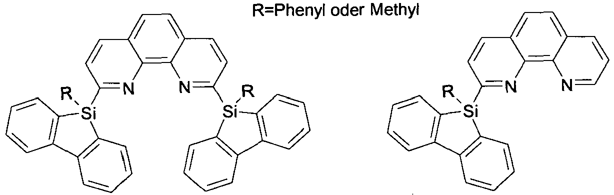

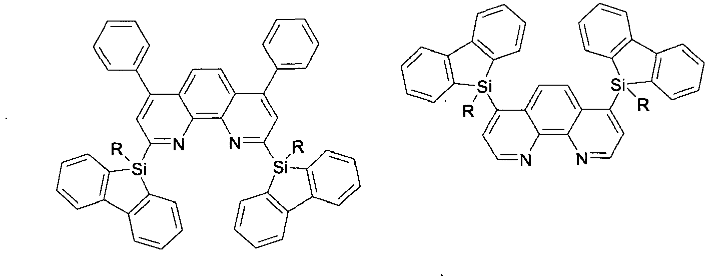

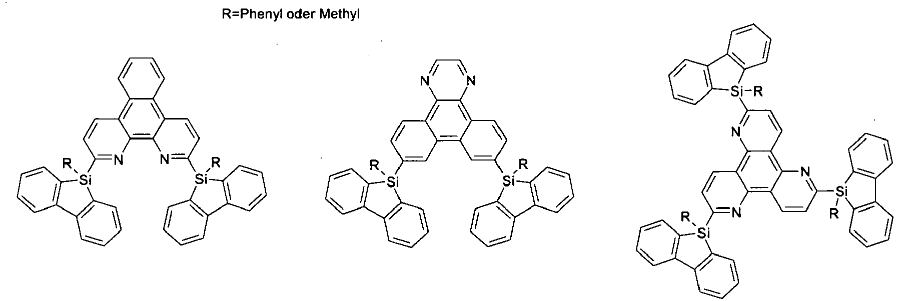

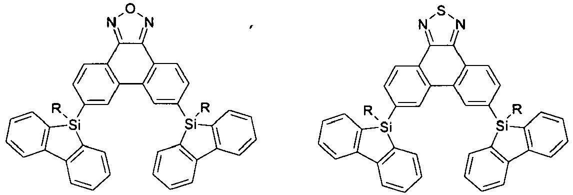

Beispiele für ganz besonders bevorzugte Verbindungen der Formel (I) sind:

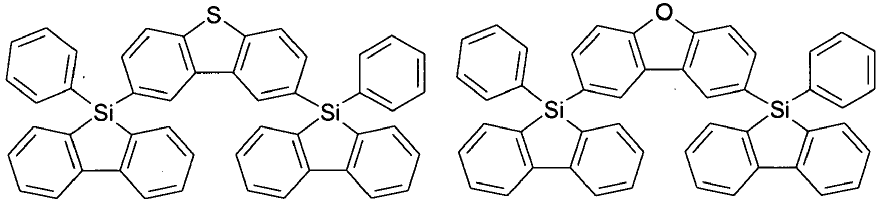

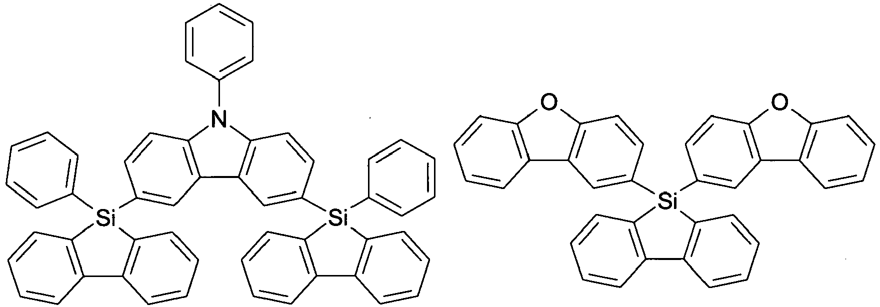

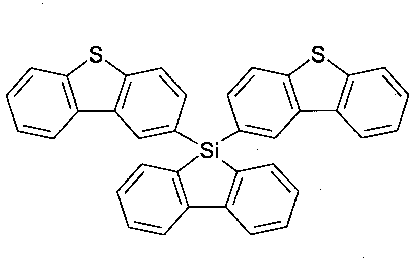

Es wurde gefunden, dass die vorstehend genannten Silolverbindungen der Formel (I) sich als Matrix- und/oder Loch-/Excitonenblocker-Materialien für organisch elektronische Anwendungen hervorragend geeignet sind. Insbesondere eignen sich die Silolverbindungen der allgemeinen Formel (I) für den Einsatz in OLEDs, wobei sie insbesondere dann bevorzugt als Matrix- und/oder Loch-/Elektronenblockermaterialien eingesetzt werden können, wenn blaues oder grünes Licht-emittierende OLEDs bereitgestellt werden sollen.

Eine Gruppe der Silolverbindungen der allgemeinen Formel (I), die die allgemeine Formel (Ib) aufweist, ist im Stand der Technik nicht bekannt.

Ein Gegenstand der vorliegenden Erfindung betrifft daher Silolverbindungen der allgemeinen Formel (Ib) 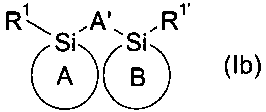 worin bedeuten:
- A': ein kondensiertes Ringsystem aufgebaut aus mindestens 3, bevorzugt 3 oder 4, besonders bevorzugt 3, kondensierten Ringen, die unabhängig voneinander 4 bis 10, bevorzugt 5 bis 7, besonders bevorzugt 5 oder 6 Ringglieder aufweisen und gesättigt oder ein- oder mehrfach ungesättigt sowie unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, bevorzugt Alkyl, Heteroaryl und Gruppen mit Donor- oder Akzeptorwirkung substituiert sein können, wobei das kondensierte Ringsystem mindestens eine Heteroatom haltige Gruppe, bevorzugt ausgewählt aus O, S, N, P, SO, SO₂ und Si, besonders bevorzugt O, S und N, ganz besonders bevorzugt O und S, in dem kondensierten Ringsystem selbst oder in mindestens einem Substituenten, bevorzugt in dem kondensierten Ringsystem selbst, aufweist; 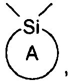 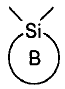 unabhängig voneinander jeweils ein Si enthaltender Ring, der 4 bis 10, bevorzugt 5 bis 7, besonders bevorzugt 5 oder 6, ganz besonders bevorzugt 5 Ringglieder aufweist, wobei der Ring gesättigt oder ein- oder mehrfach ungesättigt sein kann und neben dem Si-Atom eine oder mehrere weitere Heteroatom haltige Gruppen, bevorzugt ausgewählt aus O, S, SO, SO₂ und N, besonders bevorzugt O und N aufweisen kann, und unsubstituiert oder mit einem oder mehreren Substituenten ausgewählt aus Alkyl, Cycloalkyl, Heterocycloalkyl, Aryl, Hetereoaryl und Gruppen mit Donor- oder Akzeptorwirkung substituiert sein kann, wobei der Si-enthaltende Ring des Weiteren Teil eines kondensierten Ringsystems aufgebaut aus mindestens 2, bevorzugt 2 oder 3, besonders bevorzugt 3 kondensierten Ringen sein kann, wobei die weiteren Ringe - neben dem Si enthaltenden Ring - in dem kondensierten Ringsystem unabhängig voneinander gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung substituiert sein können und eine oder mehrere Heteroatom haltige Gruppen, bevorzugt ausgewählt aus O, S, SO, SO₂ und N, besonders bevorzugt S und N, aufweisen können;
- R¹, R^{1'}: unabhängig voneinander A, Alkyl, Cycloalkyl, Heterocycloalkyl, Aryl oder Heteroaryl, bevorzugt Alkyl, Aryl oder Heteroaryl, besonders bevorzugt Alkyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl oder Dibenzofuryl, Dibenzothienyl, Carbazolyl oder Azacarbazolyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl, und Gruppen mit Donor- oder Akzeptorwirkung substituiert sein können;
- A: ein kondensiertes Ringsystem aufgebaut aus mindestens 3 kondensierten Ringen, die unabhängig voneinander 4 bis 10 Ringglieder aufweisen und gesättigt oder ein- oder mehrfach ungesättigt sowie substituiert oder mit einem oder mehreren Substituenten ausgewählt aus Alkyl, Cycloalkyl, Heterocycloalkyl, Aryl, Heteroaryl, SiR²R³R⁴ und Gruppen mit Donor- oder Akzeptorwirkung substituiert sein können, wobei das kondensierte Ringsystem mindestens ein Heteroatom in dem kondensierten Ringsystem selbst oder in mindestens einem Substituenten aufweist.

Bevorzugte Gruppen A, Alkyl, Cycloalkyl, Heterocycloalkyl, Aryl, Heteroaryl und Gruppen mit Donor- oder Akzeptorwirkung sind vorstehend genannt.

Bevorzugte Gruppen A' entsprechen den vorstehend genannten Gruppen A, wobei die Gruppe A' im Gegensatz zu der Gruppe A zwei Verknüpfungsstellen zu jeweils einem Si enthaltenden Ring aufweist. A' bedeutet somit besonders bevorzugt 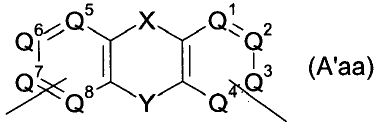 worin bedeuten:
- X: S, O, NR⁵, SO, SO₂ oder PR⁶, bevorzugt S, O oder NR⁵, besonders bevorzugt S oder O;
- Y: eine Bindung oder NR⁵, CR⁷R⁸, O, SO, SO₂ oder S, bevorzugt eine Bindung oder NR⁵, besonders bevorzugt eine Bindung;
- Q¹ bis Q⁸: unabhängig voneinander CR⁹ oder N, bevorzugt unabhängig voneinander CR⁹, wobei über eine der Gruppen Q¹, Q², Q³ oder Q⁴ und über eine der Gruppen Q⁵, Q⁶, Q⁷ oder Q⁸ eine Bindung zu dem jeweiligen Si-Atom der Gruppen 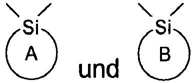 erfolgt und diese Gruppe Q¹, Q², Q³ oder Q⁴ sowie Q⁵, Q⁶, Q⁷ oder Q⁸ C bedeutet;
- R⁵, R⁶: unabhängig voneinander Alkyl, Cycloalkyl, Heterocycloalkyl, Aryl oder Heteroaryl, bevorzugt Aryl oder Alkyl, besonders bevorzugt Phenyl;
- R⁷, R⁸: unabhängig voneinander Wasserstoff, Alkyl, Cycloalkyl, Heterocycloalkyl, Aryl oder Heteroaryl, bevorzugt Alkyl oder Aryl;
- R⁹: Wasserstoff, Alkyl, Cycloalkyl, Heterocycloalkyl, Aryl, Heteroaryl oder eine Gruppe mit Donor- oder Akzeptorwirkung, bevorzugt Wasserstoff, Alkyl, Heteroaryl oder eine Gruppe mit Donor- oder Akzeptorwirkung.

Besonders bevorzugt erfolgt die Verknüpfung zu dem Si-Atom der Gruppe 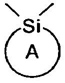 über die Gruppe Q⁷, die entsprechend C bedeutet, und die Verknüpfung zu dem Si-Atom der Gruppe 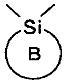 über die Gruppe Q³, die entsprechend C bedeutet. Die übrigen Gruppen Q¹, Q², Q⁴, Q⁵, Q⁶ und Q⁸ bedeuten in einer ganz besonders bevorzugten Ausführungsform Wasserstoff.

Bevorzugte Ausführungsformen der Gruppen 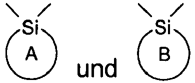 der allgemeinen Formel (Ib) entsprechen den bevorzugten Ausführungsformen der Gruppe

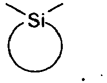

Bevorzugte Ausführungsformen der Reste R¹ und R^{1'} in Formel (Ib) entsprechen dem Rest R¹ in Formel (I).

Ganz besonders bevorzugte Verbindungen der Formel (Ib) weisen die allgemeine Formel (Iba) auf:

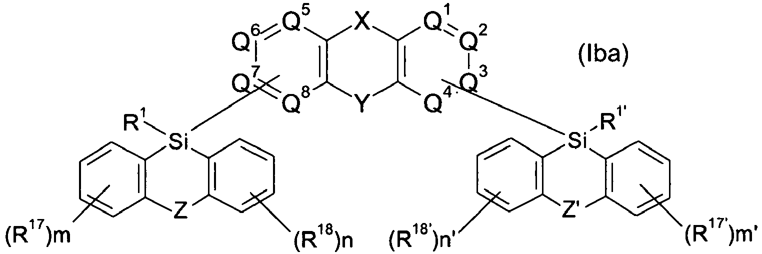

Die in Formel (Iba) genannten Gruppen weisen die bezüglich der Verbindungen der Formel (I) genannten bevorzugten Bedeutungen für die Reste und Gruppen X, Y, Q¹ bis Q⁸, Z, R¹, R^{1'}, R¹⁷, R¹⁸, n und m auf, wobei - wie vorstehend erwähnt - jeweils eine der Gruppen Q¹, Q², Q³ oder Q⁴ und Q⁵, Q⁶, Q⁷ oder Q⁸ C bedeutet und eine Bindung zu dem Si-Atom des jeweiligen Si enthaltenden Rings aufweist. Die in Formel (Iba) genannten Reste und Gruppen Z', R^{17'}, R^{18'}, m', n' weisen unabhängig die für die Gruppen Z, R¹⁷, R¹⁸, m und n genannten Bedeutungen auf.

Ganz besonders bevorzugte Verbindungen der Formel (Ibaa) sind nachstehend genannt: 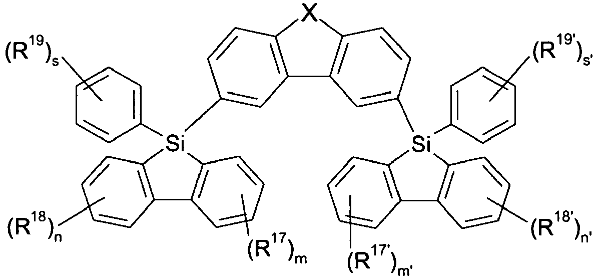 wobei die Gruppen X, R¹⁷, R¹⁸, R^{17'}, R^{18'}, n, m, n' und m' die vorstehend genannten Bedeutungen aufweisen.

Die Herstellung der Verbindungen der Formel (I) erfolgt in Anlehnung an dem Fachmann bekannte Verfahren, z. B. durch
(i) Transmetallierung der Verbindung
   A-Hal, worin A die vorstehend genannten Bedeutungen aufweist und Hal Halogen, bevorzugt Br oder I, bedeutet, gemäß dem Fachmann bekannten Verfahren, z. B. mit Mg, n-BuLi, sec. BuLi oder tert.-BuLi, und
(ii) anschließende Reaktion der transmetallierten Verbindung mit einer Chlorsilolverbindung der Formel 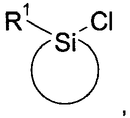 worin R¹ und 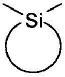 die vorstehend genannten Bedeutungen aufweisen.

Geeignete Verfahrensbedingungen zur Transmetallierung und weiteren Umsetzung sind dem Fachmann bekannt und z. B. in J. Am. Chem. Soc. 2005, 127, 9021-9029, Seite 9023 und Chem. Lett. 2007, 36, 1138 bezüglich der Herstellung von Silolen genannt.

Geeignete halogenierte Verbindungen A-Hal können gemäß dem Fachmann bekannten Verfahren hergestellt werden. Geeignete Verfahren sind z. B. für N-Phenylcarbazol in M. Park, J.R. Buck, C.J. Rizzo, Tetrahedron, 1998, 54, 12707-12714 und für Dibenzothiophen in W. Yang et al., J. Mater. Chem. 2003, 13, 1351 und in Meille et al., J. Catal. 1997, 170, 29 beschrieben. Die Synthese von 2,8-Dibromdibenzofuran kann analog ausgeführt werden. Die Synthese von 4-Bromdibenzofuran wird in D.J. Cram et al, J. Am. Chem. Soc., 1984, 106, 3286 beschrieben. Die Synthese von 3-Bromdibenzofuran wird in Cullinane, Padfield, J. Chem. Soc. 1935, 1131 beschrieben. Die Synthese von 2-Bromdibenzofuran wird in J. Org. Chem. 1997, 62, 1348 beschrieben. Des Weiteren sind einige bromierte Verbindungen A-Hal kommerziell erhältlich, z. B. Verbindungen, worin X (in der Gruppe A) = NH (CAS 6825-20-3), NPh (CAS 57103-20-5) und S (CAS 31574-87-5) bedeutet.

Die Synthese geeigneter Chlorsilolverbindungen erfolgt ebenfalls gemäß oder analog zu dem Fachmann bekannten Verfahren. Zum Beispiel ist die Synthese von 5-Chlor-5-Phenyldibenzosilol und 5,5-Dichlordibenzosilol in J. Am. Chem. Soc., 1958, 80, 1883 beschrieben und die Synthese von 5,5-Dichlordibenzosilol des Weiteren in Chem. Lett., 2007, 36, 1138 und J.Am.Chem.Soc. 2002, 124, 49.

Die Synthese von substituierten Silolen wird u.a. beschrieben von Murakami in Org. Lett. 2007, 9, 133 und in Org. Lett. 2007, 9, 93, wobei die Synthese von geeigneten Vorstufen dem Fachmann bekannt ist.

Außerdem können geeignete substitierte Silole z. B. nach dem folgenden Verfahren hergestellt werden: 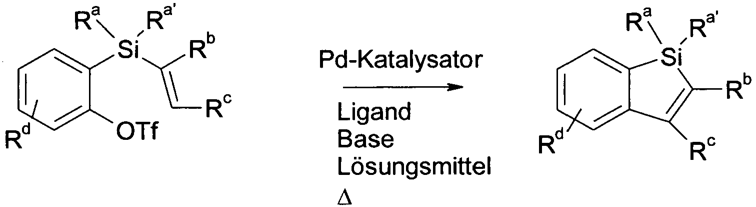 worin bedeuten:
- R^{a}, R^{a'}: unabhängig voneinander Alkyl, Cycloalkyl, Heterocycloalkyl, Aryl, Heteroaryl, bevorzugt Alkyl oder Aryl;
- R^{b}, R^{c}: unabhängig voneinander Wasserstoff, Alkyl, Cycloalkyl, Heterocycloalkyl, Aryl, Heteroaryl und Gruppen mit Donor- oder Akzeptorwirkung, oder R^{a} und R^{a'} bilden gemeinsam mit den beiden jeweiligen Kohlenstoffatomen des Si enthaltenden Rings, mit denen sie verknüpft sind, einen cyclischen Rest mit 5 oder 6 Ringatomen, der eine, zwei oder drei Doppelbindungen aufweisen kann und ein oder zwei Heteroatome ausgewählt aus N, SO, SO₂ oder S, bevorzugt N, aufweisen kann und unsubstituiert oder mit einem oder mehreren Substituenten ausgewählt aus Alkyl, Cycloalkyl, Heterocycloalkyl, Aryl, Heteroaryl und Gruppen mit Donoroder Akzeptorwirkung, substituiert sein kann, wobei der cyclische Rest mit 5 oder 6 Ringatomen des Weiteren mit einem oder mehreren weiteren cyclischen Resten mit 5 oder 6 Ringatomen anelliert sein kann;
- R^{d}: Alkyl, Cycloalkyl, Heterocycloalkyl, Aryl, Heteroaryl oder eine Gruppe mit Donoroder Akzeptorwirkung, bevorzugt Alkyl, Heteroaryl oder eine Gruppe mit Donoroder Akzeptorwirkung.

Geeignete Pd-Katalysatoren, Basen, Lösungsmittel und Liganden, z. B. Phosphanliganden, sowie geeignete Reaktionsbedingungen sind dem Fachmann bekannt.

Die erfindungsgemäßen Silolverbindungen der Formel (Ib) werden erfindungsgemäß in organisch elektronischen Anwendungen ausgewählt aus schaltenden Elementen wie organischen Transistoren, z. B. organischen FET und organischen TFT, organischen Solarzellen und organischen Leuchtdioden (OLED) eingesetzt, wobei die Verbindungen der Formel (Ib) in OLEDs als Matrix- und/oder Loch-/Excitonenblockermaterialien eingesetzt werden. In einer bevorzugten Ausführungsform betrifft die vorliegende Anmeldung die Verwendung der Verbindungen der Formel (Ib) als Matrix- und/oder Loch-/Excitonenblockermaterialien in OLEDs. Geeignete Aufbauten der organisch elektronischen Anwendungen sind dem Fachmann bekannt.

Auch offenbart wir der Einsatz der Silolverbindungen der Formel (I) in organisch elektronischen Anwendungen ausgewählt aus schaltenden Elementen wie organischen Transistoren, z. B. organischen FET und organischen TFT, organischen Solarzellen und organischen Leuchtdioden (OLED), wobei die Verbindungen der Formel (I) in OLEDs als Matrix- und/oder Loch-/Excitonenblockermaterialien eingesetzt werden. In einer bevorzugten Ausführungsform wird die Verwendung der Verbindungen der Formel (I) als Matrix- und/oder Loch-/Excitonenblockermaterialien in OLEDs offenbart. Geeignete Aufbauten der organisch elektronischen Anwendungen sind dem Fachmann bekannt.

Der organische Transistor beinhaltet im Allgemeinen eine Halbleiterschicht, die aus einer organischen Schicht mit einer Lochtransportfähigkeit und/oder Elektronentransportfähigkeit gebildet ist; eine aus einer leitfähigen Schicht gebildete Gate-Elektrode; und eine zwischen der Halbleiterschicht und der leitfähigen Schicht eingebrachte Isolierschicht. An diese Anordnung wird eine Source-Elektrode und eine Drain-Elektrode angebracht, um so das Transistorelement herzustellen. Daneben können in dem organischen Transistor weitere dem Fachmann bekannte Schichten vorliegen. Die Silolverbindung der Formel (I) bzw. (Ib) kann in jeder beliebigen Schicht des organischen Transitors vorliegen.

Die organische Solarzelle (fotoelektrisches Umwandlungselement) enthält im Allgemeinen eine zwischen zwei parallel angeordneten, plattenartigen Elektroden befindliche organische Schicht. Die organische Schicht kann auf einer kammartigen Elektrode ausgebildet sein. Es besteht keine besondere Einschränkung bezüglich des Orts der organischen Schicht und es besteht keine besondere Einschränkung bezüglich des Materials der Elektroden. Wenn jedoch plattenartige, parallel angeordnete Elektroden eingesetzt werden, ist zumindest eine Elektrode bevorzugt aus einer transparenten Elektrode, wie z. B. einer ITO-Elektrode oder einer fluordotierten Zinnoxidelektrode, gebildet. Die organische Schicht ist aus zwei Subschichten gebildet, d.h. einer Schicht mit p-Typ-Halbleitereigenschaft oder Loch-Transportfähigkeit, sowie einer mit n-Typ-Halbleitereigenschaft oder Elektronen-Transportfähigkeit gebildeten Schicht. Daneben können in der organischen Solarzelle weitere, dem Fachmann bekannte Schichten vorliegen. Die Silolverbindung der Formel (I) bzw. (Ib) kann in jeder beliebigen Schicht der organischen Solarzelle vorliegen.

Bevorzugt werden die Silolverbindungen der Formeln (I) bzw. (Ib) als Matrix- und/oder Loch-/Excitonenblockermaterialien in organischen Leuchtdioden (OLEDs) eingesetzt. Geeignete Schichtenfolgen von OLEDs sind dem Fachmann bekannt und nachstehend genannt.

In einer weiteren Ausführungsform betrifft die vorliegende Erfindung eine organische Leuchtdiode, worin die Silolverbindungen der Formel (Ib) als Matrixmaterialien, bevorzugt in der Licht-emittierenden Schicht einer OLED, eingesetzt werden.

Auch offenbart wird eine organische Leuchtdiode, worin die Silolverbindungen der Formel (I) als Matrixmaterialien, bevorzugt in der Licht-emittierenden Schicht einer OLED, eingesetzt werden.

In einer weiteren Ausführungsform betrifft die vorliegende Erfindung eine organische Leuchtdiode, worin die Silolverbindungen der Formel (Ib) als Loch/Excitonenblocker, bevorzugt in einer Blockschicht für Löcher, eingesetzt werden.

Auch offenbart wird eine organische Leuchtdiode, worin die Silolverbindungen der Formel (I) als Loch/Excitonenblocker, bevorzugt in einer Blockschicht für Löcher, eingesetzt werden.

Es ist ebenfalls möglich, dass die Verbindungen der Formel (I) bzw. (Ib) sowohl in der Licht-emittierenden Schicht (als Matrix) als auch in der Blockschicht für Löcher vorliegen.

Des. Weiteren können weitere Schichten der OLED (neben der Licht-emittierenden Schicht und/oder der Blockschicht für Löcher) eine oder mehrere Verbindungen der Formel (I) oder (Ib) enthalten.

Ein weiterer Gegenstand der vorliegenden Erfindung ist somit die Verwendung der Silolverbindungen der Formel (Ib) als Matrixmaterialien und/oder Loch-/Excitonenblockermaterialien in organischen Leuchtdioden. Bevorzugt werden die Silolverbindungen der Formel (Ib) in organischen Leuchtdioden in der Licht-emittierenden Schicht und/oder einer Blockschicht für Löcher/Excitonen eingesetzt.

Auch offenbart ist die Verwendung der Silolverbindungen der Formel (I) als Matrixmaterialien und/oder Loch-/Excitonenblockermaterialien in organischen Leuchtdioden. Bevorzugt werden die Silolverbindungen der Formel (I) in organischen Leuchtdioden in der Licht-emittierenden Schicht und/oder einer Blockschicht für Löcher/Excitonen eingesetzt.

Ein weiterer Gegenstand der vorliegenden Erfindung ist eine organische Leuchtdiode enthaltend eine Anode An und eine Kathode Ka und eine zwischen der Anode An und der Kathode Ka angeordente Licht-emittierende Schicht E sowie gegebenenfalls mindestens eine Blockschicht für Löcher/Excitonen, wobei die organische Leuchtdiode mindestens eine Verbindung der Formel (Ib) enthält, die in der Licht-emittierenden Schicht und/oder in der mindestens einen Blockschicht für Löcher/Excitonen - soweit vorhanden - vorliegt.

Auch offenbart ist eine organische Leuchtdiode enthaltend eine Anode An und eine Kathode Ka und eine zwischen der Anode An und der Kathode Ka angeordente Licht-emittierende Schicht E sowie gegebenenfalls mindestens eine Blockschicht für Löcher/Excitonen, wobei die organische Leuchtdiode mindestens eine Verbindung der Formel (I) enthält, die in der Licht-emittierenden Schicht und/oder in der mindestens einen Blockschicht für Löcher/Excitonen - soweit vorhanden - vorliegt.

### Aufbau der erfindungsgemäßen OLED

Die erfindungsgemäße organische Leuchtdiode (OLED) weist somit den folgenden Aufbau auf:
eine Anode (An) und eine Kathode (Ka) und eine zwischen der Anode (An) und der Kathode (Ka) angeordnete Licht-emittierende Schicht E sowie gegebenenfalls mindestens eine Blockschicht für Löcher/Excitonen.

Die erfindungsgemäße OLED kann z. B. - in einer bevorzugten Ausführungsform - aus den folgenden Schichten aufgebaut sein:
1. Anode
2. Lochleiterschicht
3. Licht-emittierende Schicht
4. Blockschicht für Löcher/Excitonen
5. Elektronenleiterschicht
6. Kathode

Es sind auch von dem vorstehend genannten Aufbau verschiedene Schichtenfolgen möglich, die dem Fachmann bekannt sind. Beispielsweise ist es möglich, dass das OLED nicht alle der genannten Schichten aufweist, zum Beispiel ist eine OLED mit den Schichten (1) (Anode), (3) (Licht-emittierende Schicht) und (6) (Kathode) ebenfalls geeignet, wobei die Funktionen der Schichten (2) (Lochleiterschicht) und (4) (Blockschicht für Löcher/Excitonen) und (5) (Elektronenleiterschicht) durch die angrenzenden Schichten übernommen werden. OLEDs, die die Schichten (1), (2), (3) und (6) bzw. die Schichten (1), (3), (4), (5) und (6) aufweisen, sind ebenfalls geeignet. Des Weiteren können die OLEDs zwischen der Anode (1) und der Lochleiterschicht (2) eine Blockschicht für Elektronen/Excitonen aufweisen.

Es ist des Weiteren möglich, dass mehrere der vorstehend genannten Funktionen Elektronen-/Excitonenblocker, Loch-/Excitonenblocker, Loch-Injektion, Lochleitung, Elektroneninjektion, Elektronenleitung) in einer Schicht vereint sind und z. B. von einem einzigen in dieser Schicht vorliegenden Material übernommen werden. Beispielsweise kann ein in der Lochleiterschicht eingesetztes Material in einer Ausführungsform gleichzeitig Excitonen und/oder Elektronen blocken.

Des Weiteren können die einzelnen der vorstehend genannten Schichten der OLED wiederum aus 2 oder mehreren Schichten aufgebaut sein. Beispielsweise kann die Lochleiterschicht aus einer Schicht aufgebaut sein, in die aus der Elektrode Löcher injiziert werden, und einer Schicht, die die Löcher von der Loch injizierenden Schicht weg in die Licht-emittierende Schicht transportiert. Die Elektronenleitungsschicht kann ebenfalls aus mehreren Schichten bestehen, zum Beispiel einer Schicht, worin Elektronen durch die Elektrode injiziert werden, und einer Schicht, die aus der Elektronen-Injektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten organischen Verbindungen angepasst ist.

Um besonders effiziente OLEDs zu erhalten, sollte z. B. das HOMO (höchstes besetztes Molekülorbital) der Lochleiterschicht mit der Arbeitsfunktion der Anode angeglichen sein, und das LUMO (niedrigstes unbesetztes Molekülorbital) der Elektronenleiterschicht sollte mit der Arbeitsfunktion der Kathode angeglichen sei, soweit die vorstehend genannten Schichten in den erfindungsgemäßen OLEDs vorliegen.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen Ib, IVa, Va und VIa des Periodensystems der Elemente sowie die Übergangsmetalle der Gruppe VIIIa. Wenn die Anode lichtdurchlässig sein soll, werden im Allgemeinen gemischte Metalloxide der Gruppen IIb, IIIb und IVb des Periodensystems der Elemente (alte IUPAC-Version) eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können. Bevorzugt wird als Material für die Anode (1) ITO eingesetzt.

Geeignete Lochleitermaterialien für die Schicht (2) der erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus tris-[N-(1-naphthyl)-N-(phenylamino)]triphenylamin (1-NaphDATA), 4,4'-Bis[N-(1-naphthyl)-N-phenyl-amino]biphenyl (α-NPD), N,N'-Diphenyl-N,N'-bis(3-methylphenyl)-[1,1'-biphenyl]-4,4'-diamin (TPD), 1,1-Bis[(di-4-tolylamino)phenyl]-cyclohexan (TAPC), N,N'-Bis(4-methylphenyl)-N,N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-Tetrakis(4-methylphenyl)-(1,1'-biphenyl)-4,4'-diamin (TTB), 4,4',4"-tris(N,N-Diphenylamino)triphenylamin (TDTA), 4,4',4"-tri(N-carbazolyl)triphenylamine (TCTA), N,N'-Bis(naphthalen-2-yl)-N,N'-bis(phenyl)-benzidin (β-NPB), N,N'-Bis(3-methylphenyl)-N,N'-bis(phenyl)-9,9-spirobifluoren (Spiro-TPD), N,N'-Bis(naphthalen-1-yl)-N,N'-bis(phenyl)-9,9-spirobifluoren (Spiro-NPB), N,N'-Bis(3-methylphenyl)-N,N'-bis(phenyl)-9,9-dimethylfluoren (DMFL-TPD), N,N'-Bis(3-methylphenyl)-N,N'-bis(phenyl)-9,9-diphenylfluoren (DPFL-TPD), N,N'-Bis(naphthalen-1-yl)-N,N'-bis(phenyl)-9,9-diphenylfluoren (DPFL-NPB), 2,2',7,7'-Tetrakis(N,N-diephenylamino)-9,9'-spirobifluoren (Spiro-TAD), 9,9-Bis[4-N,N-bis-biphenyl-4-yl-amino)phenyl]-9H-fluoren (BPAPF), 9,9-Bis[4-(N,N-bis-naphthalen-2-yl-amino)phenyl]-9H-fluoren (NPAPF), 9,9-Bis[4-(N,N-bis-naphthalen-2-yl-N,N'-bis-phenyl-amino)phenyl]-9H-fluoren (NPBAPF), 2,2',7,7'-Tetrakis[N-naphthalenyl(phenyl)-amino]-9,9'-spirobifluoren (Spiro-2NPB), N,N'-bis(phenanthren-9-yl)-N,N'-bis(phenyl)-benzidin (PAPB), 2,7-Bis[N,N-bis(9,9-spiro-bifluoren-2-yl)-amino]-9,9-spirobifluoren (Spiro-5), 2,2'-Bis[N,N-bis(biphenyl-4-yl)amino]-9,9-spirobifluoren (2,2'-Spiro-DBP), 2,2'-Bis(N,N-di-phenyl-amino)-9.9-spirobifluoren (Spiro-BPA), 2,2',7,7'-tetra(N,N-di-Tolyl)amino-Spiro-bifluoren (Spiro-TTB), N,N,N',N'-tetra-naphthalen-2-yl-benzidin (TNB), Porphyrinverbindungen und Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen und Polyanilinen. Es ist ebenfalls möglich, Löcher transportierende Polymere durch Dotieren Löcher transportierender Moleküle in Polymeren wie Polystyrol und Polycarbonat zu erhalten. Ein Beispiel dafür ist mit Polystyrolsulfonat dotiertes Poly(3,4-ethylendioxythiophen) (PEDOT:PSS). Geeignete Löcher transportierende Moleküle sind die bereits vorstehend genannten Moleküle.

Weiterhin können - in einer Ausführungsform - Carben-Komplexe als Lochleitermaterialien eingesetzt werden, wobei die Bandlücke des mindestens einen Lochleitermaterials im Allgemeinen größer ist als die Bandlücke des eingesetzten Emittermaterials. Dabei ist unter Bandlücke im Sinne der vorliegenden Anmeldung die Triplett-Energie zu verstehen. Geeignete Carben-Komplexe sind z. B. Carben-Komplexe, wie sie in WO 2005/019373 A2, WO 2006/056418 A2, WO 2005/113704, WO 2007/115970, WO 2007/115981 und WO 2008/000727 beschrieben sind. Ein Beispiel für einen geeigneten Carbenkomplex ist Ir(dpbic)₃ mit der Formel: 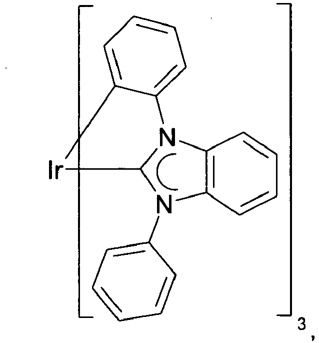 der z. B. in WO2005/019373 offenbart ist.

Die Licht-emittierende Schicht (3) enthält mindestens ein Emittermaterial. Dabei kann es sich grundsätzlich um einen Fluoreszenz oder Phosphoreszenzemitter handeln, wobei geeignete Emittermaterialien dem Fachmann bekannt sind. Bevorzugt handelt es sich bei dem mindestens einen Emittermaterial um einen Phosphoreszenzemitter. Die bevorzugt eingesetzten Phosphoreszenzmitter-Verbindungen basieren auf Metallkomplexen, wobei insbesondere die Komplexe der Metalle Ru, Rh, Ir, Pd und Pt, vor allem die Komplexe des Ir Bedeutung erlangt haben. Die Verbindungen der Formel (I) bzw. (Ib) können - neben der Verwendung in der Blockschicht für Löcher/Excitonen - als Matrix in der Licht-emittierenden Schicht eingesetzt werden

Geeignete Metallkomplexe zur Verwendung in den erfindungsgemäßen OLEDs sind z. B. in den Schriften WO 02/60910 A1, US 2001/0015432 A1, US 2001/0019782 A1, US 2002/0055014 A1, US 2002/0024293 A1, US 2002/0048689 A1, EP 1 191 612 A2, EP 1 191 613 A2, EP 1 211 257 A2, US 2002/0094453 A1, WO 02/02714 A2, WO 00/70655 A2, WO 01/41512 A1, WO 02/15645 A1, WO 2005/019373 A2, WO 2005/113704 A2, WO 2006/115301 A1, WO 2006/067074 A1, WO 2006/056418, WO 2006121811 A1, WO 2007095118 A2, WO 2007/115970, WO 2007/115981 und WO 2008/000727 beschrieben.

Weitere geeignete Metallkomplexe sind die kommerziell erhältlichen Metallkomplexe Tris(2-phenylpyridin)iridium(III), Iridium(III)tris(2-(4-tolyl)pyridinato-N,C^{2'}), Iridium(III)tris(1-phenylisochinolin), Iridium(III)bis(2-2'-benzo-thienyl)pyridinato-N,C^{3'})(acetylacetonat), Iridium(III)bis(2-(4,6-difluorophenyl)pyridinato-N,C²)picolinat, Iridium(III)bis(1-phenylisochinolin)(acetylacetaonat), Iridium(III)bis(dibenzo[f,h]chinoxalin)(acetylacetaonat), Iridium(III)bis(2-methyldi-benzo[f,h]chinoxalin)-(acetylacetonat) und Tris(3-methyl-1-phenyl-4-trimethyl-acetyl-5-pyrazolin)terbium(III).

Des Weiteren sind die folgenden kommerziell erhältlichen Materialien geeignet: Tris(dibenzoylacetonato)-mono(phenanthrolin)-europium(III), Tris(dibenzoylmethan)-mono(phenanthrolin)europium(III), Tris(dibenzoylmethan)-mono(5-aminophenan-throlin)europium(III), Tris(di-2-naphthoylmethan)-mono(phenanthrolin)-europium(III), Tris(4-bromobenzoylmethan)-mono(phenanthrolin)-europium(III), Tris(di-biphenyl-methan)-mono(phenanthrolin)-europium(III), Tris(dibenzoylmethan)-mono(4,7-diphenyl-phenanthrolin)-europium(III), Tris(dibenzoylmethan)-mono(4,7-di-methylphenanthrolin)-europium(III), Tris(dibenzoylmethan)-mono(4,7-dimethyl-phenanthrolin-disulfonsäure)-europium(III)-dinatriumsalz, Tris[di(4-(2-(2-ethoxy-ethoxy)ethoxy)benzoylmethan)]-mono(phenanthrolin)-europium(III) und Tris[di[4-(2-(2-ethoxyethoxy)ethoxy)benzoyl-methan)]mono-(5-aminophenanthrolin)-europium(III).

Geeignete Triplett-Emitter sind z. B. Carbenkomplexe. In einer Ausführungsform der vorliegenden Erfindung werden die Verbindungen der Formel (I) bzw. (Ib) in der Licht-emittierenden Schicht als Matrixmaterial gemeinsam mit Carbenkomplexen als Triplett-Emitter eingesetzt. Geeignete Carbenkomplexe sind dem Fachmann bekannt und z. B. in WO 2005/019373 A2, WO 2006/056418 A2, WO 2005/113704, WO 2007/115970, WO 2007/115981 und WO 2008/000727 beschrieben.

Die Licht-emittierende Schicht kann neben dem Emittermaterial weitere Komponenten enthalten. Beispielsweise kann in der Licht-emittierenden Schicht ein fluoreszierender Farbstoff anwesend sein, um die Emissionsfarbe des Emittermaterials zu verändern. Des Weiteren kann - in einer bevorzugten Ausführungsform - ein Matrixmaterial eingesetzt werden. Dieses Matrixmaterial kann ein Polymer sein, zum Beispiel Poly(N-vnylcarbazol) oder Polysilan. Das Matrixmaterial kann jedoch ebenfalls ein kleines Molekül sein, zum Beispiel 4,4'-N,N'-Dicarbazolbiphenyl (CDP=CBP) oder tertiäre aromatische Amine wie z. B. TCTA. In einer bevorzugten Ausführungsform der vorliegenden Erfindung wird mindestens eine Verbindung der Formel (I) bzw. (Ib) als Matrixmaterial eingesetzt.

In einer bevorzugten Ausführungsform ist die Licht-emittierende Schicht aus 2 bis 20 Gew.-%, bevorzugt 5 bis 17 Gew.-% mindstens eines der vorstehend genannten Emittermaterialien und 80 bis 98 Gew.-%, bevorzugt 83 bis 95 Gew.-% mindestens eines der vorstehend genannten Matrixmaterialien - in einer Ausführungsform mindestens einer Verbindung der Formel (Ib) - aufgebaut, wobei die Gesamtsumme des Emittermaterials und des Matrixmaterials 100 Gew.-% ergibt.

In einer weiteren Ausführungsform werden die Verbindungen der Formel (Ib) als Loch/Excitonen-Bockermaterial gemeinsam mit Carbenkomplexen als Triplett-Emitter eingesetzt. Die Verbindungen der Formel (Ib) können des Weiteren - wie vorstehend erwähnt - sowohl als Matrixmaterialien als auch als Loch/Excitonenblockermaterialien gemeinsam mit Carbenkomplexen als Triplett-Emitter eingesetzt werden.

Geeignete Metallkomplexe zur Verwendung zusammen mit den Verbindungen der Formel (b) als Matrixmaterialien und/oder Loch/Excitonen-Blockermaterialien in OLEDs sind somit z. B. auch Carben-Komplexe, wie sie in WO 2005/019373 A2, WO 2006/056418 A2, WO 2005/113704, WO 2007/115970, WO 2007/115981 und WO 2008/000727 beschrieben sind. Auf die Offenbarung der genannten WO-Anmeldungen wird hierbei explizit Bezug genommen und diese Offenbarungen sollen in den Inhalt der vorliegenden Anmeldung als mit einbezogen gelten.

Falls die Blockschicht für Löcher/Excitonen (4) keine Silolverbindungen der Formel (I) bzw. (Ib) enthält, weist die OLED - falls eine Blockschicht für Löcher vorliegt - üblicherweise in OLEDs eingesetzte Lochblockermaterialien auf wie 2,6-Bis(N-carbazolyl)pyridine (mCPy), 2,9-Dimethyl-4,7-diphenyl-1,10-phenanthrolin (Bathocuproin, (BCP)), Bis-(2-methyl-8-chinolinato)-4-phenyl-phenylato)-aluminium(III) (BAlq), Phenothiazin-*S*,*S*-dioxidderivate und 1,3,5-tris(N-Phenyl-2-benzylimidazol)-benzol) (TPBI), wobei TPBI auch als Elektronen-leitendes Material geeignet ist. In einer weiteren Ausführungsform können Verbindungen, die aromatische oder heteroaromatische über Carbonyl-Gruppen enthaltende Gruppen verbundene Ringe enthalten, wie sie in WO2006/100298 offenbart sind, Disilylverbindungen, ausgewählt aus der Gruppe bestehend aus Disilylcarbazolen, Disilylbenzofuranen, Disilylbenzothiophenen, Disilylbenzophospholen, Disilylbenzothiophen-S-oxiden und Disilylbenzothiophen-S,S-dioxiden wie sie z. B. in den nicht vorveröffentlichten PCT-Anmeldungen mit den Aktenzeichen PCT/EP2008/058207 und PCT/EP2008/058106 genannt sind sowie Disilylverbindungen wie sie in WO2008/034758 offenbart sind als Blockschicht für Löcher/Excitonen (4) oder als Matrixmaterialien in der Licht-emittierenden Schicht (3) eingesetzt werden.

In einer bevorzugten Ausführungsform betrifft die vorliegende Erfindung eine erfindungsgemäße OLED umfassend die Schichten (1) Anode, (2) Lochleiterschicht, (3) Licht-emittierende Schicht, (4) Blockschicht für Löcher/Excitonen, (5) Elektronenleiterschicht und (6) Kathode, sowie gegebenenfalls weitere Schichten, wobei die Blockschicht für Löcher/Excitonen oder die Licht-emittierende Schicht mindestens eine Verbindung der Formel (Ib) enthält.

In einer weiteren bevorzugten Ausführungsform betrifft die vorliegende Erfindung eine erfindungsgemäße OLED umfassend die Schichten (1) Anode, (2) Lochleiterschicht, (3) Licht-emittierende Schicht, (4) Blockschicht für Löcher/Excitonen, (5) Elektronenleiterschicht und (6) Kathode, sowie gegebenenfalls weitere Schichten, wobei die Licht-emittierende Schicht (3) mindestens eine Verbindung der Formel (Ib) und die Blockschicht für Löcher/Excitonen mindestens eine Verbindung der Formel (Ib) enthält.

Geeignete Elektronenleitermaterialien für die Schicht (5) der erfindungsgemäßen OLEDs umfassen mit oxinoiden Verbindungen chelatisierte Metalle wie 2,2', 2"-(1,3,5-phenylen)tris-[1-phenyl-1H-benzimidazol] (TPBI), Tris(8-chinolinolato)aluminium (Alq₃), Verbindungen auf Phenanthrolinbasis wie 2,9-Dimethyl-4,7-diphenyl-1,10-phenanthrolin (DDPA = BCP) oder 4,7-Diphenyl-1,10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ), 8-Hydroxyquinolinolatolithium (Liq), 4,7-Diphenyl-1,10-phenanthrolin (BPhen), Bis-(2-methyl-8-quinolinolat)-4-(phenylphenolato)aluminium (BAlq), 1,3-Bis[2-(2,2'-bipyridin-6-yl)-1,3,4-oxadiazo-5-yl]benzen (Bpy-OXD), 6,6'-Bis[5-(biphenyl-4-yl)-1,3,4-oxadiazo-2-yl]-2,2'-bipyridyl (BP-OXD-Bpy), 4-(Naphthalen-1-yl)-3,5-diphenyl-4H-1,2,4-triazol (NTAZ), 2,9-Bis(naphthalen-2-yl)-4,7-diphenyl-1,10-phenanthrolin (NBphen), 2,7,-Bis[2-(2,2'-bipyridin-6-yl)-1,3,4-oxadiazo-5-yl]-9,9-dimethylfluoren (Bby-FOXD), 1,3-Bis[2-(4-tert-butylphenyl)-1,3,4-oxadiazo-5-yl]benzen (OXD-7), Tris(2,4,6-trimethyl-3-(pyridin-3-yl)phenyl)boran (3TPYMB), 1-methyl-2-(4-(naphthalen-2-yl)phenyl)-1H-imidazo[4,5-f][1,10]phenanthrolin (2-NPIP), 2-phenyl-9,10,-di(naphthalen-2-yl)-anthracen (PADN), 2-(naphthalen-2-yl)-4,7-diphenyl-1,10,phenanthrolin (HNBphen). Dabei kann die Schicht (5) sowohl zur Erleichterung des Elektronentransports dienen als auch als Pufferschicht oder als Sperrschicht, um ein Quenchen des Excitons an den Grenzflächen der Schichten der OLED zu vermeiden. Vorzugsweise verbessert die Schicht (5) die Beweglichkeit der Elektronen und reduziert ein Quenchen des Excitons. In einer bevorzugten Ausführungsform wird TPBI als Elektronenleitermaterial eingesetzt.

Von den vorstehend als Lochleitermaterialien und Elektronenleitermaterialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen. Diese können z. B. in der Blockschicht für Löcher/Excitonen (4) eingesetzt werden. Es ist jedoch ebenfalls möglich, dass die Funktion als Loch/Excitonenblocker von der Schicht (5) mit übernommen wird, so dass die Schicht (4) entfallen kann.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochleitermaterialien mit Elektronenakzeptoren dotiert werden, zum Beispiel können Phthalocyanine bzw. Arylamine wie TPD oder TDTA mit Tetrafluortetracyanchinodimethan (F4-TCNQ) oder mit MoO₃ oder WO₃ dotiert werden. Die Elektronenleitermaterialien können zum Beispiel mit Alkalimetallen dotiert werden, beispielsweise Alq₃ mit Lithium. Außerdem können Elektronenleiter mit Salzen wie Cs₂CO₃ dotiert werden. Die elektronische Dotierung ist dem Fachmann bekannt und zum Beispiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo. Appl. Phys. Lett., Vol. 82, No. 25, 23 June 2003 und Pfeiffer et al., Organic Electronics 2003, 4, 89 - 103 offenbart. Zum Beispiel kann die Lochleiterschicht einen neben einem Carbenkomplex, z. B. Ir(dpbic)₃, mit MoO₃ oder WO₃ dotiert werden.

Die Kathode (6) ist eine Elektrode, die zur Einführung von Elektronen oder negativen Ladungsträgern dient. Geeignete Materialien für die Kathode sind ausgewählt aus der Gruppe bestehend aus Alkalimetallen der Gruppe Ia, zum Beispiel Li, Cs, Erdalkalimetallen der Gruppe IIa, zum Beispiel Calcium, Barium oder Magnesium, Metallen der Gruppe IIb des Periodensystems der Elemente (alte IUPAC-Version), umfassend die Lanthaniden und Aktiniden, zum Beispiel Samarium. Des Weiteren können auch Metalle wie Aluminium oder Indium, sowie Kombinationen aller genannten Metalle eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Die OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält die erfindungsgemäß OLED zusätzlich zu den Schichten (1) bis (6) mindestens eine der im Folgenden genannten weiteren Schichten:
- eine Loch-Injektionsschicht zwischen der Anode (1) und der Löcher-transportierenden Schicht (2);
- eine Blockschicht für Elektronen zwischen der Löcher-transportierenden Schicht (2) und der Licht-emittierenden Schicht (3);
- eine Elektronen-Injektionsschicht zwischen der Elektronen-transportierenden Schicht (5) und der Kathode (6).

Materialien für eine Lochinjektionsschicht können ausgewählt sein aus Kupferphthalocyanin, 4,4',4"-Tris(N-3-methylphenyl-N-phenyl-amino)triphenylamin (m-MTDATA), 4,4',4"-Tris(N-(2-naphthyl)-N-phenyl-amino)triphenylamin (2T-NATA), 4,4',4"-Tris(N-(1naphthyl)-N-phenyl-amino)triphenylamin (1T-NATA), 4,4',4"-Tris(N,N-diphenyl-amino)triphenylamin (NATA), Titanoxidphtalocyanin, 2,3,5,6-Tetrafluoro-7,7,8,8-tetracyano-quinodimethan (F4-TCNQ), Pyrazino[2,3-f][1,10]phenanthrolin-2,3-dicarbonitril (PPDN), N,N,N',N'-Tetrakis(4-methoxyphenyl)benzidin (MeO-TPD), 2,7-Bis[N,N-bis(4-methoxy-phenyl)amino]-9,9-spirobifluoren (MeO-Spiro-TPD), 2,2'-Bis[N,N-bis(4-methoxy-phenyl)amino]-9,9-spirobifluoren (2,2'-MeO-Spiro-TPD), N,N'-di-phenyl-N,N'-di-[4-(N,N-di-tolyl-amino) phenyl]benzidin (NTNPB), N,N'-di-phenyl-N,N'-di-[4-(N,N-di-phenyl-amino) phenyl]benzidin (NPNPB), N,N'-di(naphthalen-2-yl)-N,N'-diephenylbenzen-1,4-diamin (β-NPP).

Als Material für die Elektroneninjektionsschicht kann beispielsweise LiF, Cs₂CO₃ oder Li₃PO₄ gewählt werden.

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z. B. in WO 00/70655 offenbart.

Des Weiteren ist es möglich, dass einige der in der erfindungsgemäßen OLED eingesetzten Schichten oberflächenbehandelt sind, um die Effizienz des Ladungsträgertransports zu erhöhen. Die Auswahl der Materialien für jede der genannten Schichten ist bevorzugt dadurch bestimmt, eine OLED mit einer hohen Effizienz und Lebensdauer zu erhalten.

Die Herstellung der erfindungsgemäßen OLED kann nach dem Fachmann bekannten Methoden erfolgen. Im Allgemeinen wird die erfindungsgemäße OLED durch aufeinander folgende Dampfabscheidung (Vapor deposition) der einzelnen Schichten auf ein geeignetes Substrat hergestellt. Geeignete Substrate sind zum Beispiel Glas, anorganische Halbleiter oder Polymerfilme. Zur Dampfabscheidung können übliche Techniken eingesetzt werden wie thermische Verdampfung, Chemical Vapor Deposition (CVD), Physical Vapor Deposition (PVD) und andere. In einem alternativen Verfahren können die organischen Schichten der OLED aus Lösungen oder Dispersionen in geeigneten Lösungsmitteln aufgetragen werden, wobei dem Fachmann bekannte Beschichtungstechniken angewendet werden.

Im Allgemeinen haben die verschiedenen Schichten folgende Dicken: Anode (1) 50 bis 500 nm, bevorzugt 100 bis 200 nm; Löcher-leitende Schicht (2) 5 bis 100 nm, bevorzugt 20 bis 80 nm, Licht-emittierende Schicht (3) 1 bis 100 nm, bevorzugt 10 bis 80 nm, Blockschicht für Löcher/Excitonen (4) 2 bis 100 nm, bevorzugt 5 bis 50 nm, Elektronen-leitende Schicht (5) 5 bis 100 nm, bevorzugt 20 bis 80 nm, Kathode (6) 20 bis 1000 nm, bevorzugt 30 bis 500 nm. Die relative Lage der Rekombinationszone von Löchern und Elektronen in den erfindungsgemäßen OLED in Bezug zur Kathode und somit das Emissionsspektrum der OLED können u. a. durch die relative Dicke jeder Schicht beeinflusst werden. Das bedeutet, die Dicke der Elektronentransportschicht sollte bevorzugt so gewählt werden, dass die Lage der Rekombinationszone auf die optische Resonatoreigenschaft der Diode und damit auf die Emissionswellenlänge des Emitters abgestimmt ist. Das Verhältnis der Schichtdicken der einzelnen Schichten in der OLED ist von den eingesetzten Materialien abhängig. Die Schichtdicken von gegebenenfalls eingesetzten zusätzlichen Schichten sind dem Fachmann bekannt. Es ist möglich, dass die Elektronen-leitende Schicht und/oder die Löcher leitende Schicht größere Dicken als die angegebenen Schichtdicken aufweisen, wenn sie elektrisch dotiert sind.

Durch Einsatz der Silolverbindungen der Formel (Ib) als in der Licht-emittierenden Schicht und/oder der Blockschicht für Löcher/Excitonen können OLEDs mit hoher Effizienz und Lebensdauer erhalten werden. Die Effizienz der OLEDs kann des Weiteren durch Optimierung der anderen Schichten der OLEDs verbessert werden. Beispielsweise können hoch effiziente Kathoden wie Ca oder Ba, gegebenenfalls in Kombination mit einer Zwischenschicht aus LiF, eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die OLEDs können weiterhin zumindest eine zweite Licht emittierende Schicht enthalten. Die Gesamtemission der OLEDs kann sich dabei aus der Emission der zumindest zwei Licht emittierenden Schichten zusammensetzen und kann auch weißes Licht umfassen.

Ein weiterer Gegenstand der vorliegenden Erfindung ist eine Licht-emittierende Schicht enthaltend mindestens eine Silolverbindung der Formel (Ib) und mindestens ein Emittermaterial. Bevorzugte Silolverbindungen der Formel (Ib) sowie geeignete und bevorzugte Emittermaterialien und bevorzugte Mengen des Emittermaterials und der Verbindung der Formel (Ib) sind vorstehend genannt.

Ein weiterer Gegenstand der vorliegenden Erfindung ist eine OLED enthaltend eine erfindungsgemäße Licht-emittierende Schicht.

Die OLEDs können in allen Vorrichtungen eingesetzt werden, worin Elektrolumineszenz nützlich ist. Geeignete Vorrichtungen sind bevorzugt ausgewählt aus stationären und mobilen Bildschirmen und Beleuchtungseinheiten. Stationäre Bildschirme sind z. B. Bildschirme von Computern, Fernsehern, Bildschirme in Druckern, Küchengeräten sowie Reklametafeln, Beleuchtungen und Hinweistafeln. Mobile Bildschirme sind z. B. Bildschirme in Handys, Laptops, Digitalkameras, Fahrzeugen sowie Zielanzeigen an Bussen und Bahnen.

Weiterhin können die Silolverbindungen der Formel (Ib) in OLEDs mit inverser Struktur eingesetzt werden. Bevorzugt werden die erfindungsgemäß eingesetzten Verbindungen der Formel (Ib) in diesen inversen OLEDs wiederum als Loch-/Excitonenblockermaterialien eingesetzt. Der Aufbau von inversen OLEDs und die üblicherweise darin eingesetzten Materialien sind dem Fachmann bekannt.

Des Weiteren betrifft die vorliegende Erfindung eine Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen und Beleuchtungseinheiten enthaltend mindestens eine erfindungsgemäße organische Leuchtdiode oder mindestens eine erfindungsgemäße Licht-emittierende Schicht.

Die nachfolgenden Beispiele und Figuren erläutern die Erfindung zusätzlich.
Figur 1 zeigt a) die Stromspannungskurve und b) die Stromeffizienzkurve der OLED des Diodenbeispiels 3.
Figur 2 zeigt a) die Stromspannungskurve und b) die Stromeffizienzkurve der OLED des Diodenbeispiels 4.
Figur 3 zeigt a) die Stromspannungskurve und b) die Stromeffizienzkurve der OLED des Diodenbeispiels 5.
Figur 4 zeigt a) die Stromspannungskurve und b) die Stromeffizienzkurve der OLED des Diodenbeispiels 6.

### Beispiele

### A Synthesebeispiele:

### Beispiel 1: Herstellung von Silolen der Formel (1)

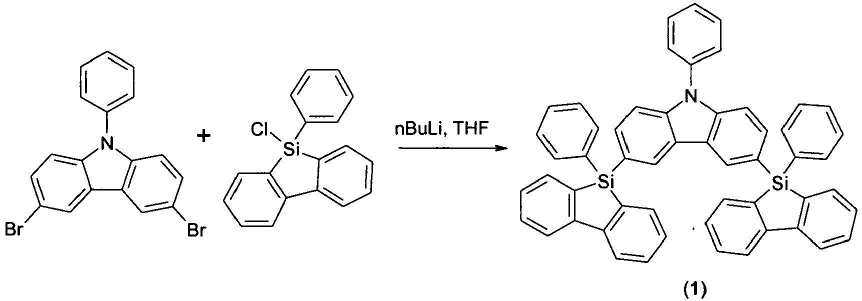

Eine Lösung von 9-Phenyl-3,6-dibrom-9H-carbazol (Tetrahedron, 1998, 54, 12707-12714) (2.1 g, 5.1 mmol) in trockenem THF (100 mL) wird bei -78 °C unter Argon langsam mit *n*-Butyllithium (1.6 M in Hexan, 8.0 mL, 12.8 mmol) versetzt und 1 h bei -78 °C gerührt. Nach Zugabe einer Lösung von 5-Chlor-5-Phenyldibenzosilol (J. Am. Chem. Soc. 1958, 80, 1883) (4.61 g, 15.4 mmol) in trockenem THF (25 mL) bei -78 °C wird die Mischung unter Rühren über Nacht auf Raumtemperatur erwärmt. Überschüssiges Butyllithium wird mit gesättigter Ammoniumchlorid-Lösung hydrolysiert. Das ausgefallene Produkt wird abfiltriert und gründlich mit CH₂Cl₂ gewaschen. Die vereinigten CH₂Cl₂-Filtrate werden mit H₂O gewaschen, mit Na₂SO₄ getrocknet und eingeengt. Der Rückstand wird in Ethanol digeriert, filtriert und getrocknet. Ausbeute (**1**): 60%. ¹H-NMR (CDCl₃, 400 MHz): *δ* = 7.32 (m, 8H), 7.42-7.52 (m, 13H), 7.63 (d, 2H), 7.68 (d, 4H), 7.82 (d, 4H), 7.90 (d, 4H), 8.38 (s, 2H).

### Beispiel 2: Herstellung von Silolen der Formel (2)

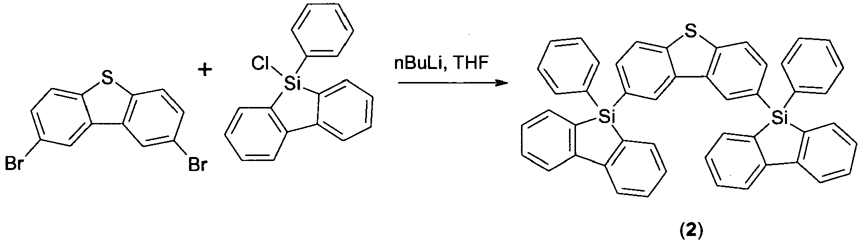

Eine Lösung von 2,8-Dibromdibenzothiophen (J. Catal. 1997, 170, 29) (1.8 g, 5.3 mmol) in trockenem THF (25 mL) wird bei -78 °C unter Argon langsam mit *n*-Butyllithium (1.6 M in Hexan, 8.4 mL, 13.4 mmol) versetzt und 1 h bei -78 °C gerührt. Nach Zugabe einer Lösung von 5-Chlor-5-Phenyldibenzosilol (J. Am. Chem. Soc. 1958, 80, 1883) (4.82 g, 16.1 mmol) in trockenem THF (20 mL) bei -78 °C wird die Mischung unter Rühren über Nacht auf Raumtemperatur erwärmt. Die Mischung wird mit MeOH und H₂O versetzt und mit CH₂Cl₂ extrahiert. Die vereinigten organischen Phasen werden mit H₂O gewaschen, mit Na₂SO₄ getrocknet und eingeengt. Der Rückstand wird in Ethanol digeriert, filtriert und getrocknet. Flash-Säulenchromatographie (SiO₂, Gradient von Cyclohexan nach Cyclohexan/CH₂Cl₂ 4:1). Ausbeute (**2**): 60%. ¹H-NMR (CDCl₃, 400 MHz): *δ* = 7.24 (m, 8H), 7.43 (t, 2H), 7.51 (dd, 4H), 7.67 (m, 6H), 7.81 (m, 6H), 7.92 (d, 4H), 8.31 (s, 2H).

### Beispiel 3: Herstellung von Silolen der Formel (3)

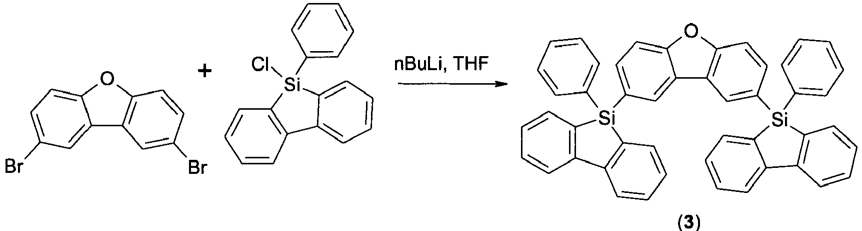

Eine Lösung von 2,8-Dibromdibenzofuran (analog J. Catal. 1997, 170, 29) (8.73 g, 26.8 mmol) in trockenem THF (500 mL) wird bei -78 °C unter Argon langsam mit *n*-Butyllithium (1.6 M in Hexan, 41.8 mL, 66.9 mmol) versetzt und 1 h bei -78 °C gerührt. Nach Zugabe einer Lösung von 5-Chlor-5-Phenyldibenzosilol (J. Am. Chem. Soc. 1958, 80, 1883) (23.7 g, 80.3 mmol) in trockenem THF (80 mL) bei -78 °C wird die Mischung unter Rühren über Nacht auf Raumtemperatur erwärmt. Die Mischung wurde mit MeOH und H₂O versetzt und mit CH₂Cl₂ extrahiert. Die vereinigten organischen Phasen werden mit H₂O gewaschen, mit Na₂SO₄ getrocknet und eingeengt. Flash-Säulenchromatographie (SiO₂, Gradient von Cyclohexan nach Cyclohexan/CH₂Cl₂ 4:1). Ausbeute (**3**): 43%. ¹H-NMR (CDCl₃, 400 MHz): *δ* = 7.33 (m, 8H), 7.42 (t, 2H), 7.50 (dd, 4H), 7.55 (d, 2H), 7.64 (d, 2H), 7.72 (d, 4H), 7.81 (d, 4H), 7.93 (d, 4H), 8.22 (s, 2H).

### Vergleichsbeispiel 4: Herstellung von Silolen der Formel (4)

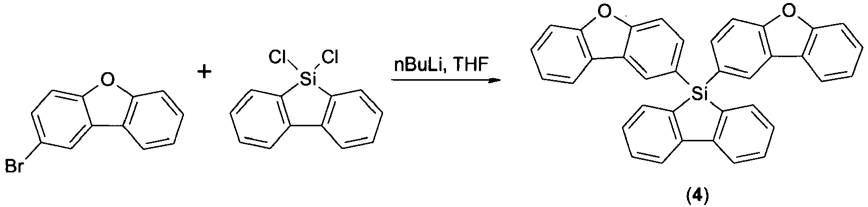

Eine Lösung von 2-Bromdibenzofuran (J. Org. Chem. 1997, 62, 1348) (1.97 g, 7.96 mmol) in trockenem THF (70 mL) wird bei -78 °C unter Argon langsam mit n-Butyllithium (1.6 M in Hexan, 5.7 mL, 9.2 mmol) versetzt und 1 h bei -78 °C gerührt. Nach Zugabe einer Lösung von 5,5-Dichlordibenzosilol (Chem. Lett. 2007, 36, 1138) (1.0 g, 4.0 mmol) in trockenem THF (10 mL) bei -78 °C wird die Mischung unter Rühren über Nacht auf Raumtemperatur erwärmt. Die Mischung wurde mit gesättigter NH₄Cl-Lösung versetzt und mit CH₂Cl₂ extrahiert. Die vereinigten organischen Phasen werden mit H₂O gewaschen, mit Na₂SO₄ getrocknet und eingeengt. Flash-Säulenchromatographie (SiO₂, Gradient von Cyclohexan nach Cyclohexan/CH₂Cl₂ 4:1). Ausbeute (**4**): 48%. ¹H-NMR (CDCl₃, 400 MHz): *δ* = 7.32 (dd, 2H), 7.38 (dd, 2H), 7.44 (dd, 2H), 7.54 (m, 4H), 7.59 (d, 2H), 7.77 (d, 2H), 7.91 (d, 4H), 7.96 (d, 2H), 8.30 (s, 2H).

Als Nebenkomponente wurde isoliert: 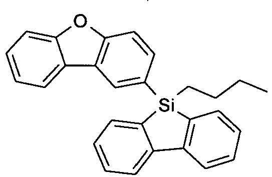 Ausbeute: 5.9%
¹H-NMR (CDCl₃, 400 MHz): *δ* = 0.82 (t, 3H), 1.38 (m, 6H), 7.32 (m, 3H), 7.45 (m, 3H), 7.56 (dd, 2H), 7.62 (d, 1H), 7.72 (d, 2H), 7.88 (d, 2H), 7.94 (d, 1H), 8.19 (s, 1H).

### B Diodenbeispiele:

### Beispiel 1: Herstellung einer OLED mit Verbindung (1) (Synthesebeispiel 1) bzw. Verbindung (2) (Synthesebeispiel 2) als Matrixmaterial

Das als Anode verwendete ITO-Substrat wird zuerst mit kommerziellen Reinigungsmitteln für die LCD-Produktion (Deconex® 20NS und Neutralisationsmittel 25ORGAN-ACID®) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert weiterhin die Lochinjektionseigenschaften des ITOs.

Danach werden die nachfolgend genannten organischen Materialien mit einer Rate von ca. 0.5-5 nm/min bei etwa 10⁻⁸ mbar auf das gereinigte Substrat aufgedampft. Als Lochleiter wird eine Mischung aus 50% Ir(dpbic)₃ und 50% MoO₃ mit einer Dicke von 35 nm auf das Substrat aufgebracht. Anschließend eine 20 nm dicke undotierte Schicht **Ir(dpbic)₃.** 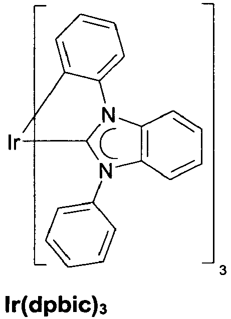 (zur Herstellung von Ir(dpbic)₃ siehe Ir-Komplex (7) in der Anmeldung WO 2005/019373).

Anschließend wird eine Mischung aus 15 Gew.-% des Emitters **Ir(ppy)₃** 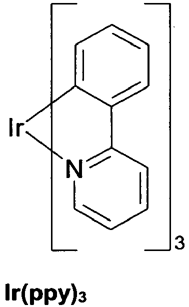 und 85 Gew.-% der Verbindung (**1**) oder der Verbindung (**2**) in einer Dicke von 20 nm aufgedampft, wobei erstere Verbindung **Ir(ppy)₃** als Emitter, eine der letzteren beiden jeweils als Matrixmaterial fungiert.

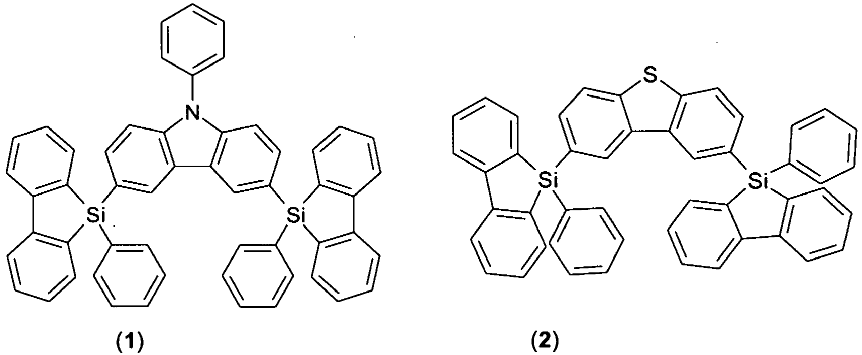

Anschließend wird das Material **mCPy** mit einer Dicke von 10 nm als Excitonen- und Lochblocker aufgedampft.

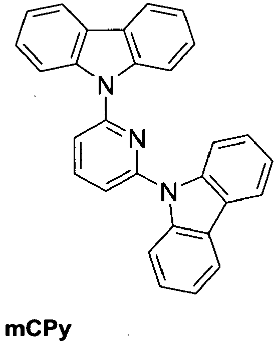

Als nächstes wird ein Elektronentransporter **Alq₃** in einer Dicke von 50 nm, eine 0,75 nm dicke Lithiumfluorid-Schicht und abschließend eine 110 nm dicke Al-Elektrode aufgedampft.

Zur Charakterisierung der OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

Für die beschriebenen OLEDs ergeben sich die folgenden elektrooptischen Daten:

**Tabelle 1**

| | Verbindung **(1)** | Verbindung **(2)** |
|---|---|---|
| Emissionsmaximum | 515 nm | 516 nm |
| CIE(x, y) | X=0,329 | X=0,325 |
| | Y=0,571 | Y=0,572 |
| Leuchtdichte bei 8 V | 480 cd/m2 | 1900 cd/m2 |

### Beispiel 2: Herstellung einer OLED mit Verbindung (1) (Synthesebeispiel 1) bzw. Verbindung (2) (Synthesebeispiel 2) bzw. Verbindung (3) (Synthesebeispiel 3) bzw. Verbindung (4) (Synthesebeispiel 4) als Blockermaterial und/oder Matrixmaterial

Das als Anode verwendete ITO-Substrat wird zuerst mit kommerziellen Reinigungsmitteln für die LCD-Produktion (Deconex® 20NS und Neutralisationsmittel 25ORGAN-ACID®) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert weiterhin die Lochinjektionseigenschaften des ITOs.

Danach werden die nachfolgend genannten organischen Materialien mit einer Rate von ca. 0.5-5 nm/min bei etwa 10⁻⁸ mbar auf das gereinigte Substrat aufgedampft. Als Lochleiter wird eine Mischung aus 50% Ir(dpbic)₃ und 50% MoO₃ mit einer Dicke von 35 nm auf das Substrat aufgebracht. Anschließend wird eine 20 nm dicke undotierte Schicht **Ir(dpbic)₃** aufgebracht. 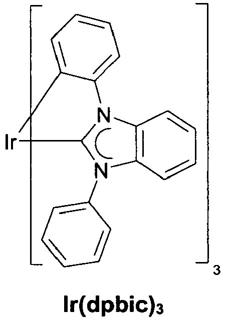 (zur Herstellung von Ir(dpbic)₃ siehe Ir-Komplex (7) in der Anmeldung WO 2005/019373).

Anschließend wird eine Mischung aus 10 Gew.-% des Emitters 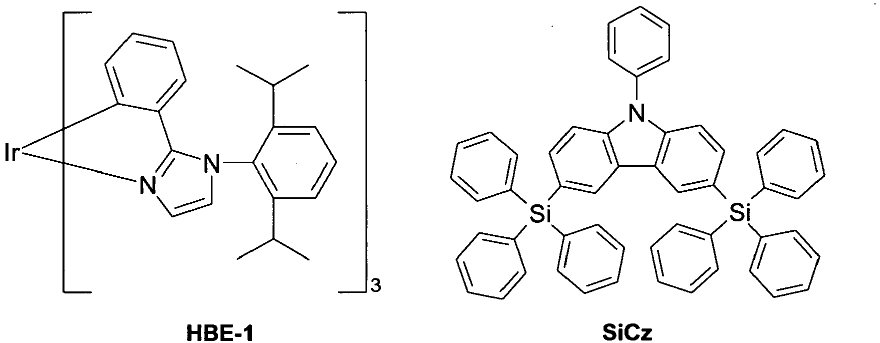 und 90 Gew.-% der Verbindung **SiCz** (Referenz) oder der Verbindung (**1**), (**2**), (**3**) oder (**4**, Vergleichsbeispiel) in einer Dicke von 20 nm aufgedampft, wobei erstere Verbindung **HBE-1** als Emitter, eine der letzteren jeweils als Matrixmaterial fungiert.

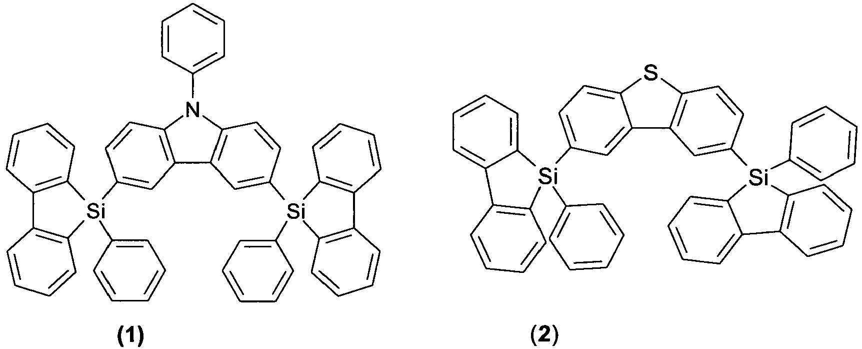

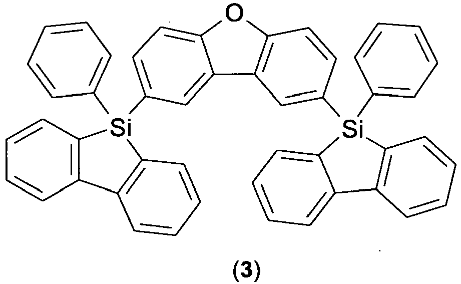

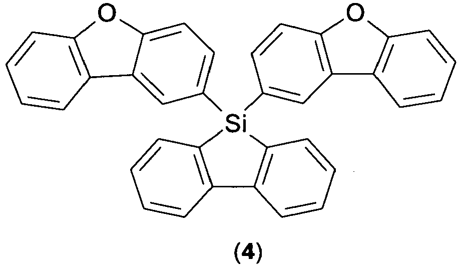

Anschließend wird das Material **mCPy** (Referenz) oder Verbindung (**3**) oder (**4**) mit einer Dicke von 10 nm als Excitonen- und Lochblocker aufgedampft.

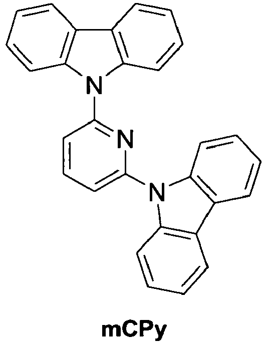

Als nächstes wird ein Elektronentransporter **Alq₃** in einer Dicke von 50 nm, eine 0,75 nm dicke Lithiumfluorid-Schicht und abschließend eine 110 nm dicke Al-Elektrode aufgedampft.

Zur Charakterisierung der OLEDs werden Elektrolumineszenz-Spektren bei verschiedenen in der nachstehenden Tabelle 2 genannten Strömen bzw. Spannungen aufgenommen. Die in Tabelle 2 genannten Daten der erfindungsgemäßen Dioden werden relativ zu den Daten der Referenzdiode (Matrix: SiCz; Loch- und Excitonenblocker: mCPy) angegeben. Die Werte der Referenzdiode werden auf 100 gesetzt.

**Tabelle 2**

| **Mat rial** | **Funktion** | **Leuchtdichte bei 8 V** | **Stromeffizienz bei 300 nits** | **Leistungs ffizi nz bei 300 nits** | **Device Aufbau (ITO 125 +/- 20nm)** (analog zur typischen Arbeitsvorschrift, Austausch von **mCPy** und/oder **SiCz** durch neues Material) |
|---|---|---|---|---|---|
| **SiCz (Referenz)** | Matrix | 100 | 100 | 100 | 50%MoO₃: **Ir(dpbic)3** (35nm)// **lr(dpbic)₃** (20nm)//10% **HBE-1: SiCz** (20nm)//**mCPy** (10nm)//**Alq₃** (50 nm)//LiF//Alu |
| **1** | Matrix | 297 | 158 | 180 | 50%MoO₃: **Ir(dpbic)3** (35nm)// **Ir(dpbic)₃** (20nm)//10% **HBE-1:(1)** (20nm)//**mCPy** (10nm)//**Alq₃** (50 nm)//LiF//Alu |
| **2** | Matrix | 670 | 161 | 209 | 50%MoO₃: **Ir(dpbic)3** (35nm)// **Ir(dpbic)₃** (20nm)//10% **HBE-1:(2)** (20nm)//**mCPy** (10nm)//**Alq₃** (50 nm)//LiF//Alu |
| **3** | Matrix | 185 | 117 | 129 | 50%MoO₃: **Ir(dpbic)3** (35nm)// **Ir(dpbic)₃** (20nm)//10% **HBE-1:(3)** (20nm)//**mCPy** (10nm)//**Alq₃** (50 nm)//LiF//Alu |
| | Matrix+Blocker | 169 | 123 | 134 | 50%MoO₃: **Ir(dpbic)3** (35nm)// **Ir(dpbic)₃** (20nm)//10% **HBE-1:(3)** (20nm)//(**3**) (10nm)//**Alq₃** (50 nm)//LiF//Alu |
| **4** (Vergleichsbeispiel) | Matrix | 337 | 156 | 185 | 50%MoO₃: **Ir(dpbic)3** (35nm)// **lr(dpbic)₃** (20nm)//10% **HBE-1:(4)** (20nm)//**mCPy** (10nm)//**Alq₃** (50 nm)//LiF//Alu |
| | Matrix + Blocker | 325 | 155 | 178 | 50%MoO₃: **Ir(dpbic)3** (35nm)// **lr(dpbic)₃** (20nm)//10% **HBE-1:(4)** (20nm)//**(4)** (10nm)//**Alq₃** (50 nm)//LiF//Alu |

### Beispiel 3: OLED mit Verbindung (2) als Matrixmaterial für einen grünen phosphoreszenten Emitter

Es wird eine OLED bereitgestellt, die auf einer ITO-Anode eine 20 nm dicke Lochinjektionsschicht, eine 10 nm dicke Lochleiterschicht, eine 10 nm dicke Rotlicht emittierende Schicht, 5 nm dicke Grünlicht emittierende Schicht, eine 3 nm dicke Blockschicht für Löcher und Excitonen, eine 30 nm dicke Elektronenleiterschicht, eine 20 nm dicke Elektroneninjektionsschicht und eine 200 nm dicke Aluminium-Kathode aufweist.

Die Lochinjektionsschicht weist beispielsweise 10 Gew% Molybdäntrioxid und 90 Gew% NPB (N,N'-Bis(naphthalen-1-yl)-N,N'-bis(phenyl)-benzidin)) auf. Die Lochleiterschicht enthält in diesem Ausführungsbeispiel NPB. Die Rotlicht emittierende Schicht weist beispielsweise 70Gew% NPB, 20 Gew% TPBi (2,2',2"-(1,3,5-Benzintriyl)-tris(1-phenyl)-1-H-Benzimidazol) und 10 Gew% Iridium(III)bis(2-methyldibenzo-[f,h]quinoxalin)(acetylacetonat) (Verbindung 5) auf.

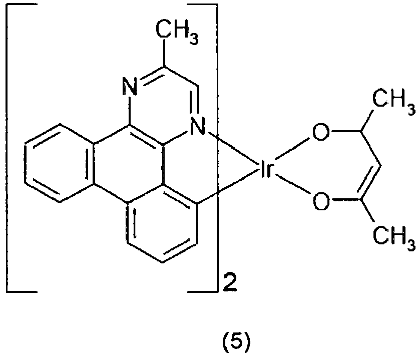

Die Grünlicht emittierende Schicht weist als Matrix die Verbindung (2) und als phosphoreszenten, grünen Emitter 10 Gew% Ir(ppy)₃ auf.

Die Blockschicht enthält ein Material der Verbindung (6):

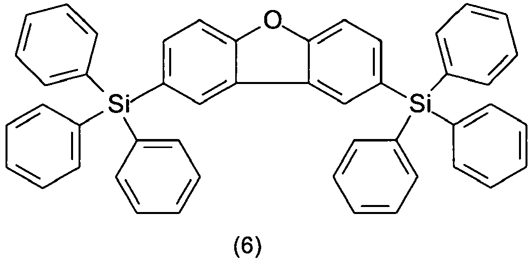

Die Elektronenleiterschicht enthält TPBi und die Elektroneninjektionsschicht enthält 50 Gew% BCP (2,9-Dimethyl-4,7-diphenyl-1,10-phenanthronlin) und 50 Gew% Cäsiumcarbonat.

Die Kombination dieser Materialien für die Blockschicht, die Lochleiterschicht und dem Matrixmaterial der Grünlicht emittierenden Schicht kann in Verbindung mit dem phosphoreszenten, grünen Emitter hohe Quanteneffizienzwerte, hohe Leistungseffizienzwerte, geringe Spannungen und eine hohe Lebensdauer erzielen. Die hohen Quanteneffizienz- und Leistungseffizienzwerte werden auch dadurch ermöglicht, dass angrenzend an die Licht emittierende Schicht die Blockschicht angeordnet wird, die den Weitertransport von Ladungsträgern, beispielsweise Löchern, in nicht emittierende oder wenig emittierende Schichten und einen Verlust von Ladungsträgern in angrenzenden Schichten vermeidet. Weiterhin können durch die Wahl des Emitters und der Matrix in der Grünlicht emittierenden Schicht die Verhältnisse der jeweiligen Energieniveaus innerhalb der Licht emittierenden Schicht, wie beispielsweise das Triplettniveau, angepasst werden.

Durch die besondere Auswahl der Materialien findet die strahlende Rekombination von Löchern und Elektronen zumindest teilweise in der Grünlicht emittierenden Schicht statt. Das bedeutet, dass der phosphoreszente, grüne Emitter gut in die Matrix eingelagert werden kann und mit ihr eine feste Lösung bilden kann, die einen guten Energieübertrag vom Matrixmaterial auf den Emitter ermöglicht, da in der Matrix eine Aggregation von Emittermolekülen und Annihilationseffekte vermieden werden. Damit ist das Triplettniveau der Matrix für den Emitter und damit auch für langwelligeres Licht emittierende Emitter ausreichend.

Weiterhin weisen die Verbindungen (2) und (6) eine Bandlücke zwischen HOMO (Highest occupied molecular orbital) und LUMO (Lowest unoccupied molecular orbital) auf, wobei die Verbindung (6) der Blockschicht tiefere HOMO-Werte und höhere LUMO-Werte aufweist als die Verbindung (2) des Matrixmaterials in der Licht emittierenden Schicht. Die beiden Verbindungen sind sich weiterhin aufgrund ihrer ähnlichen Strukturen chemisch ähnlich. Dies führt zu einer guten Elektroneninjektion aus der Blockschicht in die Grünlicht emittierende Schicht und zu guten Blockeigenschaften gegenüber Löchern, die aus der Grünlicht emittierenden Schicht stammen. Somit ist die Verbindung (2) eine geeignete Matrix für den grünen Emitter, was auch vorteilhaft für die Herstellung von Weißlicht emittierenden OLEDs ist.

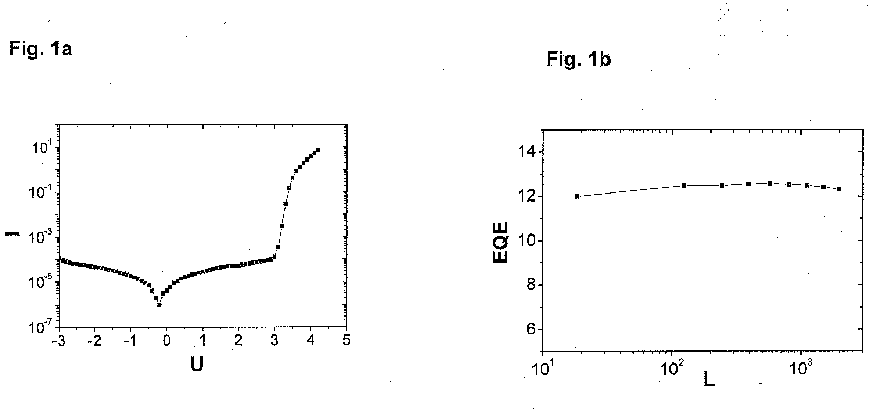

Die Figur 1a) zeigt die Stromspannungskurve einer OLED gemäß Beispiel 3, die in ihrer Grünlicht emittierenden Schicht die Kombination der Verbindungen (2) und Ir(ppy)₃ und in ihrer Blockschicht die Verbindung (6) aufweist. Aufgetragen ist der Strom I in mA/cm² gegen die Spannung U in V.

Figur 1b) zeigt die externe Quanteneffizienzkurve der oben genannten OLED, die in ihrer Licht emittierenden Schicht die Kombination der Verbindungen (2) und Ir(ppy)₃ und in ihrer Blockschicht die Verbindung (6) aufweist. Aufgetragen ist die externe Quanteneffizienz (EQE) in % gegen die Leuchtdichte L in cd/m². Zur Ermittlung der EQE wird an die OLED ein definierter Strom angelegt und ein Spektrum gemessen. Die externe Quanteneffizienz gibt an, wie viele außerhalb des Bauteils gemessene Photonen pro injiziertem Ladungsträger in der Licht emittierenden Schicht erzeugt werden. Bei einer Leuchtdichte von 1000 cd/m² kann für die oben genannte beispielhafte OLED die EQE 12,5% betragen.

Alternativ kann eine OLED mit dem oben genannten Aufbau auch eine Rotlicht emittierende Schicht und eine Grünlicht emittierende Schicht aufweisen, wobei sowohl der rote Emitter als auch der grüne Emitter in einer Matrix angeordnet sind, die ganz oder teilweise die Verbindung (2) enthält.

Analog zu der OLED des Beispiels 3 können auch andere monochrome OLEDs hergestellt werden. Beispielsweise kann eine hellblaues Licht emittierende OLED mit einem hellblauen phosphoreszenten Emitter in der Licht emittierenden Schicht bereitgestellt werden.

### Beispiel 4: Weißes Licht emittierende OLED mit Verbindung (2) als Material in der Blockschicht

Es kann eine Weißlicht emittierende OLED hergestellt werden, die auf einer ITO-Anode eine 20 nm dicke Lochinjektionsschicht, eine 10 nm dicke Lochleiterschicht, eine 10 nm dicke Rotlicht emittierende Schicht, 3 nm dicke Grünlicht emittierende Schicht, eine 10 nm dicke Blaulicht emittierende Schicht, eine 3 nm dicke Blockschicht für Löcher und Excitonen, eine 10 nm dicke Elektronenleiterschicht, eine 20 nm dicke Elektroneninjektionsschicht und eine 200 nm dicke Aluminium-Kathode aufweist.

Die Lochinjektionsschicht, die Lochleiterschicht, die Rotlicht emittierende Schicht, die Elektronenleiterschicht und die Elektroneninjektionsschicht sind dabei gemäß dem Beispiel 3 ausgeformt.

Die Grünlicht emittierende Schicht enthält 10 Gew% des grünen, phosphoreszierenden Emitters Ir(ppy)₃ und 90 Gew% der Verbindung (7).

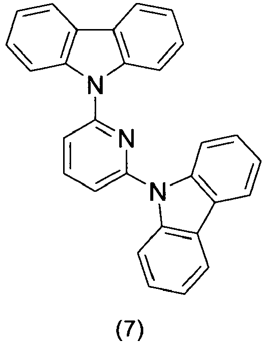

Die Blaulicht emittierende Schicht enthält die Verbindung (8) als erste Matrix, die Verbindung (7) als zweite Matrix und die Verbindung (9) als phosphoreszenten, blauen Emitter im Verhältnis 35:60:5.

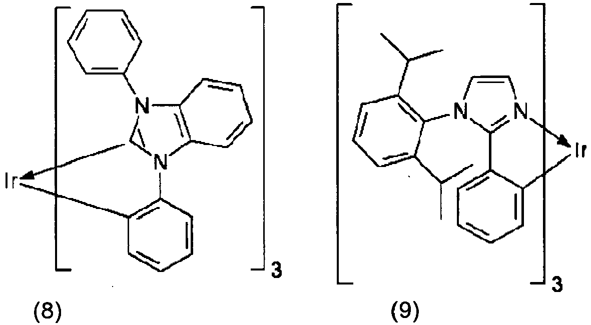

Die Blockschicht, die an die blaues Licht emittierende Schicht angrenzt, enthält das Material der Verbindung (2).

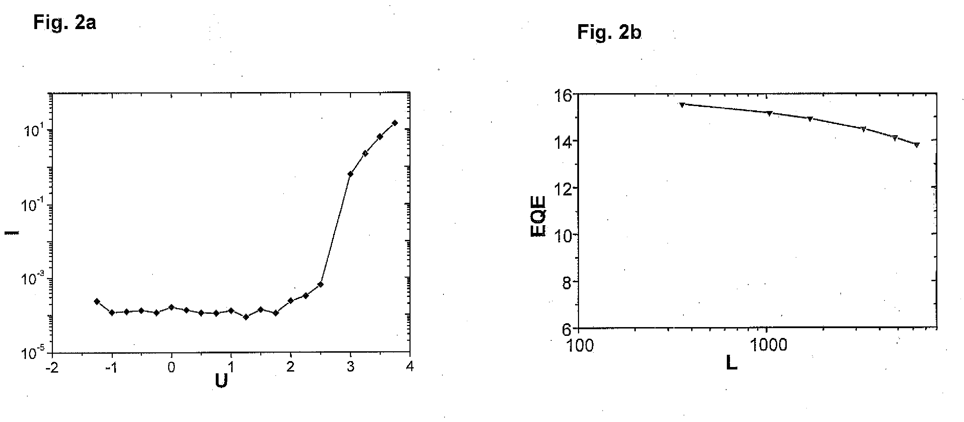

In Figur 2a ist die Stromspannungskurve und in Figur 2b die externe Quanteneffizienzkurve für diese OLED angegeben. Eine solche Weißlicht emittierende OLED mit der Verbindung (2) als Material für die Blockschicht hat eine gute Effizienz (15,2 % EQE bei 1000 cd/m²) und eine niedrige Spannung, was durch eine ausreichende Elektronentransportfähigkeit in den Schichten bedingt ist. Dies zeigt, dass die Verbindung (2) in Verbindung mit dem blauen Emitter (9) mit den Verbindungen (7) und (8) als Matrix in der Blaulicht emittierenden Schicht ein geeignetes Material für die Blockschicht ist.

### Beispiel 5: Weißlicht emittierende OLED mit Verbindung (2) als Matrix für einen grünen phosphoreszenten Emitter und den blauen phosphoreszenten Emitter

Es kann eine Weißlicht emittierende OLED hergestellt werden, die auf einer ITO-Anode eine 20 nm dicke Lochinjektionsschicht, eine 10 nm dicke Lochleiterschicht, eine 10 nm dicke Rotlicht emittierende Schicht, 5 nm dicke Grünlicht emittierende Schicht, eine 10 nm dicke blaues Licht emittierende Schicht, eine 5 nm dicke Blockschicht für Löcher und Excitonen, eine 30 nm dicke Elektronenleiterschicht, eine 20 nm dicke Elektroneninjektionsschicht und eine 200 nm dicke Aluminium-Kathode aufweist.

Die Lochinjektionsschicht, die Lochleiterschicht, die Rotlicht emittierende Schicht, die Elektronenleiterschicht und die Elektroneninjektionsschicht sind dabei beispielsweise gemäß dem Beispiel 3 ausgeformt.

Die Grünlicht emittierende Schicht enthält 10 Gew% den grünen, phosphoreszierenden Emitter Ir(ppy)₃ und 90 Gew% der Verbindung (2) als Matrix.

Die Blaulicht emittierende Schicht enthält die Verbindung (2) als Matrix und die Verbindung (9) als blauen Emitter, der mit 10 Gew% in der Schicht vorhanden ist.

Die Blockschicht weist das Material der Verbindung (6) auf.

Dieses Beispiel zeigt, dass die Verbindung (2) als Matrixmaterial für zwei aufeinanderfolgende Licht emittierende Schichten mit Emittern unterschiedlicher Farbe geeignet ist und auch damit eine weißes Licht emittierende OLED bereitgestellt werden kann, die eine gute Effizienz und Farbe (CIE bei 1000 cd/m² Leuchtdichte ist 0,45/0,44) aufweist.

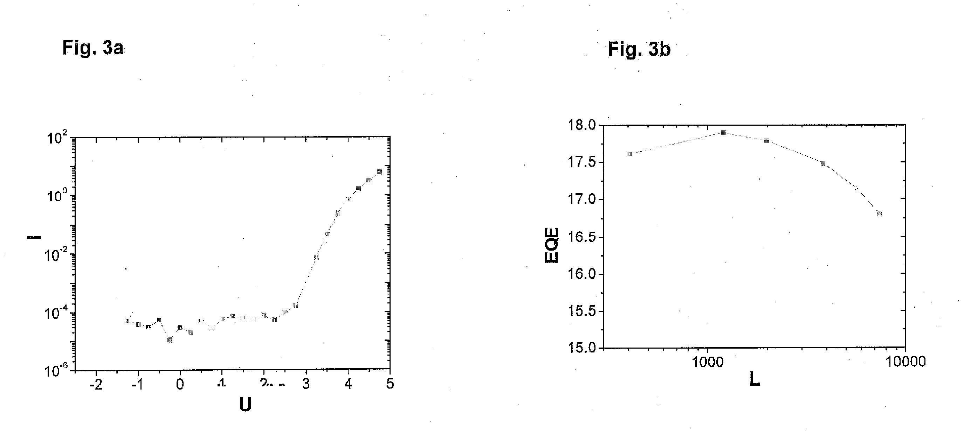

Die Figuren 3a und 3b zeigen die Stromeffizienzkurve und die externe Quanteneffizienzkurve (EQE ist 17,8 % bei 1000 cd/m²) für dieses Ausführungsbeispiel.

Alternativ kann eine OLED mit dem oben genannten Aufbau auch eine Rotlicht emittierende Schicht und eine Grünlicht emittierende Schicht aufweisen, in denen sowohl der rote Emitter als auch der grüne Emitter in einer Matrix angeordnet sind, die ganz oder teilweise die Verbindung (2) enthält. Oder die OLED kann eine Rotlicht emittierende Schicht und eine Blaulicht emittierende Schicht aufweisen, in denen sowohl der rote Emitter als auch der blaue Emitter in einer Matrix angeordnet sind, die ganz oder teilweise die Verbindung (2) enthält. Es können auch alle drei Licht emittierenden Schichten mit der Verbindung (2) als Matrix in einer OLED vorhanden sein, wobei die Verbindung (2) alleine oder in Kombination mit anderen Matrixmaterialien verwendet wird.

Beispiel 6: Weißes Licht emittierende OLED mit Verbindung (2) als Matrix für den grünen phosphoreszenten Emitter und als Matrixkomponente für den blauen phosphoreszenten Emitter

Es kann eine Weißlicht emittierende OLED hergestellt werden, die auf einer ITO-Anode eine 20 nm dicke Lochinjektionsschicht, eine 10 nm dicke Lochleiterschicht, eine 10 nm dicke Rotlicht emittierende Schicht, 3 nm dicke Grünlicht emittierende Schicht, eine 10 nm dicke blaues Licht emittierende Schicht, eine 3 nm dicke Blockschicht für Löcher und Excitonen, eine 30 nm dicke Elektronenleiterschicht, eine 20 nm dicke Elektroneninjektionsschicht und eine 200 nm dicke Aluminium-Kathode aufweist.

Die Lochinjektionsschicht, die Lochleiterschicht, die rotes Licht emittierende Schicht, die grünes Licht emittierende Schicht, die Blockschicht, die Elektronenleiterschicht und die Elektroneninjektionsschicht sind dabei beispielsweise gemäß dem Beispiel 5 ausgeformt.

Die Blaulicht emittierende Schicht enthält die Verbindung (2) als erste Matrix mit 60 Gew%, die Verbindung (8) als zweite Matrix mit 35 Gew% und die Verbindung (9) als blauen phosphoreszenten Emitter, der mit 5 Gew% in der Schicht vorhanden ist. Dieses Beispiel zeigt, dass die Verbindung (2) als Matrixmaterial für zwei aufeinanderfolgende Licht emittierende Schichten geeignet ist. Dabei liegt die Verbindung (2) in der Grünlicht emittierenden Schicht als alleiniges Matrixmaterial und in der Blaulicht emittierenden Schicht in Mischung mit einem weiteren Matrixmaterial vor. Diese OLED zeichnet sich durch hohe Effizienz und eine hohe Farbstabilität auch bei Veränderung der Stromdichte und damit Leuchtdichte (CIE 0,44/0,42 zwischen 100 und 3000 cd/m²) aus. Damit ist die Verbindung (2) als Matrix für effiziente Weißlicht emittierende OLEDs geeignet.

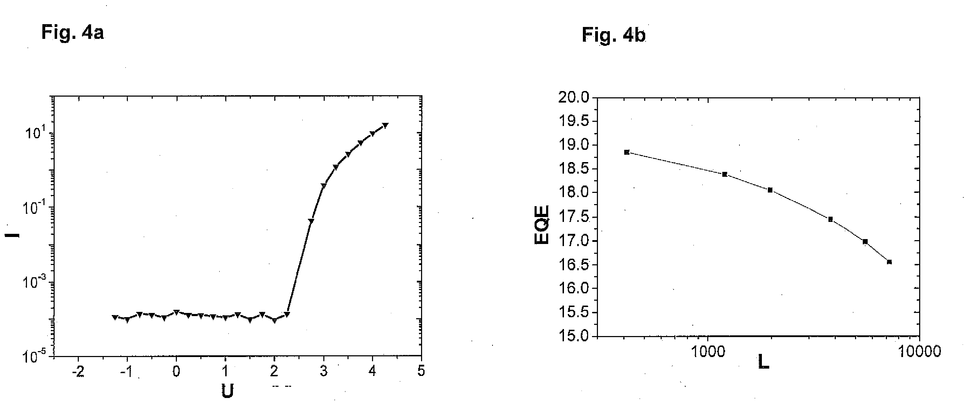

Die Figuren 4a und 4b zeigen die Stromeffizienzkurve und die externe Quanteneffizienzkurve (EQE ist 18,5 % bei 1000 cd/m²) für dieses Ausführungsbeispiel.

Alternativ kann eine OLED mit dem oben genannten Aufbau auch eine Rotlichjt emittierende Schicht und eine Grünlicht emittierende Schicht aufweisen, in denen sowohl der rote Emitter als auch der grüne Emitter in einer Matrix angeordnet sind, die ganz oder teilweise die Verbindung (2) enthält. Alternativ kann die OLED eine Rotlicht emittierende Schicht und eine Blaulicht emittierende Schicht aufweisen, in denen sowohl der rote Emitter als auch der blaue Emitter in einer Matrix angeordnet sind, die ganz oder teilweise die Verbindung (2) enthält. In einer weiteren Ausführungsform kann die OLED eine Grünlicht emittierende Schicht und eine Blaulicht emittierende Schicht aufweisen, in denen sowohl der grüne Emitter als auch der blaue Emitter in einer Matrix angeordnet sind, die ganz oder teilweise die Verbindung (2) enthält. Es können auch alle Licht emittierenden Schichten mit der Verbindung (2) als Matrix ausgeformt sein, wobei die Verbindung (2) alleine oder in Kombination mit anderen Matrixmaterialien vorhanden sein kann.

Für die oben genannten Beispiele 3 bis 6 können die Materialien für die einzelnen Schichten variiert werden.

Beispielsweise kann als phosphoreszenter grüner Emitter Tris(2-phenylpyridin)iridium(III), Tris(2-(p-tolyl)pyridin)iridium(III), Bis(2-phenylpyridin)(acetylacetonat)iridium(III) Bis(2-(p-tolyl)pyridin)(acetylacetonat)iridium(III) Bis[2-(2-hydroxyphenyl)benzothiazolato]zinc(II) Bis[1-(9,9-dimethyl-9H-fluoren-2-yl)-isoquinolin](acetylacetonat)iridium(III) Bis(2-benzo[b]thiophen-2-yl-pyridin)(acetylacetonat)iridium(III) Tris(1-phenylisoquinolin)iridium(III) Bis(1-phenylisoquinolin)(acetylacetonat)iridium (III) Tris(dibenzoylmethan)phenanthrolin europium(III) Osmium(II)bis(3-(trifluoromethyl)-5-(4-tert-butylpyridyl)-1,2,4-triazolate)diphenylmethylphosphin Osmium(II) bis(3-(trifluoromethyl)-5-(2-pyridyl)-1,2,4-triazol) dimethylphenylphosphin Osmium(II)bis(3-(trifluoromethyl)-5-(4-tert-butylpyridyl)-1,2,4-triazolat)dimethylphenylphosphin Bis(2-phenylbenzothiazolato)(acetylacetonat)iridium(III) Osmium(II) bis(3-trifluoromethyl-5-(2-pyridyl)-pyrazolat) dimethylphenylphosphin Tris(2-phenylquinolin)iridium(III) Bis(2-phenylquinolin)(acetylacetonat)iridium(III) Bis[3-(9,9-dimethyl-9H-fluoren-2-yl)-isoquinolin](acetylacetonat)iridium(III) Tris[4,4'-di-tert-buty)-(2,2')-bipyridin]ruthenium(III) Iridium (III) bis(2-(2'-benzo-thienyl)pyridinatoN,C3')(acetyl-acetonat). Tris(1-phenylisoquinolin)iridium (III) Bis(1-phenylisoquinolin)-(acetylacetonat) iridium (III) Iridium(III)bis(dibenzo[f,h]-quinoxalin)(acetylacetonat) Bis(2-(9,9-dibutylfluorenyl)-1-isoquinoline(acetylacetonat) Iridium(III)bis(2-methyldibenzo-[f,h]quinoxalin)(acetylacetonat) Bis(2-(9,9-dihexylfluorenyl)-1-pyridin)(acetylacetonate)iridium(III) Tris(3-methyl-1-phenyl-4-trimethyl-acetyl-5-pyrazolin)terbium(III) eingesetzt werden.

Weiterhin kann als Material für die Blockschicht und/oder die Lochleiterschicht N, N'-Bis(naphthalen-1-yl)-N,N'-bis(phenyl)-9,9-dimethyl-fluoren N, N'-Bis(3-methylphenyl)-N,N'-bis(phenyl)-9,9-diphenyl-fluoren N, N'-Bis(naphthalen-1-yl)-N,N'-bis(phenyl)-9,9-diphenyl-fluoren N, N'-Bis(naphthalen-1-yl)-N,N'-bis(phenyl)-2,2-dimethylbenzidin N, N'-Bis(3-methylphenyl)-N,N'-bis(phenyl)-9,9-spirobifluoren 2,2',7,7'-Tetrakis(N, N-diphenylamino)-9,9'-spirobifluoren N, N'-Bis(naphthalen-1-yl)-N,N'-bis(phenyl)-benzidin N, N'-Bis(naphthalen-2-yl)-N,N'-bis(phenyl)-benzidin N, N'-Bis(3-methylphenyl)-N,N'-bis(phenyl)-benzidin N, N'-Bis(3-methylphenyl)-N,N'-bis(phenyl)-9,9-dimethyl-fluoren N, N'-Bis(naphthalen-1-yl)-N,N'-bis(phenyl)-9,9-spirobifluoren Di-[4-(N,N-ditolyl-amino)-phenyl]cyclohexan 2,2',7,7'-tetra(N, N-di-tolyl)amino-spiro-bifluoren 9,9-Bis[4-(N,N-bis-biphenyl-4-yl-amino)phenyl]-9H-fluoren 2,2',7,7'-Tetrakis[N-naphthalenyl(phenyl)-amino]-9,9-spirobifluoren 2,7-Bis[N,N-bis(9,9-spiro-bifluorene-2-yl)-amino]-9,9-spirobifluoren 2,2'-Bis[N,N-bis(biphenyl-4-yl)amino]-9,9-spirobifluoren N, N'-bis(phenanthren-9-yl)-N,N'-bis(phenyl)-benzidin N, N,N',N'-tetra-naphthalen-2-yl-benzidin 2,2'-Bis(N,N-di-phenyl-amino)-9,9-spirobifluoren 9,9-Bis[4-(N,N-bis-naphthalen-2-yl-amino)phenyl]-9H-fluoren 9,9-Bis[4-(N, N'-bis-naphthalen-2-yl-N,N'-bis-phenyl-amino)-phenyl]-9H-fluoren Titaniumoxidphthalocyanin Kupferphthalocyanin 2,3,5,6-Tetrafluoro-7,7,8,8,-tetracyano-quinodimethan 4,4',4" -Tris(N-3-methylphenyl-N-phenyl-amino)triphenylamin (als Dotierstoff in einer Lochleiterschicht) 4,4',4"-Tris(N-(2-naphthyl)-N-phenyl-amino)triphenylamin 4,4',4"-Tris(N-(1-naphthyl)-N-phenyl-amino)triphenylamin 4,4',4" -Tris(N,N-diphenyl-amino)triphenylamin Pyrazino[2,3-f][1,10]phenanthrolin-2,3-dicarbonitril N, N,N' ,N' -Tetrakis(4-methoxyphenyl)benzidin 2,7-Bis[N,N-bis(4-methoxy-phenyl)amino]-9,9-spirobifluoren 2,2'-Bis[N,N-bis(4-methoxy-phenyl)amino]-9,9-spirobifluoren N, N'-di(naphthalen-2-yl)-N,N'-diphenylbenzol-1,4-diamin N,N'-di-phenyl-N,N'-di-[4-(N, N-di-tolyl-amino)phenyl]benzidin N,N'-di-phenyl-N,N'-di-[4-(N, N-di-phenyl-amino)phenyl]benzidin oder als Blockschicht und/oder Elektronenleiterschicht 2,2',2" -(1,3,5-Benzinetriyl)-tris(1-phenyl-1-H-benzimidazol) 2-(4-Biphenylyl)-5-(4-tert-butylphenyl)-1,3,4-oxadiazol 2,9-Dimethyl-4,7-diphenyl-1,10-phenanthrolin 8-Hydroxyquinolinolato-lithium 4-(Naphthalen-1-yl)-3,5-diphenyl-4H-1,2,4-triazol 1,3-Bis[2-(2,2'-bipyridin-6-yl)-1,3,4-oxadiazo-5-yl]benzen 4,7-Diphenyl-1,10-phenanthrolin 3-(4-Biphenylyl)-4-phenyl-5-tert-butylphenyl-1,2,4-triazol Bis(2-methyl-8-quinolinolat)-4-(phenylphenolato)aluminium 6,6'-Bis[5-(biphenyl-4-yl)-1,3,4-oxadiazo-2-yl]-2,2'-bipyridyl 2-phenyl-9,10-di(naphthalen-2-yl)-anthracen 2,7-Bis[2-(2,2'-bipyridin-6-yl)-1,3,4-oxadiazo-5-yl]-9,9-dimethylfluoren 1,3-Bis[2-(4-tert-butylphenyl)-1,3,4-oxadiazo-5-yl]benzen 2-(naphthalen-2-yl)-4,7-diphenyl-1,10-phenanthrolin 2,9-Bis(naphthalen-2-yl)-4,7-diphenyl-1,10-phenanthrolin Tris(2,4,6-trimethyl-3-(pyridin-3-yl)phenyl)boran 1-methyl-2-(4-(naphthalen-2-yl)phenyl)-1H-imidazo[4,5-f][1,10]phenanthrolin eingesetzt werden.

Weiterhin kann die OLED des Beispiels 3 für ein Bauteil, das Weißlicht emittiert, verwendet werden, indem mehrere, monochrome OLEDs, die Licht verschiedener Farben emittieren, zusammen mit der OLED des Beispiels 3 übereinander gestapelt werden und mittels "Charge generation layers" (Ladungsträgergenerationsschichten, CGLs) miteinander verbunden werden. Die CGLs können dabei die Ladungsträger einer OLED zur darüber oder darunter angeordneten OLED transportieren.

Die OLED des Beispiels 3 kann auch neben mehreren monochromen OLEDs, die Licht verschiedener Farben emittieren, angeordnet werden, um ein Weißlicht emittierendes Bauteil zu realisieren.

In den Beispielen 3 bis 6 können weiterhin als Anode und/oder Kathode Materialien verwendet werden, die ausgewählt sind aus einer Gruppe, die Cu, Au, Pt, Pd, Ph, Os, AI, Mg, Ca, Ba, Ag, Yb, Fe, Co, Ni, ITO (Indiumzinnoxid), AZO (Aluminiumdotiertes Zinkoxid) und deren Kombinationen umfasst. Zusätzlich sind Metalle der Hauptgruppen, Übergangsmetalle, Lanthanoide und Legierungen dieser Metalle, Übergangsmetalle und Lanthanoiden als Material für die Elektroden geeignet.

Desweiteren kann die OLED der Beispiele 1 bis 6 als transparente OLED ausgebildet sein. Die OLED der Beispiele 1 bis 6 kann weiterhin als eine Top emittierende oder eine Bottom emittierende OLED ausgeformt sein. Bei einer Top emittierenden OLED ist die Elektrode, die von dem Substrat weiter entfernt ist, transparent ausgeformt, so dass die Emission durch diese Elektrode erfolgt. Bei einer Bottom emittierenden OLED sind das Substrat und die auf dem Substrat angeordnete Elektrode transparent ausgeformt, so dass die Emission durch das Substrat erfolgt. Bei einer transparenten OLED ist die beidseitige Emission, durch Substrat und die von dem Substrat weiter entfernte Elektrode, die beide transparent ausgeformt sind, möglich.

## Patentansprüche

1. Verbindungen der Formel (Ib) 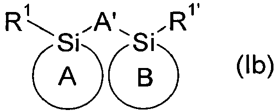 worin bedeuten:
A' ein kondensiertes Ringsystem aufgebaut aus mindestens 3, bevorzugt 3 oder 4, besonders bevorzugt 3, kondensierten Ringen, die unabhängig voneinander 4 bis 10, bevorzugt 5 bis 7, besonders bevorzugt 5 oder 6 Ringglieder aufweisen und gesättigt oder ein- oder mehrfach ungesättigt sowie unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, bevorzugt Alkyl, Heteroaryl und Gruppen mit Donor- oder Akzeptorwirkung substituiert sein können, wobei das kondensierte Ringsystem mindestens eine Heteroatom haltige Gruppe, bevorzugt ausgewählt aus O, S, N, P, SO, SO₂ und Si, besonders bevorzugt O, S und N, ganz besonders bevorzugt O und S, in dem kondensierten Ringsystem selbst oder in mindestens einem Substituenten, bevorzugt in dem kondensierten Ringsystem selbst, aufweist; 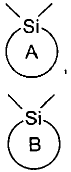 unabhängig voneinander jeweils ein Si enthaltender Ring, der 4 bis 10, bevorzugt 5 bis 7, besonders bevorzugt 5 oder 6, ganz besonders bevorzugt 5 Ringglieder aufweist, wobei der Ring gesättigt oder einoder mehrfach ungesättigt sein kann und neben dem Si-Atom ein oder mehrere weitere Heteroatom haltige Gruppen, bevorzugt ausgewählt aus O, S, SO, SO₂ und N, besonders bevorzugt O und N aufweisen kann, und unsubstituiert oder mit einem oder mehreren Substituenten ausgewählt aus Alkyl, Cycloalkyl, Heterocycloalkyl, Aryl, Hetereoaryl und Gruppen mit Donor- oder Akzeptorwirkung substituiert sein kann, wobei der Si-enthaltende Ring des Weiteren Teil eines kondensierten Ringsystems aufgebaut aus mindestens 2, bevorzugt 2 oder 3, besonders bevorzugt 3 kondensierten Ringen sein kann, wobei die weiteren Ringe - neben dem Si enthaltenden Ring - in dem kondensierten Ringsystem unabhängig voneinander gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung substituiert sein können und eine oder mehrere Heteroatom haltige Gruppen, bevorzugt ausgewählt aus O, S, SO, SO₂ und N, besonders bevorzugt S und N, aufweisen können;
R¹, R^{1'} unabhängig voneinander
- ein kondensiertes Ringsystem aufgebaut aus mindestens 3 kondensierten Ringen, die unabhängig voneinander 4 bis 10 Ringglieder aufweisen und gesättigt oder ein- oder mehrfach ungesättigt sowie substituiert oder mit einem oder mehreren Substituenten ausgewählt aus Alkyl, Cycloalkyl, Heterocycloalkyl, Aryl, Heteroaryl, SiR²R³R⁴ und Gruppen mit Donor- oder Akzeptorwirkung substituiert sein können, wobei das kondensierte Ringsystem mindestens ein Heteroatom in dem kondensierten Ringsystem selbst oder in mindestens einem Substituenten aufweist,
- Alkyl, Cycloalkyl, Heterocycloalkyl, Aryl oder Heteroaryl, bevorzugt Alkyl, Aryl oder Heteroaryl, besonders bevorzugt Alkyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl oder Dibenzofuryl, Dibenzothienyl, Carbazolyl oder Azacarbazolyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl, und Gruppen mit Donor- oder Akzeptorwirkung substituiert sein können;
R², R³, R⁴ unabhängig voneinander Alkyl, Cycloalkyl, Heterocycloalkyl, Aryl, Heteroaryl bedeuten, wobei die Reste R², R³ und R⁴ oder zwei der Reste R² , R³ und R⁴ des Weiteren gemeinsam ein kondensiertes Ringsystem aus 2 bis 6 Ringen, bevorzugt 2 bis 3 Ringen, die jeweils gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und einer Gruppe mit Donor oder Akzeptorwirkung substituiert sein können, bilden können.

2. Verwendung von Verbindungen der Formel (Ib) gemäß Anspruch 1 in organisch elektronischen Anwendungen.

3. Verwendung nach Anspruch 2, wobei die Verbindungen der Formel (Ib) als Matrixmaterial und/oder Loch-/Excitonenblockermaterial eingesetzt werden.

4. Verwendung nach einem der Ansprüche 2 bis 3, **dadurch gekennzeichnet, dass** die organisch elektronische Anwendung eine organische Leuchtdiode ist.

5. Organische Leuchtdiode enthaltend eine Anode An und eine Kathode Ka und eine zwischen der Anode An und der Kathode Ka angeordnete erste Licht-emittierende Schicht E sowie gegebenenfalls als weitere Schicht mindestens eine Blockschicht für Löcher/Excitonen, **dadurch gekennzeichnet, dass** die organische Leuchtdiode mindestens eine Verbindung der Formel (Ib) gemäß Anspruch 1 enthält, die in der Licht-emittierenden Schicht und/oder in der mindestens in der Blockschicht für Löcher/Excitonen - soweit vorhanden - vorliegt.

6. Leuchtdiode gemäß Anspruch 5, enthaltend zumindest eine zweite Licht emittierende Schicht, die zwischen der Anode An und der Kathode Ka angeordnet ist.

7. Leuchtdiode gemäß dem vorhergehenden Anspruch, wobei die zweite Licht emittierende Schicht eine Verbindung der Formel (Ib) gemäß Anspruch 1 enthält.

8. Leuchtdiode gemäß dem vorhergehenden Anspruch, die eine Gesamtemission aufweist, die sich aus der Emission der ersten Licht emittierenden Schicht E und der zweiten Licht emittierenden Schicht zusammensetzt.

9. Leuchtdiode nach dem vorhergehenden Anspruch, wobei die Gesamtemission weißes Licht umfasst.

10. Licht-emittierende Schicht enthaltend mindestens ein Emittermaterial und mindestens eine Verbindung der Formel (Ib) 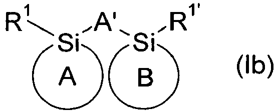 worin bedeuten:
A' ein kondensiertes Ringsystem aufgebaut aus mindestens 3, bevorzugt 3 oder 4, besonders bevorzugt 3, kondensierten Ringen, die unabhängig voneinander 4 bis 10, bevorzugt 5 bis 7, besonders bevorzugt 5 oder 6 Ringglieder aufweisen und gesättigt oder ein- oder mehrfach ungesättigt sowie unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung, bevorzugt Alkyl, Heteroaryl und Gruppen mit Donor- oder Akzeptorwirkung substituiert sein können, wobei das kondensierte Ringsystem mindestens eine Heteroatom haltige Gruppe, bevorzugt ausgewählt aus O, S, N, P, SO, SO₂ und Si, besonders bevorzugt O, S und N, ganz besonders bevorzugt O und S, in dem kondensierten Ringsystem selbst oder in mindestens einem Substituenten, bevorzugt in dem kondensierten Ringsystem selbst, aufweist; 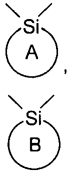 unabhängig voneinander jeweils ein Si enthaltender Ring, der 4 bis 10, bevorzugt 5 bis 7, besonders bevorzugt 5 oder 6, ganz besonders bevorzugt 5 Ringglieder aufweist, wobei der Ring gesättigt oder einoder mehrfach ungesättigt sein kann und neben dem Si-Atom ein oder mehrere weitere Heteroatom haltige Gruppen, bevorzugt ausgewählt aus O, S, SO, SO₂ und N, besonders bevorzugt O und N aufweisen kann, und unsubstituiert oder mit einem oder mehreren Substituenten ausgewählt aus Alkyl, Cycloalkyl, Heterocycloalkyl, Aryl, Hetereoaryl und Gruppen mit Donor- oder Akzeptorwirkung substituiert sein kann, wobei der Si-enthaltende Ring des Weiteren Teil eines kondensierten Ringsystems aufgebaut aus mindestens 2, bevorzugt 2 oder 3, besonders bevorzugt 3 kondensierten Ringen sein kann, wobei die weiteren Ringe - neben dem Si enthaltenden Ring - in dem kondensierten Ringsystem unabhängig voneinander gesättigt oder ein- oder mehrfach ungesättigt und unsubstituiert oder mit einem oder mehreren Substituenten ausgewählt aus Alkyl, Cycloalkyl, Heterocycloalkyl, Aryl, Heteroaryl und Gruppen mit Donor- oder Akzeptorwirkung substituiert sein können und eine oder mehrere Heteroatom haltige Gruppen, bevorzugt ausgewählt aus O, S, SO, SO₂ und N, besonders bevorzugt S und N, aufweisen können;
R¹, R^{1'} unabhängig voneinander -ein kondensiertes Ringsystem aufgebaut aus mindestens 3 kondensierten Ringen, die unabhängig voneinander 4 bis 10 Ringglieder aufweisen und gesättigt oder ein- oder mehrfach ungesättigt sowie substituiert oder mit einem oder mehreren Substituenten ausgewählt aus Alkyl, Cycloalkyl, Heterocycloalkyl, Aryl, Heteroaryl, SiR²R³R⁴ und Gruppen mit Donor- oder Akzeptorwirkung substituiert sein können, wobei das kondensierte Ringsystem mindestens ein Heteroatom in dem kondensierten Ringsystem selbst oder in mindestens einem Substituenten aufweist,
- Alkyl, Cycloalkyl, Heterocycloalkyl, Aryl oder Heteroaryl, bevorzugt Alkyl, Aryl oder Heteroaryl, besonders bevorzugt Alkyl, Phenyl, Naphthyl, Indenyl, Benzofuryl, Benzothienyl, Benzopyrrolyl, Dibenzofuryl, Dibenzothienyl, Carbazolyl, Azacarbazolyl, Phenanthrolinyl oder Fluorenyl, ganz besonders bevorzugt Methyl, Phenyl oder Dibenzofuryl, Dibenzothienyl, Carbazolyl oder Azacarbazolyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl, und Gruppen mit Donor- oder Akzeptorwirkung substituiert sein können.

11. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen enthaltend mindestens eine organische Leuchtdiode gemäß Anspruch 5 bis 9.

## Claims

1. Compounds of formula (Ib) 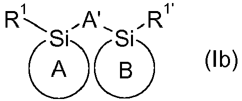 wherein:
A' is a condensed ring system composed of at least 3, preferably 3 or 4, particularly preferably 3, condensed rings which independently have 4 to 10, preferably 5 to 7, particularly preferably 5 or 6 ring members and may be saturated or monoor polyunsaturated and unsubstituted or substituted with one or more substituents selected from alkyl, cycloalkyl, heterocycloalkyl, aryl, heteroaryl and groups having donor or acceptor activity, preferably alkyl, heteroaryl and groups having donor or acceptor activity, wherein the condensed ring system has at least one heteroatomcontaining group, preferably selected from 0, S, N, P, SO, SO₂ and Si, especially preferably 0, S and N, especially preferably 0 and S, in the condensed ring system itself or in at least one substituent, preferably in the condensed ring system itself; 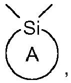 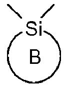 independently of one another a respective Si-containing ring which has 4 to 10, preferably 5 to 7, particularly preferably 5 or 6, particularly preferably 5 ring members, wherein the ring may be saturated or mono- or polyunsaturated and may have additionally to the Si-atom one or more further heteroatom-containing groups, preferably selected from 0, S, SO, SO₂ and N, particularly preferably 0 and N, and may be unsubstituted or substituted with one or more substituents selected from alkyl, cycloalkyl, heterocycloalkyl, aryl, hetereoaryl and groups with donor or acceptor activity, in which the Si-containing ring may further be part of a condensed ring system composed of at least 2, preferably 2 or 3, in particular preferably 3 condensed rings, the other rings - in addition to the Si-containing ring - in the condensed ring system being independently saturated or mono- or polyunsaturated and unsubstituted or substituted with one or more substituents selected from alkyl, cycloalkyl, heterocycloalkyl, aryl, heteroaryl and groups having donor or acceptor activity and may have one or more heteroatom-containing groups, preferably selected from 0, S, SO, SO₂ and N, particularly preferably S and N;
R¹, R^{1'} independently of each other - a fused ring system composed of at least 3 fused rings which independently of one another have 4 to 10 ring members and are saturated or mono- or polyunsaturated and substituted or substituted with one or more substituents selected from alkyl, cycloalkyl, heterocycloalkyl, aryl, heteroaryl, SiR²R³R⁴ and groups having donor or acceptor activity, the fused ring system having at least one heteroatom in the fused ring system itself or in at least one substituent, - alkyl, cycloalkyl, heterocycloalkyl, aryl or heteroaryl, preferably alkyl, aryl or heteroaryl, especially preferably alkyl, phenyl, naphthyl, indenyl, benzofuryl, benzothienyl, benzopyrrolyl, dibenzofuryl, dibenzothienyl, carbazolyl, azacarbazolyl, phenanthrolinyl or fluorenyl, especially preferably methyl, phenyl or dibenzofuryl, dibenzothienyl, carbazolyl or azacarbazolyl, wherein the above mentioned groups may be unsubstituted or substituted with one or more substituents selected from alkyl, cycloalkyl, heterocycloalkyl, aryl, heteroaryl, and groups having donor or acceptor activity, R², R³, R⁴ independently of each other are alkyl, cycloalkyl, heterocycloalkyl, aryl, heteroaryl, wherein the moieties R², R³, R⁴ or two of the moieties R², R³, R⁴ further may form a condensed ring system of 2 to 6 rings, preferably 2 to 3 rings, respectively being saturated or mono- or polyunsaturated and unsubstituted or substituted with one or more substituents selected from alkyl, cycloalkyl, heterocycloalkyl, aryl, heteroaryl and a group with donoer or aczeptor acitivity.

2. Use of compounds of formula (Ib) according to Claim 1 in organic electronic applications.

3. Use according to claim 2, wherein the compounds of formula (Ib) are used as matrix material and/or hole/exciton block material.

4. Use according to any of claims 2 to 3, **characterized in that** the organic electronic application is an organic light-emitting diode.

5. Organic light-emitting diode comprising an anode An and a cathode Ka and a first light-emitting layer E arranged between the anode An and the cathode Ka and optionally as a further layer at least one block layer for holes/exitons, **characterized in that** the organic light-emitting diode contains at least one compound of the formula (Ib) according to claim 1 which is present in the light-emitting layer and/or in the at least in the block layer for holes/exitons - if present.

6. Light emitting diode according to claim 5 containing at least one second light emitting layer disposed between the anode An and the cathode Ka.

7. Light emitting diode according to the preceding claim, wherein the second light emitting layer contains a compound of formula (Ib) according to claim 1.

8. Light-emitting diode according to the preceding claim, having a total emission composed of the emission of the first light emitting layer E and the second light emitting layer.

9. Light-emitting diode according to the preceding claim, the total emission comprising white light.

10. A light-emitting layer comprising at least one emitter material and at least one compound of formula (Ib) 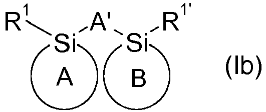 wherein:
A' is a condensed ring system composed of at least 3, preferably 3 or 4, particularly preferably 3, condensed rings which independently have 4 to 10, preferably 5 to 7, particularly preferably 5 or 6 ring members and may be saturated or monoor polyunsaturated and unsubstituted or substituted with one or more substituents selected from alkyl, cycloalkyl, heterocycloalkyl, aryl, heteroaryl and groups having donor or acceptor activity, preferably alkyl, heteroaryl and groups having donor or acceptor activity, wherein the condensed ring system has at least one heteroatomcontaining group, preferably selected from O, S, N, P, SO, SO₂ and Si, especially preferably O, S and N, especially preferably 0 and S, in the condensed ring system itself or in at least one substituent, preferably in the condensed ring system itself; 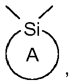 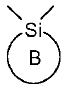 independently of one another a respective Si-containing ring which has 4 to 10, preferably 5 to 7, particularly preferably 5 or 6, particularly preferably 5 ring members, wherein the ring may be saturated or mono- or polyunsaturated and may have one or more further heteroatom-containing groups, preferably selected from O, S, SO, SO₂ and N, particularly preferably 0 and N, in addition to the Si atom, and may be unsubstituted or substituted with one or more substituents selected from alkyl, cycloalkyl, heterocycloalkyl, aryl, hetereoaryl and groups with donor or acceptor activity, in which the Si-containing ring may further be part of a condensed ring system composed of at least 2, preferably 2 or 3, in particular preferably 3 condensed rings, the other rings - in addition to the Si-containing ring - in the condensed ring system may be independently of another saturated or mono- or polyunsaturated and unsubstituted or substituted with one or more substituents selected from alkyl, cycloalkyl, heterocycloalkyl, aryl, heteroaryl and groups having donor or acceptor activity and may have one or more heteroatom-containing groups, preferably selected from 0, S, SO, SO₂ and N, particularly preferably S and N;
R¹, R^{1'} independently of each other a fused ring system composed of at least 3 fused rings which independently of one another have 4 to 10 ring members and are saturated or mono- or polyunsaturated and substituted or substituted with one or more substituents selected from alkyl, cycloalkyl, heterocycloalkyl, aryl, heteroaryl, SiR²R³R⁴ and groups having donor or acceptor activity, the fused ring system having at least one heteroatom in the fused ring system itself or in at least one substituent, - alkyl, cycloalkyl, heterocycloalkyl, aryl or heteroaryl, preferably alkyl, aryl or heteroaryl, especially preferably alkyl, phenyl, naphthyl, indenyl, benzofuryl, benzothienyl, benzopyrrolyl, dibenzofuryl, dibenzothienyl, carbazolyl, azacarbazolyl, phenanthrolinyl or fluorenyl, especially preferably methyl, phenyl or dibenzofuryl, dibenzothienyl, carbazolyl or azacarbazolyl, wherein the above mentioned groups may be unsubstituted or substituted with one or more substituents selected from alkyl, cycloalkyl, heterocycloalkyl, aryl, heteroaryl, and groups having donor or acceptor activity.

11. Device selected from the group consisting of stationary screens such as screens of computers, televisions, screens in printers, kitchen appliances and billboards, lighting, billboards and mobile screens such as screens in mobile phones, laptops, digital cameras, vehicles and destination displays on buses and trains containing at least one organic light-emitting diode according to claim 5 to 9.

## Revendications

1. Composés représentés par la formule (lb) 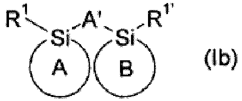 où :
A' signifie un système cyclique condensé constitué d'au moins 3, de préférence 3 ou 4, particulièrement de préférence 3, cycles condensés qui présentent indépendamment les uns des autres de 4 à 10, de préférence de 5 à 7, particulièrement de préférence 5 ou 6 chaînons et qui peuvent être saturés ou mono-insaturés ou polyinsaturés ainsi que non substitués ou substitués par un ou plusieurs substituants choisis parmi les radicaux alkyle, cycloalkyle, hétérocycloalkyle, aryle, hétéroaryle et des groupes à effet donneur ou accepteur, de préférence alkyle, hétéroaryle et groupes à effet donneur ou accepteur, le système cyclique condensé présentant dans le système cyclique condensé lui-même ou dans au moins un substituant, de préférence dans le système cyclique condensé lui-même, au moins un groupe comprenant un hétéroatome, de préférence choisi parmi O, S, N, P, SO, SO₂ et Si, particulièrement de préférence O, S et N, tout particulièrement de préférence O et S ; 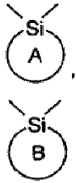 signifient indépendamment l'un de l'autre un cycle contenant respectivement un Si, ledit cycle présentant de 4 à 10, de préférence de 5 à 7, particulièrement de préférence 5 ou 6, tout particulièrement de préférence 5 chaînons, ledit cycle pouvant être saturé ou mono-insaturé ou polyinsaturé et pouvant présenter, outre l'atome Si, un ou plusieurs autres groupes contenant un hétéroatome, de préférence choisis parmi O, S, SO, SO₂ et N, particulièrement de préférence O et N, et non substitué ou substitué par un ou plusieurs substituants choisis parmi les radicaux alkyle, cycloalkyle, hétérocycloalkyle, aryle, hétéroaryle et des groupes à effet donneur ou accepteur, le cycle comprenant Si pouvant de plus faire partie d'un système cyclique condensé constitué d'au moins 2, de préférence 2 ou 3, particulièrement de préférence 3 cycles condensés, les autres cycles - outre le cycle contenant Si - pouvant être dans le système cyclique condensé, indépendamment les uns des autres, saturés ou mono-insaturés ou polyinsaturés et non substitués ou substitués par un ou plusieurs substituants choisis parmi les radicaux alkyle, cycloalkyle, hétérocycloalkyle, aryle, hétéroaryle et des groupes à effet donneur ou accepteur, et pouvant présenter un ou plusieurs groupes contenant un hétéroatome, de préférence choisis parmi O, S, SO, SO₂ et N, particulièrement de préférence S et N ;
R¹, R^{1'} signifient indépendamment l'un de l'autre
- un système cyclique condensé constitué d'au moins trois cycles condensés qui présentent indépendamment les uns des autres de 4 à 10 chaînons et qui peuvent être saturés ou monoinsaturés ou polyinsaturés ainsi que substitués ou substitués par un ou plusieurs substituants choisis parmi les radicaux alkyle, cycloalkyle, hétérocycloalkyle, aryle, hétéroaryle, SiR²R³R⁴ et des groupes à effet donneur ou accepteur, le système cyclique condensé présentant au moins un hétéroatome dans le système cyclique condensé lui-même ou dans au moins un substituant,
- un alkyle, cycloalkyle, hétérocycloalkyle, aryle ou hétéroaryle, de préférence alkyle, aryle ou hétéroaryle, particulièrement de préférence alkyle, phényle, naphtyle, indényle, benzofuryle, benzothiényle, benzopyrrolyle, dibenzofuryle, dibenzothiényle, carbazolyle, azacarbazolyle, phénanthrolinyle ou fluorényle, tout particulièrement de préférence un méthyle, phényle ou dibenzofuryle, dibenzothiényle, carbazolyle ou azacarbazolyle, les groupes nommés ci-devant pouvant être non substitués ou substitués par un ou plusieurs substituants choisis parmi les radicaux alkyle, cycloalkyle, hétérocycloalkyle, aryle, hétéroaryle et des groupes à effet donneur ou accepteur ;
R², R³, R⁴ signifient indépendamment les uns des autres alkyle, cycloalkyle, hétérocycloalkyle, aryle, hétéroaryle, les résidus R², R³ et R⁴ ou deux des résidus R², R³ et R⁴ pouvant de plus former conjointement un système cyclique condensé à entre 2 et 6 cycles, de préférence 2 à 3 cycles qui peuvent chacun être saturés ou mono-insaturés ou polyinsaturés et non substitués ou substitués par un ou plusieurs substituants choisis parmi les radicaux alkyle, cycloalkyle, hétérocycloalkyle, aryle, hétéroaryle et un groupe à effet donneur ou accepteur.

2. Utilisation de composés représentés par la formule (lb) selon la revendication 1 dans des applications électroniques organiques.

3. Utilisation selon la revendication 2, les composés représentés par la formule (lb) étant mis en oeuvre en tant que matériau matriciel et/ou matériau de blocage de trous/ d'excitons.

4. Utilisation selon l'une quelconque des revendications 2 à 3, **caractérisée en ce que** l'application électronique organique est une diode électroluminescente organique.

5. Diode électroluminescente organique contenant une anode An et une cathode Ka et une première couche E émettrice de lumière agencée entre l'anode An et la cathode Ka ainsi qu'éventuellement en tant qu'autre couche au moins une couche de blocage de trous/excitons, **caractérisée en ce que** la diode électroluminescente organique contient au moins un composé représenté par la formule (lb) selon la revendication 1 et qui est présent dans la couche émettrice de lumière et/ou au moins dans la couche de blocage de trous/excitons, pour autant qu'elle existe.

6. Diode électroluminescente selon la revendication 5, contenant au moins une deuxième couche émettrice de lumière qui est agencée entre l'anode An et la cathode Ka.

7. Diode électroluminescente selon la revendication précédente, la deuxième couche émettrice de lumière contenant un composé représenté par la formule (lb) selon la revendication 1.

8. Diode électroluminescente selon la revendication précédente, qui présente une émission totale qui se compose de l'émission de la première couche E émettrice de lumière et de la deuxième couche émettrice de lumière.

9. Diode électroluminescente selon la revendication précédente, l'émission totale comprenant de la lumière blanche.

10. Couche émettrice de lumière, contenant au moins un matériau émetteur et au moins un composé représenté par la formule (lb), 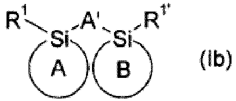 où :
A' signifie un système cyclique condensé constitué d'au moins 3, de préférence 3 ou 4, particulièrement de préférence 3, cycles condensés qui présentent indépendamment les uns des autres de 4 à 10, de préférence de 5 à 7, particulièrement de préférence 5 ou 6 chaînons et qui peuvent être saturés ou mono-insaturés ou polyinsaturés ainsi que non substitués ou substitués par un ou plusieurs substituants choisis parmi les radicaux alkyle, cycloalkyle, hétérocycloalkyle, aryle, hétéroaryle et des groupes à effet donneur ou accepteur, de préférence alkyle, hétéroaryle et des groupes à effet donneur ou accepteur, le système cyclique condensé présentant dans le système cyclique condensé lui-même ou dans au moins un substituant, de préférence dans le système cyclique condensé lui-même, au moins un groupe comprenant un hétéroatome, de préférence choisi parmi O, S, N, P, SO, SO₂ et Si, particulièrement de préférence O, S et N, tout particulièrement de préférence O et S ; 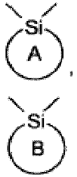 signifient indépendamment l'un de l'autre un cycle comprenant respectivement un Si, ledit cycle présentant de 4 à 10, de préférence de 5 à 7, particulièrement de préférence 5 ou 6, tout particulièrement de préférence 5 chaînons, ledit cycle pouvant être saturé ou mono-insaturé ou polyinsaturé et pouvant présenter, outre l'atome Si, un ou plusieurs autres groupes comprenant un hétéroatome, de préférence choisis parmi O, S, SO, SO₂ et N, particulièrement de préférence O et N, et non substitué ou substitué par un ou plusieurs substituants choisis parmi les radicaux alkyle, cycloalkyle, hétérocycloalkyle, aryle, hétéroaryle et des groupes à effet donneur ou accepteur, le cycle contenant Si pouvant de plus faire partie d'un système cyclique condensé constitué d'au moins 2, de préférence 2 ou 3, particulièrement de préférence 3 cycles condensés, les autres cycles - outre le cycle contenant Si - pouvant être dans le système cyclique condensé, indépendamment les uns des autres, saturés ou mono-insaturés ou polyinsaturés et non substitués ou substitués par un ou plusieurs substituants choisis parmi les radicaux alkyle, cycloalkyle, hétérocycloalkyle, aryle, hétéroaryle et des groupes à effet donneur ou accepteur, et pouvant présenter un ou plusieurs groupes contenant un hétéroatome, de préférence choisis parmi O, S, SO, SO₂ et N, particulièrement de préférence S et N ;
R¹, R^{1'} signifient, indépendamment l'un de l'autre
- un système cyclique condensé constitué d'au moins 3 cycles condensés qui présentent indépendamment les uns des autres de 4 à 10 chaînons et qui peuvent être saturés ou mono-insaturés ou polyinsaturés ainsi que substitués ou substitués par un ou plusieurs substituants choisis parmi les radicaux alkyle, cycloalkyle, hétérocycloalkyle, aryle, hétéroaryle, SiR²R³R⁴ et des groupes à effet donneur ou accepteur, le système cyclique condensé présentant au moins un hétéroatome dans le système cyclique condensé lui-même ou dans au moins un substituant,
- un alkyle, cycloalkyle, hétérocycloalkyle, aryle ou hétéroaryle, de préférence alkyle, aryle ou hétéroaryle, particulièrement de préférence alkyle, phényle, naphtyle, indényle, benzofuryle, benzothiényle, benzopyrrolyle, dibenzofuryle, dibenzothiényle, carbazolyle, azacarbazolyle, phénanthrolinyle ou fluorényle, tout particulièrement de préférence un méthyle, phényle ou dibenzofuryle, dibenzothiényle, carbazolyle ou azacarbazolyle, les groupes nommés ci-devant pouvant être non substitués ou substitués par un ou plusieurs substituants choisis parmi les radicaux alkyle, cycloalkyle, hétérocycloalkyle, aryle, hétéroaryle et des groupes à effet donneur et accepteur.

11. Dispositif choisi parmi le groupe constitué d'écrans stationnaires tels qu'écrans d'ordinateurs, de téléviseurs, écrans d'imprimantes, d'appareils de cuisine ainsi que panneaux publicitaires, éclairages, panneaux et écrans mobiles tels qu'écrans de téléphones portables, d'ordinateurs portables, d'appareils photo numériques, de véhicules ainsi qu'affichages de destination dans les bus ou trains, contenant au moins une diode électroluminescente organique selon l'une quelconque des revendications 5 à 9.
